# EUROPEAN PATENT APPLICATION

(11) **EP 4 826 587 A1**
(43) Date of publication of application: **21.10.2026**
(21) Application number: 25305544.6
(22) Date of filing: 15.04.2025
(51) Int. Cl.: G06F 30/10, G06F 30/17, G06F 30/27, G06N 20/00

(54) **MACHINE-LEARNING A CLASSIFICATION FUNCTION CONFIGURED FOR DETECTION OF MECHANICAL INTERFACES OF A CAD MODEL REPRESENTING A MECHANICAL ASSEMBLY OF PARTS**

(71) Applicant: Dassault Systèmes, 78140 Vélizy-Villacoublay (FR)
(72) Inventor: PAGLIUGHI, Pierre, 78140 Vélizy-Villacoublay (FR); HEBRARD, Pascal, 78140 Vélizy-Villacoublay (FR); FEDRITZI, Benjamin, 78140 Vélizy-Villacoublay (FR); ZHANG, Zhenchen, 78140 Vélizy-Villacoublay (FR); BAYON DE NOYER, Camille, 78140 Vélizy-Villacoublay (FR)
(74) Representative: Bandpay & Greuter

(57) **Abstract**

The disclosure notably relates to a computer-implemented method for machine-learning a classification function configured for detection of mechanical interfaces of a CAD model representing a mechanical assembly of parts. The method comprises obtaining a training dataset comprising graphs representing a local contact between parts of a CAD model. The graph comprises one or more nodes representing canonical surfaces of the CAD model. Each node comprises a label within the label list: primary face, secondary face, tertiary face, maintain face, and no interface. The graph further comprises one or more internal edges and one or more external edges. The method further comprises training the classification function based on the training dataset to classify, with a label of the label list, each node of a graph representing a local contact between parts of a CAD model representing a mechanical assembly of parts. This provides an improved solution for detecting mechanical interfaces.

## Description

### TECHNICAL FIELD

The disclosure relates to the field of computer programs and systems, and more specifically to methods, systems, programs, and machine-learnt functions for detection of mechanical interfaces of a CAD model representing a mechanical assembly of parts.

### BACKGROUND

A number of systems and programs are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systèmes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service.

CAD models representing assemblies of mechanical parts often comprise mechanical interfaces. A mechanical interface of a mechanical assembly of parts indicates zones of interaction, such as zones of contact, between different mechanical parts comprised in the mechanical assembly of parts. Correctly identifying the mechanical interfaces ensures that the mechanical parts comprised in the mechanical assembly of parts are correctly produced, with the appropriate tolerances. However, in the prior art, determining mechanical interfaces was a slow and manual process involving extensive amount of time from the user and prone to error.

Within this context, there is still a need for an improved method to determine the mechanical interfaces of a mechanical assembly of parts.

### SUMMARY

It is therefore provided a computer-implemented method for machine-learning a classification function configured for detection of mechanical interfaces of a CAD model. The CAD model represents a mechanical assembly of parts. The learning method comprises obtaining a training dataset comprising training samples. Each training sample comprises a graph representing a local contact between parts of a CAD model representing a mechanical assembly of parts. The graph comprises one or more nodes. Each node represents a canonical surface of the CAD model. Each node comprises a label. The label is one within the label list: primary face of a mechanical interface; secondary face of a mechanical interface; tertiary face of a mechanical interface; maintain face of a mechanical interface; and no interface. The graph further comprises one or more internal edges. Each internal edge represents an internal connection between the canonical surfaces represented by the nodes connected by the edge. The canonical surfaces represent portions of a same part of the mechanical assembly. The graph further comprises one or more external edges. Each external edge represents a contact between the canonical surfaces represent by the nodes connected by the edge. The canonical surfaces represent portions of different parts of the mechanical assembly. The learning method further comprises training the classification function based on the training dataset to classify, with a label of the label list, each node of a graph representing a local contact between parts of a CAD model representing a mechanical assembly of parts. The method may be referred to as "the learning method" in the present disclosure.

The learning method may comprise one or more of the following:
- each of the graphs comprised in the training dataset comprises:
   - a node-vector for each node, the node-vector being a feature vector representing properties of a canonical surface represented by the node;
   - an internal-edge-vector for each internal edge, the internal-edge-vector being a feature vector representing properties of an internal connection represented by the edge; and/or
   - an external-edge-vector for each external edge, the external-edge-vector being a feature vector representing properties of a contact represented by the edge;
- the properties of the canonical surface represented by each node-vector comprise: surface type, area, radius, orientation, material, or a combination thereof;
- the properties of the internal connection represented by each internal-edge-vector comprise: convexity, concavity, coplanarity, coaxiality, neighbor smooth, presence of a fillet, presence of a chamfer, presence of a connection other than a fillet or a chamfer, or a combination thereof;
- the properties of the contact represented by each external-edge-vector comprise: contact, stackablity, coaxiality, coplanarity, or a combination thereof;
- obtaining the training dataset comprises:
   - obtaining an initial dataset comprising CAD models representing mechanical assembly of parts; and
   - for each CAD model representing a mechanical assembly of parts in the initial dataset, determining one or more graphs each representing a respective local contact between parts of the assembly of parts;
- the obtaining of the training dataset further comprises, before the determining, for each CAD model, of the one or more graphs each representing a respective local contact between parts of the assembly of parts, determining, for each CAD model of the initial dataset, a graph representing the CAD model, including:
   - determining the canonical surfaces of the CAD model, and generating a node for each canonical surface;
   - determining the internal connections between couples of canonical surfaces representing portions of a same part of the assembly represented by the CAD model, and generating an internal edge for each couple of canonical surfaces having an internal connection; and
   - determining the contacts between couples of canonical surfaces representing portions of different parts of the assembly represented by the CAD model, and generating an external edge for each couple of canonical surfaces that are in contact,
   wherein, for each CAD model of the initial dataset, the determining of one or more graphs each representing a respective local contact between parts of the assembly of parts is based on the determined graph representing the CAD model;
- the determining, for each CAD model, of one or more graphs each representing a respective local contact between parts of the assembly of parts represented by the CAD model based on the determined graph representing the CAD model comprises:
   - determining a sub-graph of the determined graph representing the CAD model, the sub-graph comprising:
      ▪ a set of nodes, comprising all the nodes of the determined graph that are in a boundary of any of the external edges of the determined graph; and
      ▪ a set of internal and external edges, comprising all the internal and/or external edges of the determined graph that are bounded by two nodes comprised in the set of nodes;
   - determining one or more connected components of the sub-graph; and
   - determining, for each connected component of the sub-graph, a graph representing a local contact between parts of the assembly of parts, the graph comprising:
      ▪ one or more nodes, the one or more nodes comprising all the nodes of the connected component of the sub-graph and all the nodes that are at distance 1 of the connected component of the sub-graph;
      ▪ all the internal edges of the graph that are adjacent to any node of the connected component of the sub-graph; and
      ▪ all the external edges of the connected component of the sub-graph;
- each canonical surface is a portion of a plane, of a sphere, of cone, of a torus, or of a cylinder;
- the classification function comprises a graph neural network; and/or
- the classification function being further configured to form mechanical interfaces based on the outputted labels by regrouping neighboring canonical surfaces corresponding to primary, secondary, tertiary, and maintain faces, the canonical surfaces representing portions of a same mechanical part.

It is further provided a classification function obtainable according to the learning method, that is, a computer-implemented classification function having the weights of a classification function learnt by the learning method. The provided classification function may for example have been learnt directly by the learning method, with its weights having been fixed by the learning step of the learning method.

It is further provided a method of use of the machine-learnt classification function. The method of use comprises obtaining one or more graphs each representing a respective local contact between parts of a same CAD model representing the mechanical assembly of parts. Each graph comprises one or more nodes. Each node represents a canonical surface of the CAD model. Each graph further comprises one or more internal edges. Each internal edge represents an internal connection between the canonical surfaces represented by the nodes connected by the edge. The canonical surfaces represent portions of a same part of the mechanical assembly. Each graph further comprises one or more external edges. Each external edge represents a contact between the canonical surfaces represent by the nodes connected by the edge. The canonical surfaces represent portions of different parts of the mechanical assembly. The method of use further comprises applying the machine-learnt classification function to the one or more graphs. The method may be referred to as "the method of use" in the present disclosure.

In the method of use, the obtaining of the one or more graphs may comprise:
- obtaining the CAD model;
- determining a graph representing the CAD model, including:
   - determining the canonical surfaces of the CAD model, and generating a node for each canonical surface;
   - determining the internal connections between couples of canonical surfaces representing portions of a same part of the assembly represented by the CAD model, and generating an internal edge for each couple of canonical surfaces having an internal connection; and
   - determining the contacts between couples of canonical surfaces representing portions of different parts of the assembly represented by the CAD model, and generating an external edge for each couple of canonical surfaces that are in contact,
- determining one or more graphs each representing a respective local contact between parts of the assembly of parts represented by the CAD model including:
   - determining a sub-graph of the graph representing the CAD model, the sub-graph comprising:
      ∘ a set of nodes, comprising all the nodes of the graph representing the CAD model that are in a boundary of any of the external edges of the graph representing the CAD model; and
      ∘ a set of internal and external edges, comprising all the internal and/or external edges of the graph representing the CAD model that are bounded by two nodes comprised in the set of nodes;
   - determining one or more connected components of the sub-graph; and
   - determining, for each connected component of the sub-graph, a graph representing a local contact between parts of the assembly of parts, the graph comprising:
      ∘ one or more nodes, the one or more nodes comprising all the nodes of the connected component of the sub-graph and all the nodes that are at distance 1 of the connected component of the sub-graph;
      ∘ all the internal edge of the graph that are adjacent to any node of the connected component of the sub-graph; and
      ∘ all the external edges of the connected component of the sub-graph;
      and wherein the method further comprises gathering the results of the application of the function to the one or more graphs by labeling the nodes of the graph representing the CAD model with the labels outputted by the function for each of the one or more graphs.

It is further provided a computer program comprising instructions for performing the learning method and/or the method of use.

It is further provided a device comprising a data storage medium having recorded thereon the computer program and/or the classification function.

The device may form or serve as a non-transitory computer-readable medium, for example on a SaaS (Software as a service) or other server, or a cloud based platform, or the like. The device may alternatively comprise a processor coupled to the data storage medium. The device may thus form a computer system in whole or in part (e.g. the device is a subsystem of the overall system). The system may further comprise a graphical user interface coupled to the processor.

### BRIEF DESCRIPTION OF THE DRAWINGS

Non-limiting examples will now be described in reference to the accompanying drawings, where:
- FIGs. 1 to 59 illustrate the method; and
- FIG. 60 shows an example of the system.

### DETAILED DESCRIPTION

It is proposed a computer-implemented method for machine-learning a classification function configured for detection of mechanical interfaces of a CAD model. The CAD model represents a mechanical assembly of parts (or, equivalently, an assembly of mechanical parts). The learning method comprises obtaining a training dataset comprising training samples. Each training sample comprises a graph representing a local contact between parts of a CAD model representing a mechanical assembly of parts. The graph comprises one or more nodes. Each node represents a canonical surface of the CAD model. Each node comprises a label. The label is one within the label list: primary face of a mechanical interface; secondary face of a mechanical interface; tertiary face of a mechanical interface; maintain face of a mechanical interface; and no interface. The graph further comprises one or more internal edges. Each internal edge represents an internal connection between the canonical surfaces represented by the nodes connected by the edge. The canonical surfaces represent portions of a same part of the mechanical assembly. The graph further comprises one or more external edges. Each external edge represents a contact between the canonical surfaces represent by the nodes connected by the edge. The canonical surfaces represent portions of different parts of the mechanical assembly. The learning method further comprises training the classification function based on the training dataset to classify, with a label of the label list, each node of a graph representing a local contact between parts of a CAD model representing a mechanical assembly of parts.

In the present disclosure, a mechanical assembly of parts is a collection of two or more mechanical parts that are interconnected to form an integrated system. That is, each mechanical part is operatively connected to at least one other part such that the assembly functions as a unified structure, wherein the connections may be either fixed (e.g., by mechanical fasteners such as bolts or screws) or movable. A CAD model representing a mechanical assembly of parts is a digital representation of the assembly, comprising a digital representation (e.g., parts of the CAD model) of each of the mechanical parts composing the assembly. Notably, the digital representation comprises a depiction of connections and contacts, so that one may speak, e.g., of a contact of two parts of the CAD model, corresponding to parts of the assembly that are in contact to each other.

As it will be explained in detail below, a mechanical interface of a CAD model representing a mechanical assembly of parts is a collection of canonical surfaces (e.g., portions of predetermined, or canonical, surfaces) associated to a single part of the assembly represented by the (e.g., of an outer surface) CAD model. The mechanical interface specifies a zone of interaction of the part with other parts (e.g., between parts) composing the mechanical assembly of parts represented by the CAD model. Mechanical interfaces may specify areas to be produced with detailed tolerances.

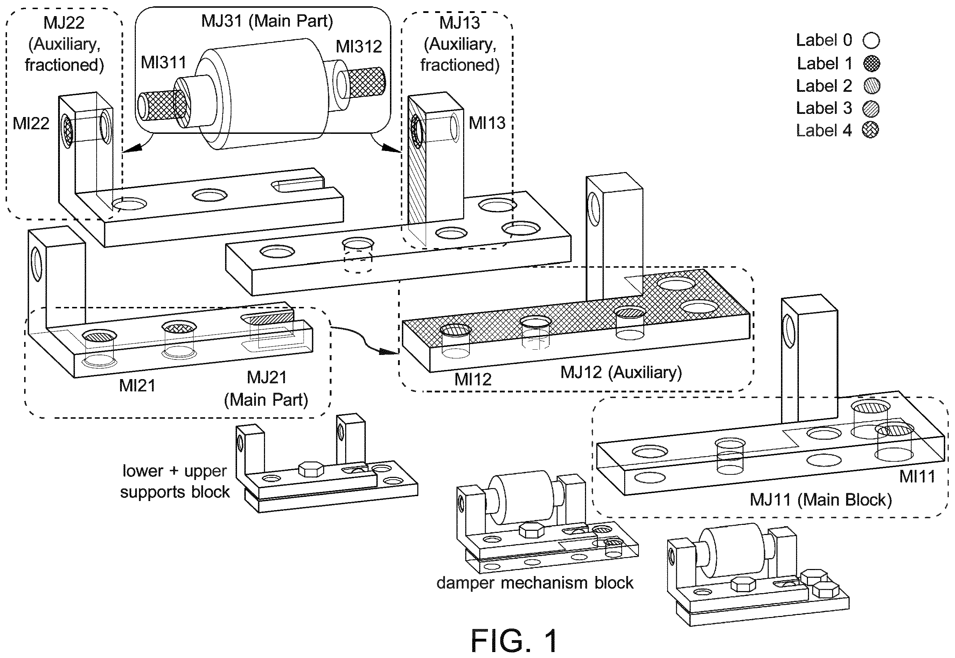

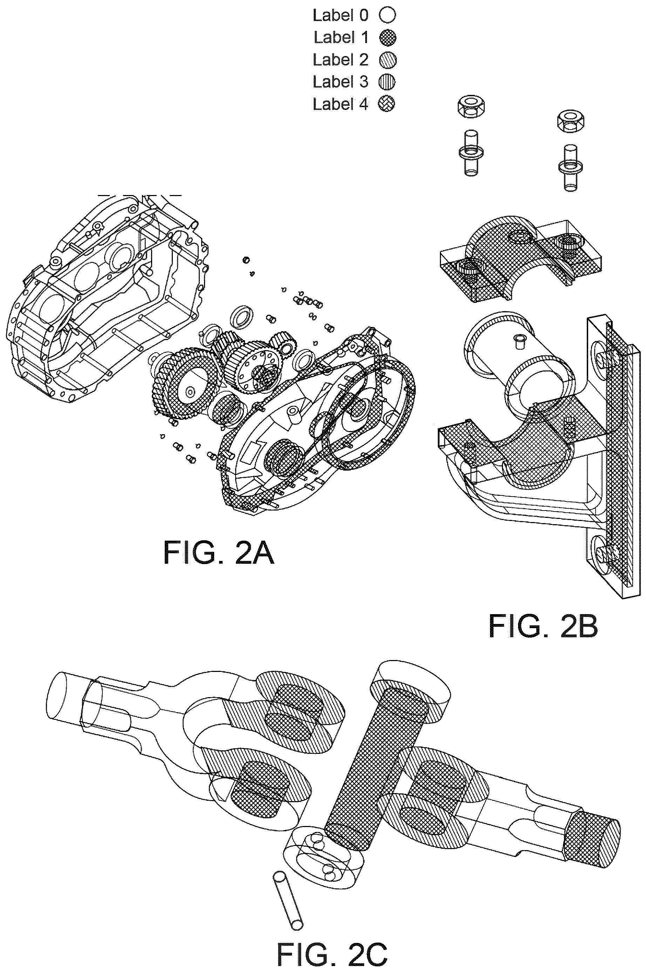

FIGs. 1, 2A, 2B, and 2C show examples of mechanical assemblies of parts comprising mechanical interfaces, each mechanical assembly of parts comprising several mechanical parts. Each of the canonical surfaces comprised in said mechanical interfaces is illustrated with a respective hatching corresponding to the classification (of the label list) in primary face of a mechanical interface, secondary face of a mechanical interface, tertiary face of a mechanical interface, maintain face of a mechanical interface, and no interface. Specifically, the hatching associated with the label "0" corresponds to canonical surfaces that are no interface. The hatching associated with the label "1" corresponds to canonical surfaces that are primary faces. The hatching associated with the label "2" corresponds to canonical surfaces that are secondary faces. The hatching associated with the label "3" corresponds to canonical surfaces that are tertiary faces. The hatching associated with the label "4" corresponds to canonical surfaces that are maintain faces.

In this disclosure, CAD models representing mechanical products (e.g., a single mechanical part or a mechanical assembly of parts) may be two- or three-dimensional, representing either the outer surface of the mechanical product (in the two-dimensional case) or the mechanical product itself (in the three-dimensional case). By the mention of "a portion of the CAD model" herein it is meant "a surface portion of the CAD model" (in the two-dimensional case) or "a portion of an outer surface of the CAD model" (in the three-dimensional case). Therefore, a portion of a CAD model as used herein consists always in a two-dimensional surface comprised in the CAD model. A portion of the CAD model may be connected (as a surface, in the standard mathematical sense) or not. Notably, any mechanical interface herein may consist of disjoint surfaces sharing an internal connection (or, equivalently, an internal connection type) with each other, the internal connection being one in a list, comprising, but not limited to, being adjacent, as it will be explained in detail below. Each CAD model (or the respective outer surface) can be partitioned into portions, each portion being a surface with boundary. For example, a CAD model may consist of a B-rep, the B-rep comprising vertices, edges, and faces. A portion of the CAD model may be, e.g., a portion of a face, a face, or a collection of faces of the B-rep (e.g., adjacent faces). Analogously, by the mention "zone" it is always meant a two-dimensional portion, corresponding to an outer surface of the mechanical part represented by the CAD model.

For any CAD model in the present disclosure, a canonical surface of the CAD model is a portion of the CAD model that corresponds to (e.g., with an affine isomorphism) a portion of one of the canonical surfaces. The canonical surfaces are the surfaces that may support a zone of contact between mechanical parts. The canonical surfaces may be, e.g., planes, spheres, cones, tori, or cylinders. Each CAD model (or outer surface of the CAD model) may be decomposed in one or more canonical surfaces and freeform surfaces, i.e., portions of the CAD model that are not one of the canonical surfaces. For example, a portion of the CAD model may be a chamfer or a fillet, such portions are not part of any canonical surface.

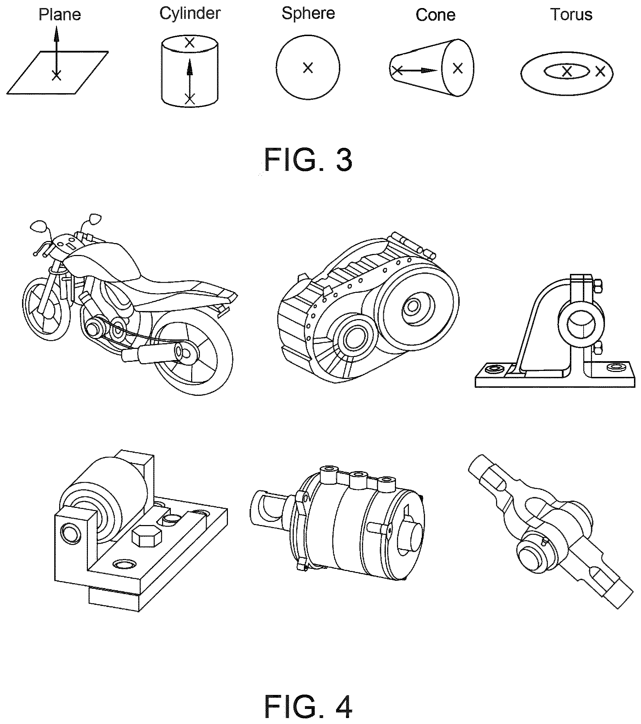

FIG. 3 illustrates the canonical surfaces.

Herein, a zone of interaction of a mechanical part within a mechanical assembly of parts may be a region of the mechanical part that has a functional role in the mechanical assembly of parts. The functional role may be, e.g., to reduce the degree of freedom of the mechanical assembly of parts or maintaining the mechanical assembly of parts together. A zone of interaction may be a portion of the mechanical part where the mechanical part, e.g., comes into contact, is stacked, or exerts mutual influence with the other mechanical parts of the assembly. The zone of interaction may be used to facilitate movement, transmit forces, or perform functional operations within the mechanical assembly of parts.

Notably, a mechanical interface of a CAD model representing a mechanical assembly of parts is a collection of canonical surfaces of a single part of the mechanical assembly that correspond to a zone of interaction of the part with other parts composing the mechanical assembly of parts. Specifically, the canonical surfaces comprising the mechanical interface may each have a (e.g., different) functional role, such as reducing the degree of freedom of the mechanical assembly of parts or maintaining the mechanical assembly of parts together.

For example, the mechanical assembly of parts may comprise a bolt and nut. In the mechanical assembly of parts, the nut may be tightened to the bolt. Therefore, the threads of the bolt may be in contact with the thread bore of the nut, and the contact reduces the degree of freedom of the mechanical assembly of parts, as the nut is thereby connected to the bolt. The surface of the CAD model representing the threads of the bolt is, therefore, comprised in a mechanical interface.

In the present disclosure, any mechanical interface of a CAD model representing a mechanical assembly of parts may consist of a collection of canonical surfaces of a same part of the assembly and that have internal connections with each other. Specifically, an internal connection between two canonical surfaces of the CAD model may correspond to the adjacency, the coplanarity, and/or the coaxiality of the two canonical surfaces within a same mechanical part. Additionally or alternatively, an internal connection between two canonical surfaces of the CAD model may correspond to a separation between the two canonical surfaces consisting of a fillet, a chamfer, and/or another non-canonical surface within a same mechanical part. In specifics, the mechanical interface may consist of a collection of canonical surfaces that is connected with respect to the above defined internal connection. That is, given any pair of canonical surfaces comprised in the mechanical interface, there may be a way of passing from any canonical surface to any other, each time by passing from canonical surface to canonical surface having an internal connection between them, within the mechanical interface.

It is understood that the mechanical interfaces of a CAD model representing a mechanical assembly of parts are in correspondence with the associated mechanical interfaces of the mechanical assembly of parts. One may speak therefore of a mechanical interface of either a CAD model or the associated mechanical assembly of parts and the two notions are in correspondence.

Each of the canonical surfaces comprised in a mechanical interface of a CAD model representing a mechanical assembly of parts is classified in function of its role, as one of the list: primary face, secondary face, tertiary face, or maintain face of the mechanical interface. The classification may correspond to an associated function role of each of the canonical surfaces.

A primary/secondary/tertiary/maintain face may also be referred to as a primary/secondary/tertiary/maintain face of a mechanical interface. A canonical surface of a CAD model is a no interface face if it is not a primary, secondary, tertiary, or maintain face (that is, if a canonical surface is not an interface face).

Each mechanical interface in the present disclosure comprises one or more primary faces. A primary face is a canonical surface comprised in the mechanical interface that constrains the most the mechanical assembly of parts (e.g., constrains the most a respective mechanical part within the mechanical assembly of parts). Constrain the most may be with respect to the degrees of freedom of the mechanical assembly of parts, that is, a primary face may be a canonical surface of the mechanical interface that reduces the most degrees of freedom in the mechanical assembly of parts. The most herein may mean that the number of degrees of freedom reduced by the canonical surface may be higher than a coefficient multiplied by the maximal number of degrees of freedom reduced by any of the canonical surfaces comprised in the mechanical interface. The coefficient may be 1, so that the only primary faces are the canonical surfaces of the mechanical interface that reduce the maximum number of degrees of freedom. Alternatively, the coefficient may be any number lower than 1, such as 0.9 or 0.8.

Each mechanical interface in the present disclosure may comprise one or more secondary faces. A secondary face is a canonical surface comprised in the mechanical interface that is not a primary face and that constrains the most the position the mechanical assembly of parts (e.g., constrains the most a respective mechanical part within the mechanical assembly of parts), aside from the primary faces (i.e., excluding or not considering the primary faces). Constrain the most may be with respect to the degrees of freedom of the mechanical assembly of parts, that is, a secondary face may be a canonical surface of the mechanical interface that is not a primary face and that reduces the most degrees of freedom in the mechanical assembly of parts, aside from the primary faces. The most herein may mean that the number of degrees of freedom reduced by the canonical surface may be higher than a coefficient multiplied by the maximal number of degrees of freedom reduced by any non-primary face of the mechanical interface. The coefficient may be 1, so that the only secondary faces are the canonical surfaces of the mechanical interface that reduce the maximum number of degrees of freedom, aside from the primary faces. Alternatively the coefficient may be any number lower than 1, such as 0.8 or 0.9.

Each mechanical interface in the present disclosure may comprise one or more tertiary faces. A tertiary face is a canonical surface of the mechanical interface that is neither a primary face nor a secondary face and that constrains the position the mechanical assembly of parts (e.g., constrains a respective mechanical part within the mechanical assembly of parts). Constrain may be with respect to the degrees of freedom of the mechanical assembly of parts, that is, a tertiary face may be a canonical surface of the mechanical interface that is neither a primary face nor a secondary face and that reduces at least a degree of freedom in the mechanical assembly of parts.

Each mechanical interface in the present disclosure may comprise one or more maintain faces. A maintain face is a canonical surface of the mechanical interface that maintains the mechanical parts in the position set by the primary, secondary and tertiary surfaces within the mechanical assembly of parts.

Therefore, in the present disclosure, each mechanical interface of a CAD model representing a mechanical assembly of parts may reduce a number *N* ≥ 1 of degrees of freedom of the mechanical assembly of parts. The number N may be written as a sum *N = N_{P} + N_{S} + N_{T}* corresponding to the primary, secondary, and tertiary faces.

The primary faces of the mechanical interface reduce (altogether) the number *N_{P}* ≥ 1 of degrees of freedom of the mechanical assembly of parts. The number *N_{P}* is the sum of one or more numbers *N*_{*P,*1}*,N*_{*P,*2}*,... ,N_{P,k_{P}}* each corresponding to the number of degrees of freedom reduced by respective primary faces, that is Σ*ᵢ N_{P,i} = N_{P}.* Each of the degrees of freedom reduced by each of the primary faces *N_{P,i}* may be bounded from below (e.g., they may all be the same and equal to the maximal number of degrees of freedom reduced by any face, or comprised in an interval as explained above).

Similarly, the secondary faces (if present) of the mechanical interface reduce (altogether) the number *N_{S}* ≥ 0 of degrees of freedom of the mechanical assembly of parts. The number *N_{S}* (if it is not 0) is the sum of one or more numbers *N*_{*S,*1}, *N*_{*S*,2}, *..., N_{S,k_{S}}* each corresponding to the number of degrees of freedom reduced by respective secondary faces, so that Σ*ᵢ N_{S,i}* = *N_{S}.* If the secondary faces are present (i.e., if *k_{S}* > 0), each of the degrees of freedom reduced by each of the secondary faces *N_{S,i}* may be bounded from below as explained above.

Similarly, the tertiary faces (if present) of the mechanical interface reduce (altogether) the number *N_{T}* ≥ 0 of degrees of freedom of the mechanical assembly of parts. The number *N_{T}* (if it is not 0) is the sum of one or more numbers *N*_{*T,*1}*. N*_{*T,*2}*, ..., N_{T,k_{T}}* each corresponding to the number of degrees of freedom reduced by respective tertiary faces, so that Σ*ᵢ N_{T,i} = N_{T}.* If the tertiary faces are present (i.e., if *k_{T} >* 0), each of the degrees of freedom reduced by each of the tertiary faces *N_{T,i}* is (strictly) positive as explained above.

As already discussed above, a mechanical interface of a CAD model representing a mechanical assembly of parts consists of one or more canonical surfaces representing portions of a same part of the assembly. Each of the canonical surfaces comprising the mechanical interface is classified as a primary/secondary/tertiary/maintain face. Thus, a mechanical interface of a CAD model is a collection of canonical surfaces, each of which is a primary/secondary/tertiary/maintain face, that have internal connections (e.g., a path of canonical surfaces having mutual internal connections, as explained above) and such that all the other canonical surfaces of the CAD model representing portions of the same part of the assembly with an internal connection to any of the canonical surfaces of the collection of canonical surfaces is a no interface face. As explained above, an internal connection between two canonical surfaces of the CAD model may correspond to the adjacency, the coplanarity, and/or the coaxiality of the two canonical surfaces within a same mechanical part. Additionally or alternatively, an internal connection between two canonical surfaces of the CAD model may correspond to a separation between the two canonical surfaces consisting of a fillet, a chamfer, and/or another non-canonical surface within a same mechanical part.

As it will be explained below, each of the local contacts between parts of a CAD model representing a mechanical assembly of parts may be represented by a graph. Such a graph comprises nodes, each representing a canonical surface of the CAD model that is near the local contact (e.g., a surface having said local contact, or a surface having an internal connection with a surface having said local contact). The graph comprises internal edges and external edges. Each of the internal edges represents an internal connection between canonical surfaces (of a same part of the CAD model) represented by nodes of the graph. Each of the external edges represents a contact between canonical surfaces (of different parts of the CAD model) represented by nodes of the graph. A mechanical interface may be comprised in a connected component of a sub-graph of such a local graph, the sub-graph only comprising the internal edges (i.e., not the external edges). It is also clear that each of the mechanical interfaces of a CAD model representing a mechanical assembly of parts are represented in one of such graphs representing local contacts. Indeed, a mechanical interface must be located in proximity to a local contact (e.g., adjacent to a local contact, such as a canonical surface having said local contact or being adjacent to a canonical surface having said contact). Therefore, the graphs representing respective local contact between parts of a respective CAD model may be a best adapted mathematical structure to determine the mechanical interfaces, as they may represent all the mechanical interfaces and not represent canonical surfaces that are far from local contacts (and, therefore, may not be part of a mechanical interface).

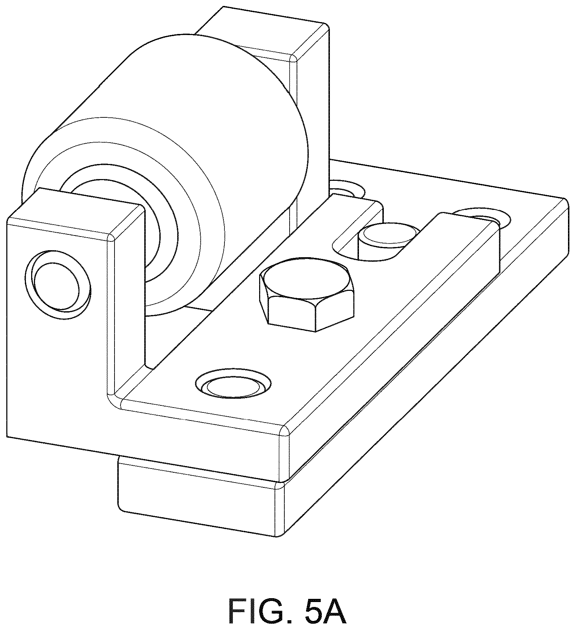

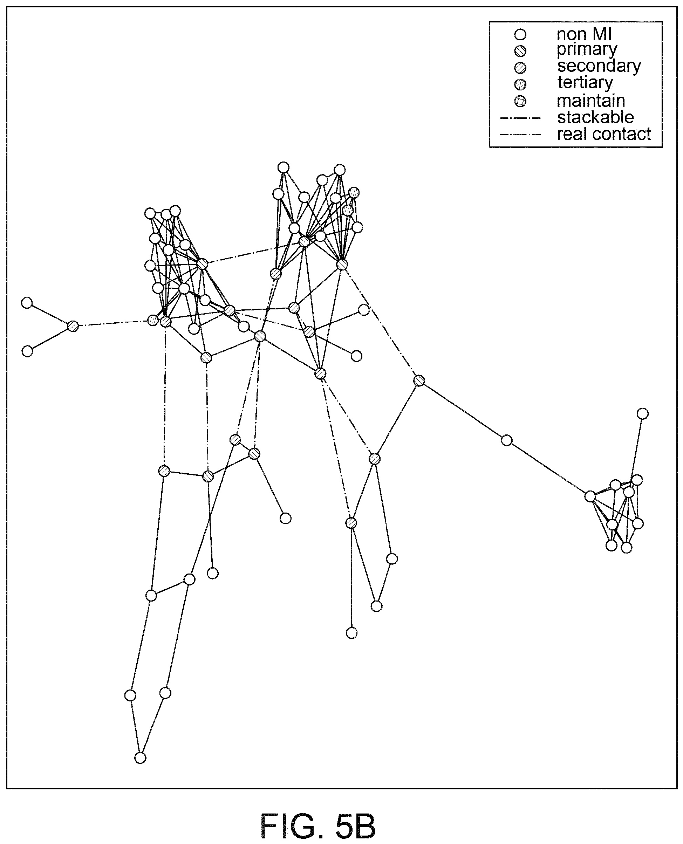

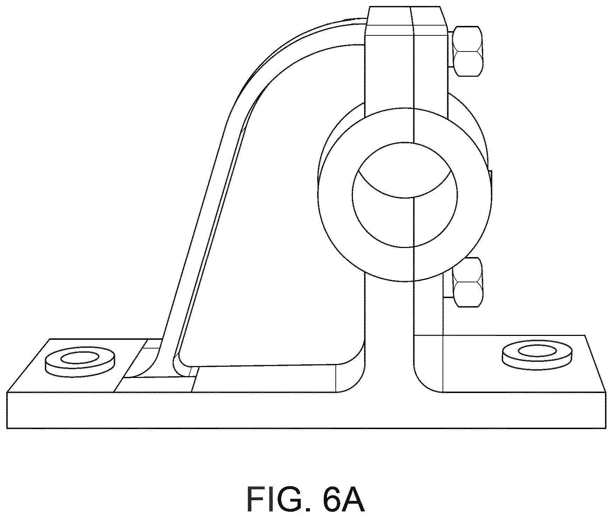

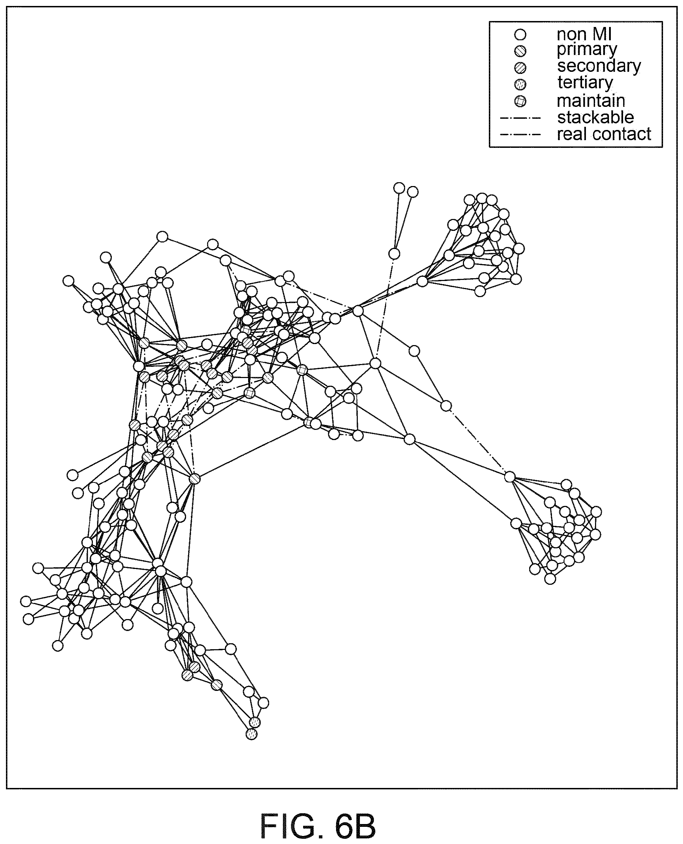

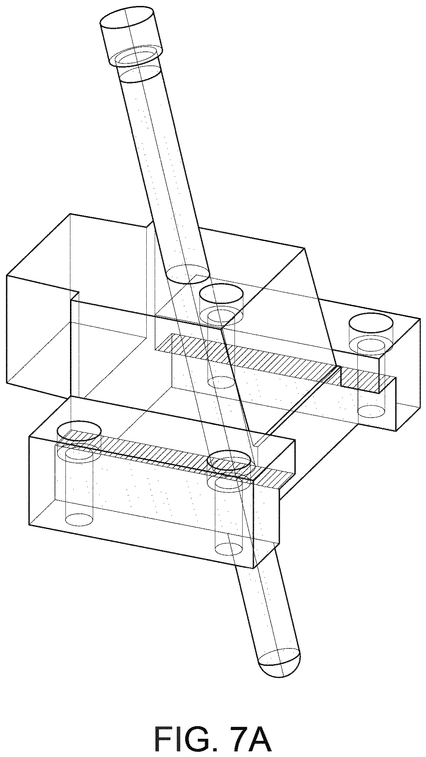

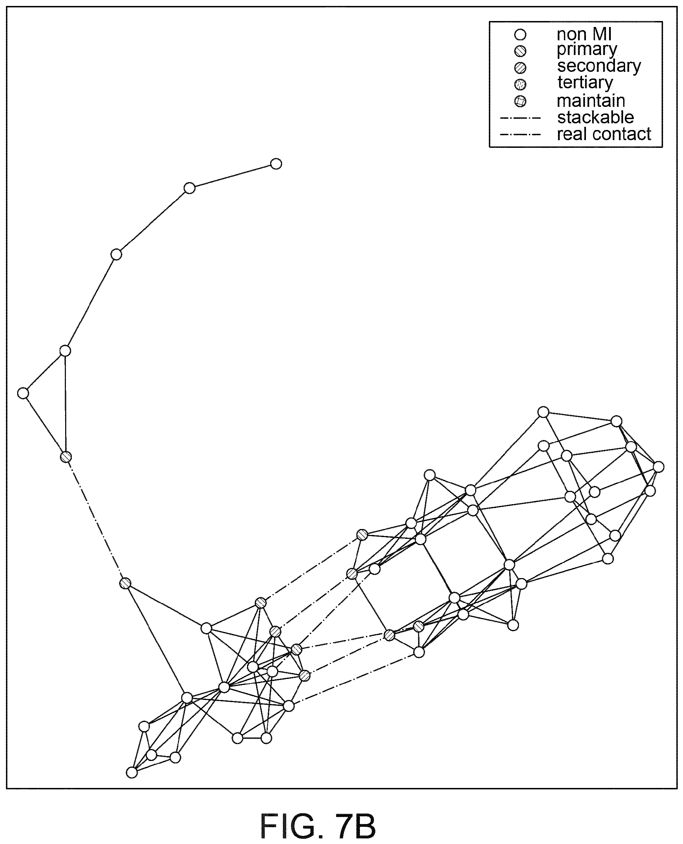

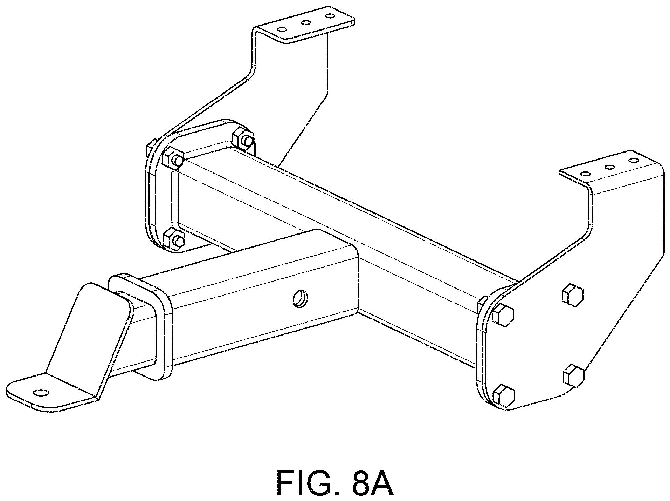

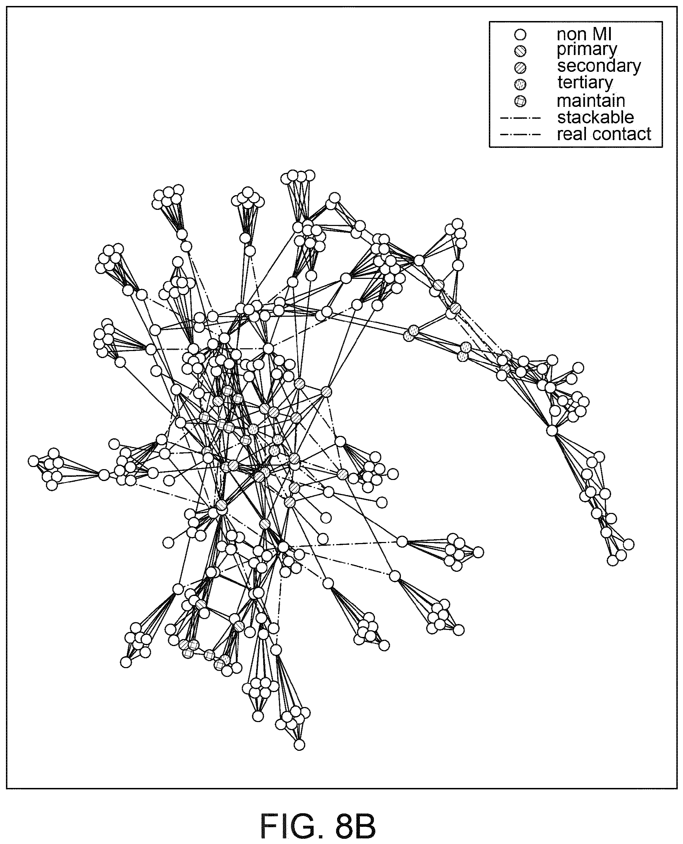

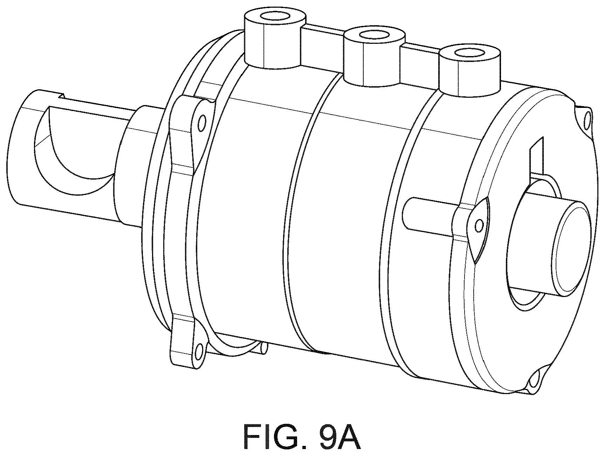

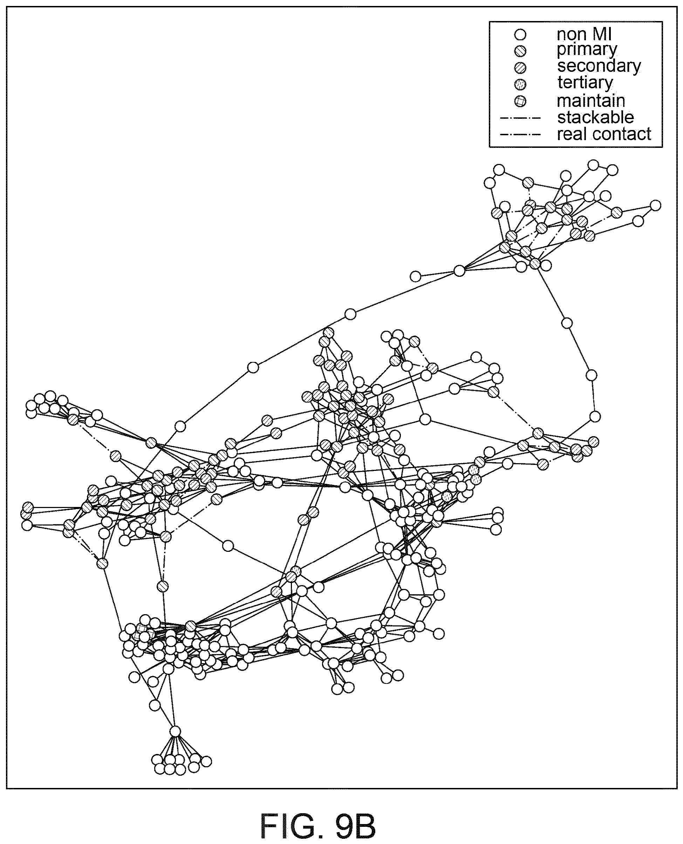

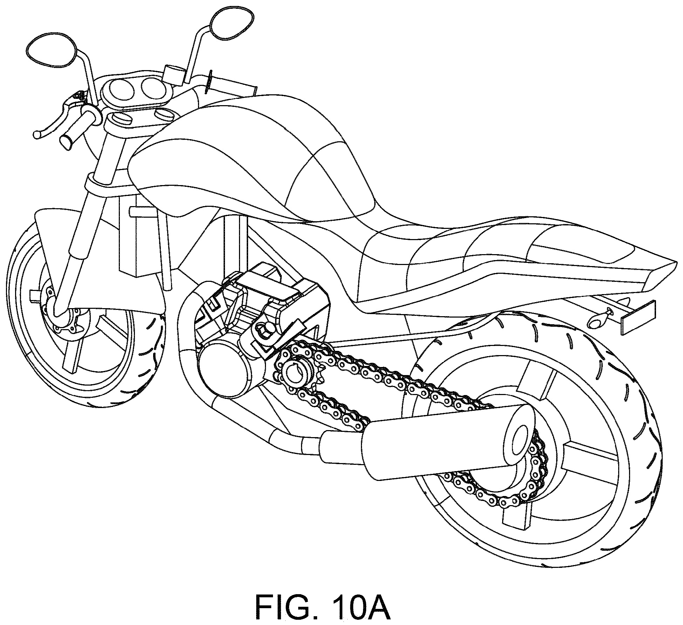

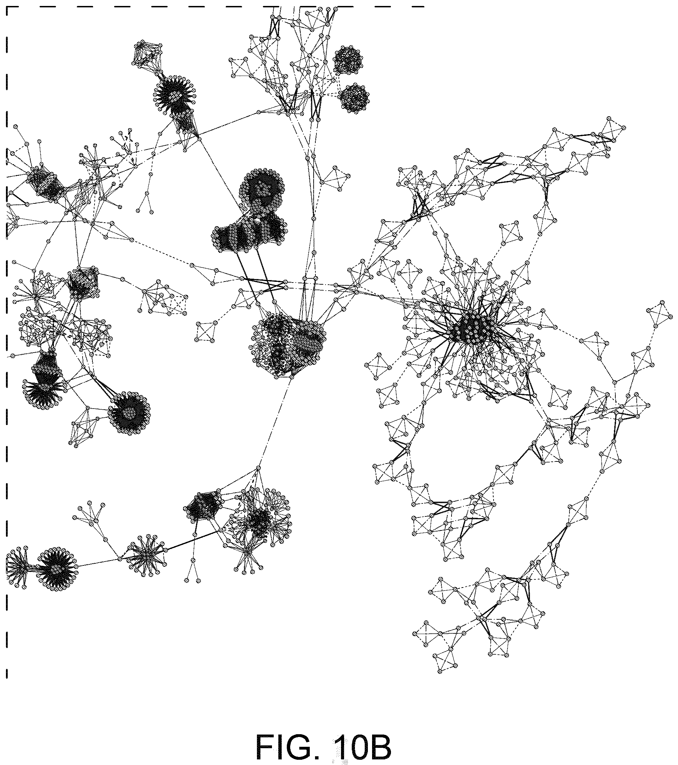

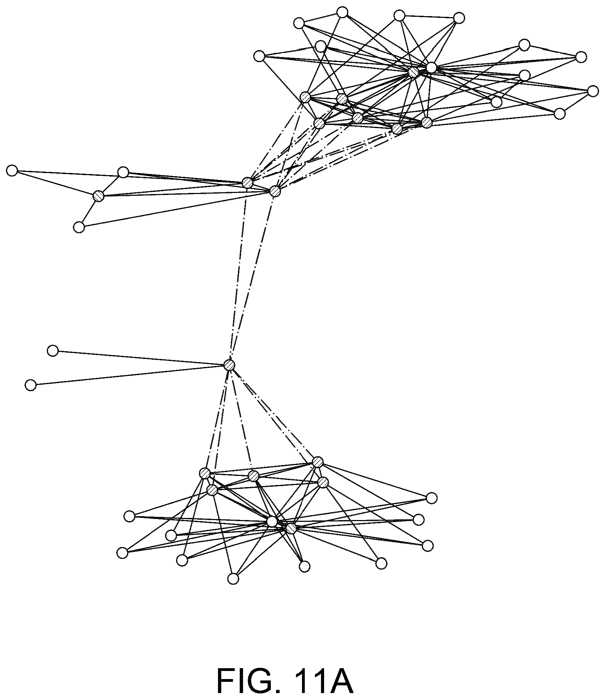

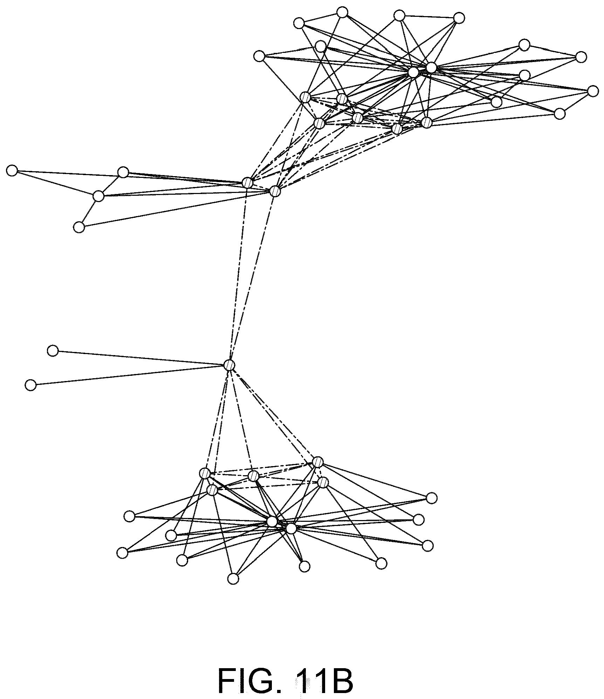

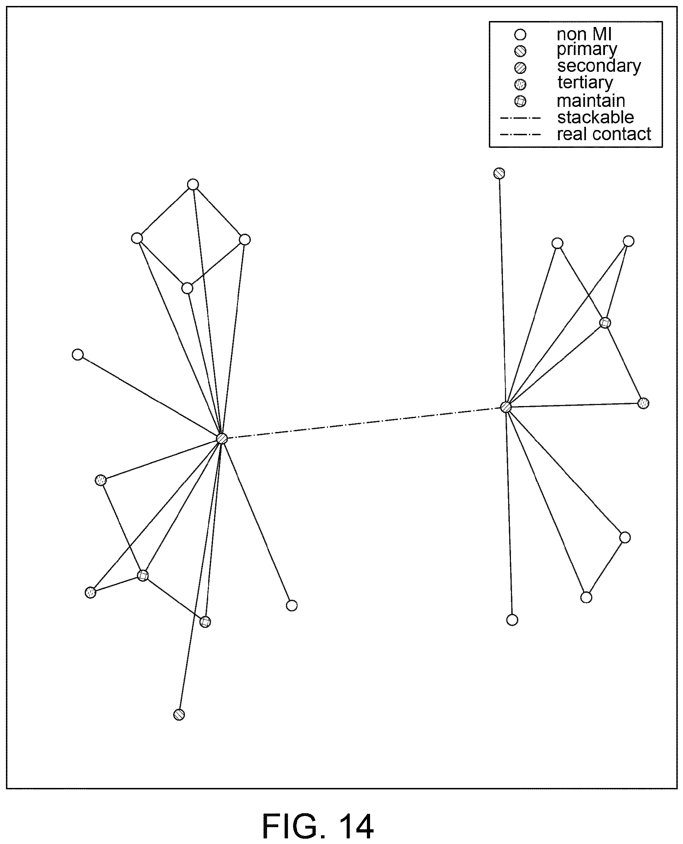

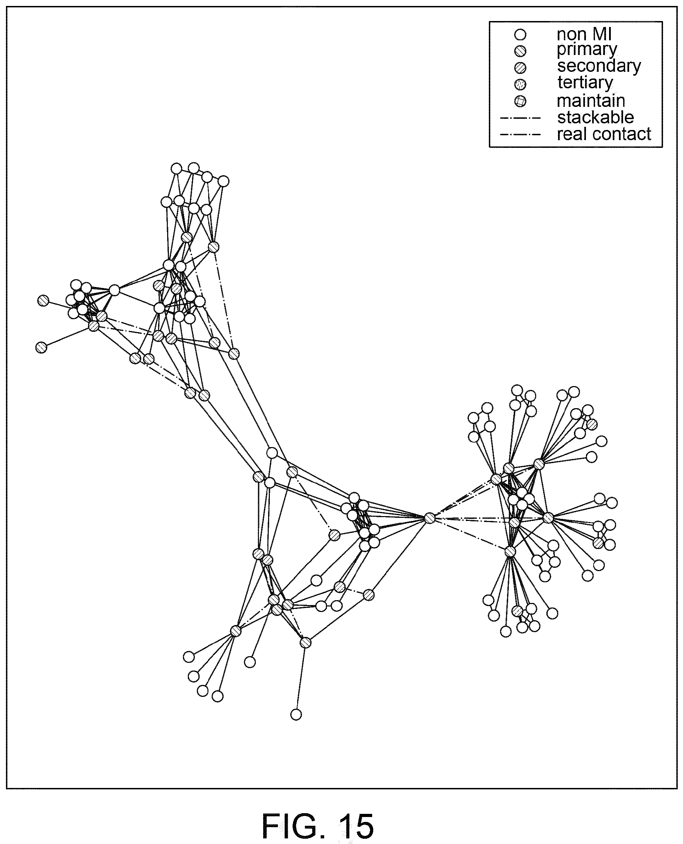

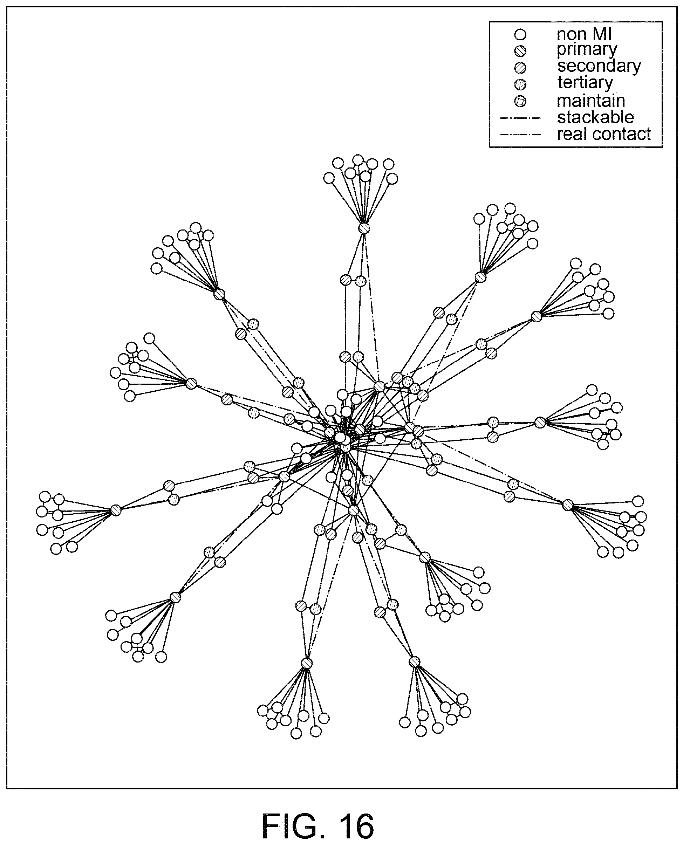

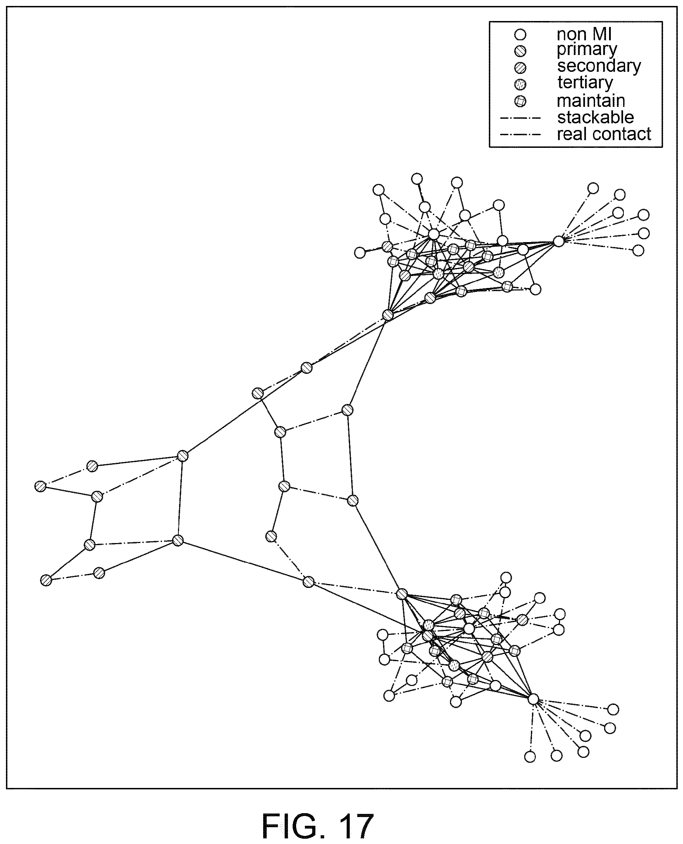

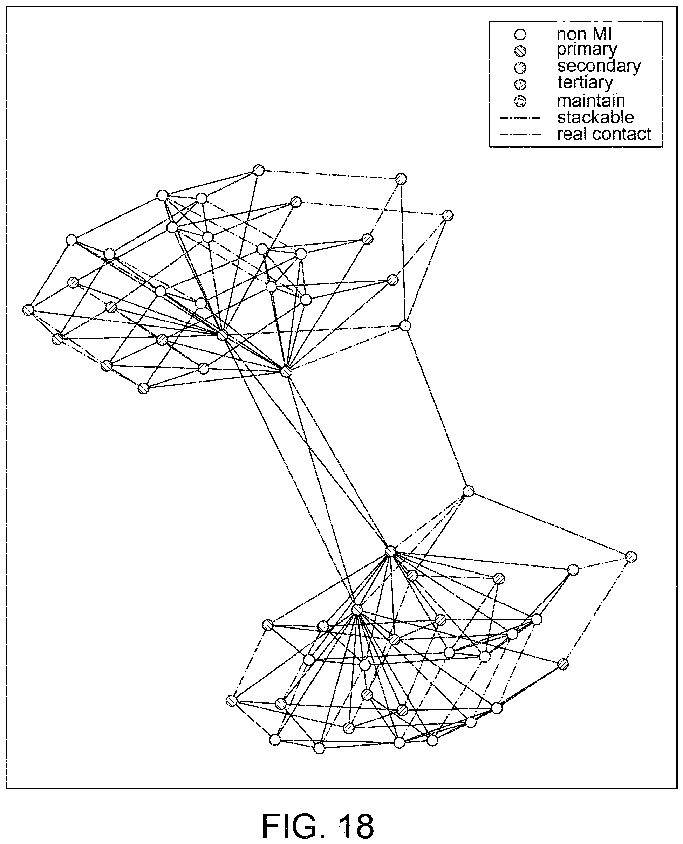

The learning method may also comprise defining a graph representing the entire CAD model representing a mechanical assembly of parts. Such a graph may have nodes, internal edges, and external edges representing canonical surfaces, internal connections, and contacts respectively, as for the previously described graphs representing local contacts. Each of the graphs representing respective local contacts may be sub-graphs of the graph representing the entire CAD model. Examples of CAD models and the respective graphs are illustrated in FIGs. 5-10 described herein below. FIGs. 11-18 described herein below illustrate examples of graphs representing local contacts between parts.

It should be noted that the detection of a mechanical interface of a CAD model representing a mechanical assembly of parts is a challenging task, as a user may have to be aware of all the possible connections between the single mechanical parts composing the mechanical assembly of parts. It is, therefore, an extremely time-consuming task to manually detect each of the mechanical interfaces and/or label each canonical surface with the respective label. Moreover, this task is prone to error, as a user may forget and/or not see some of the connections (e.g., some of the contacts) among mechanical parts (e.g., in the case where the mechanical assembly of parts comprises several parts) or not use the correct classification label for some of the canonical surfaces composing a mechanical interface. However, the detection of the mechanical interfaces may be required for the manufacturing process of the mechanical assembly of parts represented by a CAD model (and, thus, for the manufacturing process of each of the single mechanical parts comprised in the mechanical assembly of parts). In some cases, the detection of the mechanical interfaces may simplify the manufacturing process or may increase the longevity of the mechanical assembly of parts.

While manufacturing a mechanical assembly of parts represented by a CAD model it is beneficial to accurately detect the mechanical interfaces. Indeed, the zone of interactions (e.g., a zone of contact) among the mechanical parts composing the mechanical assembly of parts may be manufactured with higher tolerance and/or precision to obtain that the mechanical parts composing the mechanical assembly of parts fit properly together (e.g., minimize the distance between the parts, minimize friction between the parts). Therefore, the zones of interaction (e.g., the zones of contact), represented by the mechanical interfaces, may be manufactured with a higher precision and more detailed tolerances than some other zones (e.g., canonical surfaces) of the mechanical parts comprising the mechanical assembly of parts that, e.g., are not supposed to have functional roles/be in contact with other mechanical parts. As manufacturing with higher precision may involve longer production time and/or more expensive materials/machinery, it may be beneficial to exactly detect which zones are no interface to speed up the production process. The design and precision of these zones of interaction may ensure proper alignment, minimize energy loss, and enhance the durability and performance of the mechanical assembly. Effective management of these interaction zones may involve considerations of material compatibility, surface finish, lubrication, and tolerances to maintain optimal functionality under varying operational conditions. By meticulously defining the mechanical interfaces, mechanical products may achieve higher efficiency, reliability, and longevity.

While manufacturing a mechanical assembly of parts represented by a CAD model, it may be clear that all the mechanical parts comprising the mechanical assembly of parts are manufactured only to be used in the mechanical assembly of parts. Therefore, the only zones that may require higher precision and more detailed tolerances are the zones of interactions realized in the mechanical assembly of parts.

The learning method comprises training a classification function based on a training dataset comprising graphs representing local contacts. By using graphs representing local contacts, the learning method may consider only the most relevant mathematical structure for detecting the mechanical interfaces. Indeed, by not considering canonical surfaces that are far away from the local contacts between parts (e.g., canonical surfaces not being adjacent to a surface having a contact), the classification function learnt by the learning method is able to better detect the mechanical interfaces and classify, with a label of the label list, each canonical surface adjacent to a local contact. The canonical surfaces that are not adjacent to a local contact may always be classified as no interface. Moreover, the ratio between the number of interface faces and non-interface faces is much more balanced in the local graphs compared to in the entire set of canonical surfaces. Therefore, a classification function learned according to the learning method may better predict the classification label, being trained on an almost balanced dataset.

The learning method is a method for machine-learning a classification function configured for detection of mechanical interfaces of a CAD model representing a mechanical assembly of parts. The learning method may therefore be used to obtain the machine-learnt classification function. It is further provided a method of use of the machine-learnt classification function. The method of use comprises obtaining one or more graphs each representing a respective local contact between parts of a same CAD model representing the mechanical assembly of parts (i.e., all of the one or more graphs are representing a local contact, the local contact potentially depending on the graph, of a CAD model, the CAD model not depending on the graph). Each graph comprises one or more nodes. Each node represents a canonical surface of the CAD model. Each graph further comprises one or more internal edges. Each internal edge represents an internal connection between the canonical surfaces represented by the nodes connected by the edge. The canonical surfaces represent portions of a same part of the mechanical assembly. Each graph further comprises one or more external edges. Each external edge represents a contact between the canonical surfaces represent by the nodes connected by the edge. The canonical surfaces represent portions of different parts of the mechanical assembly. The method of use further comprises applying the machine-learnt classification function to the one or more graphs.

The method of use may comprise machine-learning the classification function as in the learning method. It is also proposed a computer-implemented process that integrates the learning method and the method of use. The process comprises performing the method and then performing the method of use.

The machine-learnt classification function (of the method of use and learnt by the learning method) takes as input one or more graphs, each representing a local contact between parts of a CAD model representing a mechanical assembly of parts and gives as output a classification of each of the nodes of each of the one or more local graphs as one of the label list. In example, the one or more graphs taken as input may represent all of the local contacts between parts of the CAD model. That is, each of the local contacts between parts of the CAD model may each be represented by one of the one or more graphs. Therefore, the one or more graphs may comprise representations of all the mechanical interfaces, as the mechanical interfaces are all adjacent to local contacts. Thus, the one or more graphs may be enough to represent the entire CAD model (the canonical surfaces not represented by the local graphs may all be no interface and there may be no need to apply the classification function to them). As it will be described herein below in the present disclosure, the method of use may comprise obtaining the CAD model and determining the one or more graphs. Thereby, the method of use may be used to classify each of the canonical surfaces of a CAD model representing a mechanical assembly of parts as one withing the above-defined label list.

The classification function may further be configured to form mechanical interfaces based on the outputted labels by regrouping neighboring canonical surfaces corresponding to primary, secondary, tertiary, and maintain faces, the canonical surfaces representing portions of a same mechanical part. Specifically, the classification function may further comprise a module configured to form mechanical interfaces based on the outputted labels by regrouping canonical surfaces corresponding to primary, secondary, tertiary, and maintain faces that have an internal connection, as defined above. That is, the classification function may further comprise a module that outputs, for each part of the assembly of mechanical parts represented by the input CAD model, all of the mechanical interfaces. Each of the mechanical interfaces is composed of one or more canonical surfaces that are connected by internal connections and form a connected component with respect to such a definition of connectedness. In implementations, the module may take as input a graph representing a local contact between parts of the CAD model (or a graph representing the CAD model itself). The module may further be configured to obtain a sub-graph of the input graph the sub-graph consisting of all the interface nodes, that is, all the nodes that are labeled by the machine-learnt classification function as primary, secondary, tertiary, or maintain faces. The sub-graph may comprise all of the internal edges between its nodes (but not the external edges). The module may further comprise determining each of the connected components of said sub-graph. The module may further comprise, for each of the connected components of said sub-graph, forming a mechanical interface consisting of the canonical surfaces represented by the nodes of the connected component of the sub-graph. In other implementations, a mechanical interface may correspond to a sub-graph that is not necessarily connected as some of the internal connections between the canonical surfaces composing the mechanical interface may not have been represented in the graph. In this case, other methods of regrouping may be implemented. Nevertheless, in implementations of the methods of the present disclosure, any mechanical interface involved in the method may correspond to a connected component of said sub-graph.

Therefore, the method of use may be used to take as input a CAD model representing a mechanical assembly of parts and give as output a classification of each of the canonical surfaces of the CAD model. Optionally, the method of use may give as output also the mechanical interfaces of the CAD model. Implementations of the method of use show that the output is obtained in real time (e.g., after a few seconds or fractions of a second after having provided the input). This is a huge improvement with respect to the manual method. Indeed, as described in detail above, the detection of mechanical interfaces is a complicated task that takes into account all possible zones of interactions among the parts of the mechanical assembly of parts. The manual detection of mechanical interfaces may take more than one hour of time and, on the contrary, the method of use enables obtaining the classification for the canonical surfaces and/or the mechanical interfaces in real time (e.g., in less than a second). In particular, the machine-learnt classification function and the method of use greatly improve the ergonomics of the steps of detecting the classification of the canonical surfaces and/or the mechanical interfaces (and hence, more generally, designing CAD models representing mechanical assemblies of parts).

Moreover, the method of use may decrease the number of errors in the classification of the canonical surfaces and/or the detection of mechanical interfaces, compared to the manual method. Indeed, in the manual method the user may not detect some of the zones of contact among the parts comprised in the mechanical assembly of parts, as the mechanical assembly of parts may comprise several parts. In addition, the user may not be certain of how exactly to classify each of the canonical surfaces composing a mechanical interface (e.g., in primary, secondary, tertiary, and maintain) as the definitions involved may be complex. Therefore, the method of use may be used to obtain a classification of the surfaces in the line of the examples provided by the experts, without the user having to understand each of the definitions involved in the classification.

The method of use may be included in a manufacturing process and/or the output of the method of use may directly be usable for manufacturing the product. For example, the method of use may include, after detecting the mechanical interfaces, storing the specifications of the CAD model representing a mechanical assembly of parts (or, alternatively, storing the specifications of each of the CAD models representing respective parts of the mechanical assembly of parts), for example in a file and/or as distributed CAD data on one or more storage and, optionally, converting them into manufacturing instructions (for example with a known CAD to CAM conversion process) for manufacturing a product modeled by the mechanical assembly of part (e.g., for manufacturing each of the mechanical parts comprised in the mechanical assembly and/or for assembling the mechanical parts to obtain the mechanical assembly of parts). The manufacturing instructions may, e.g., comprise different precision levels to be used for each of the canonical surfaces of the mechanical interface. The method may also automatically send the manufacturing instructions and/or the specification (e.g., a stored file, or distributed specifications) to a manufacturing machinery, so that the manufacturing machinery, following the instructions, produces the mechanical assembly of parts (e.g., each of the mechanical parts comprising the assembly and/or assembling the mechanical parts). The method may comprise the physical manufacturing or simply storing manufacturing instructions obtained from the specifications and output of the method and/or sending these instructions to the manufacturing process. The manufacturing instructions may comprise instructions for assembling two or more mechanical parts. The assembling may depend on the mechanical interfaces (e.g., to make mechanical interfaces of different mechanical parts match to each other). The manufacturing instructions may further comprise lubrification (e.g., lubrifaction of mechanical interfaces). A mechanical assembly of parts manufactured according to such instructions may achieve higher efficiency, reliability, and longevity.

Therefore, the method of use constitutes a great improvement to manufacturing mechanical assemblies of parts. Indeed, the method of use may ensure that all the mechanical interfaces of the mechanical assembly of parts to be manufactured are manufactured with the proper precision ensuring a smooth and efficient manufacturing process. The method of use may also comprise storing manufacturing instructions and/or manufacturing with a different precision each of the canonical surfaces depending on the classification of the canonical surface. For example, the method may comprise manufacturing with a higher precision the primary faces, and with lower precision the maintain faces. This may further increase productivity, reduce the cost, and reduce errors.

The method of use (e.g., the obtaining a CAD model representing a mechanical assembly of parts that may be comprised in the method of use) may also comprise acquiring one or more images of the mechanical assembly of parts (e.g., one or more images for the entire assembly and/or one or more images each of a respective part) and converting the acquired one or more images into a CAD model representing the mechanical assembly of parts. Acquiring the one or more images may, e.g., be from a distant or local source. For example, acquiring the one or more images may comprise acquiring at least one image with a camera or with a 3D scan. Therefore, the method of use may be used to detect mechanical interfaces of a real-world mechanical assembly of parts, and more specifically from physical measurements thereof. This may, e.g., prove useful to manufacture copies of a mechanical assembly of parts, ensuring that each canonical surface of the mechanical assembly of parts is manufactured according to their function. Indeed, the image and/or 3D scan may not be accurate enough to detect the precision/tolerances used in the manufacturing of each of the canonical surfaces comprised in the mechanical assembly of parts.

The learning method is a method of machine-learning, for learning a classification function (also called model). The learning method comprises obtaining a training dataset and training the classification function based on a training dataset. As is known *per se* from the field of machine-learning, the processing of an input by a model includes applying operations to the input, the operations being defined by data including weight values or parameters. Learning a model (e.g., a neural network or a GNN) thus includes determining values of the weights/parameters based on a dataset configured for such learning, such a dataset being possibly referred to as a learning dataset or a training dataset. For that, the dataset includes data pieces each forming a respective training sample or training example. The training samples/examples represent the diversity of the situations where the model is to be used after being learnt. Any training dataset herein may comprise a number of training samples/examples higher than 1000, 5000, or 10000. In the context of the present disclosure, by "learning a model based on a dataset", it is meant that the dataset is a learning/training dataset of the model, based on which the values of the weights/parameters are set. In the present disclosure, the training dataset is the obtained dataset of training examples, on which the model is learnt/trained. In implementations, the training dataset consists of tens of thousands examples each corresponding to a B-rep and an associated conditioning signal.

As is known *per se* from machine-learning, a neural network may be defined by its architecture, parameters, and hyperparameters. The architecture consists of layers, starting with the input layer whose neuron count may be determined by the dimensionality of the input data. This layer is followed by several hidden layers with a given number of neurons and activation functions. These layers and neurons define the network's depth and width, while the activation functions may introduce nonlinearity into the model. The output layer may have as many neurons as the variables in the output data. The interconnections between these layers define the topology of the neural network. The parameters of the neural network are the learnable weights and biases, which are determined in the training process. In contrast, the hyperparameters are pre-defined settings that are not learned from the training data. These encompasses the number of hidden layers, neurons per layer and much more. To train a neural network, at least two settings may be defined. First, a loss function, which is a metric that measures the error between the training data and the model's prediction, such as the mean square error (MSE) or the class-weighted cross entropy loss. Second, an optimizer, which modifies the model's weights and biases during the training process to minimize the loss function. Each optimizer has its own set of hyperparameters.

Specifically, the learning method comprises obtaining a training dataset comprising training samples, each training sample comprising a graph representing a local contact between parts of a CAD model representing a mechanical assembly of parts. In the present disclosure, a graph representing a local contact between parts of a CAD model represents a portion of the CAD model, the portion comprising canonical surfaces adjacent to a contact between different parts of the mechanical assembly of parts represented by the CAD model. The nodes of the local graph represent each one of said canonical surfaces. The edges of the local graph represent either internal connections (the internal edges) between canonical surfaces of a same part, or contacts (the external edges) between canonical surfaces of different parts. Therefore, a graph representing a local contact between parts of a CAD model is a mathematical representation of a geometry around a (local) contact of a CAD model. Each CAD model may comprise several distinct contacts between different parts, said contacts not being adjacent. Thus, a plurality of different graphs representing respective local contacts between parts may be associated to a same CAD model, each corresponding to one of the distinct contacts between different parts.

The obtaining of a training dataset may comprise retrieving (e.g., from local or remote memory) or receiving (e.g., from a remote system) the training dataset. Additionally or alternatively, the obtaining of a training dataset may comprise generating at least part of the training dataset.

Obtaining/generating at least part of the training dataset of the learning method may comprise obtaining a dataset comprising CAD models representing mechanical assemblies of parts (such as mechanical objects/products). Obtaining/generating at least part of the training dataset may further comprise for each CAD model representing a mechanical assembly of parts in the initial dataset, determining one or more graphs each representing a respective local contact between parts of the mechanical assembly of parts. A dataset comprising CAD models representing mechanical assemblies of parts may be called a CAD-dataset. The obtaining/generating at least part of the training dataset may therefore comprise obtaining a CAD-dataset and for each CAD model in CAD-dataset determining a one or more graphs each representing a respective local contact between parts of the assembly of parts.

The obtaining/generating of the training dataset may further comprise, before the determining, for each CAD model, of the one or more graphs each representing a respective local contact between parts of the assembly of parts, determining, for each CAD model of the initial dataset (i.e., the CAD-dataset), a graph representing the CAD model (i.e., a single graph representing the entire geometry of the CAD model, not only a portion of it). That is, obtaining/generating at least part of the training dataset may comprise, after the obtaining of a CAD-dataset, for each CAD model representing a mechanical assembly of parts comprised in the CAD-dataset, determining a graph representing the CAD model. The graph representing the CAD model may represent the entire CAD model, opposed to each of the graphs representing a respective local contact between parts of the mechanical assembly of parts, which may only represent a portion of the CAD model. The obtaining/generating at least part of the training dataset may further comprise determining, from each graph representing a respective CAD model, one or more graphs each representing a respective local contact between parts of the mechanical assembly of parts. Such one or more graphs may each be a sub-graph of the respective graph representing the entire mechanical assembly of parts. That is, for each CAD model of the initial dataset, the determining of one or more graphs each representing a respective local contact between parts of the assembly of parts may be based on the determined graph representing the CAD model (e.g., by restricting the graph representing the CAD model to sub-graph representing the local contact).

The obtaining of the CAD-dataset may comprise retrieving (e.g., from local or remote memory) or receiving (e.g., from a remote system) the CAD-dataset.

Obtaining/generating at least part of the training dataset may be advantageous, as a plurality of CAD models representing mechanical assemblies of parts may be available to the user.

FIG. 4 shows examples of mechanical assemblies of parts that may be used to obtain a CAD-dataset.

In the present disclosure, a graph representing a CAD model representing a mechanical assembly of parts will be referred to as a CAD-graph. A graph representing a local contact between parts of a CAD model representing a mechanical assembly of parts (e.g., such as the graphs comprised in the obtained training dataset) will be referred to as a local CAD-graph. Each of the local CAD-graphs may be a sub-graph of a respective CAD-graph (the CAD-graph representing the respective mechanical assembly of parts). Each CAD-graph may comprise (as sub-graphs) one or more local CAD-graphs. The local CAD-graphs comprised in a CAD-graph may be disjoint or have an intersection (as sub-graphs of the CAD graph).

In the present disclosure, each CAD-graph and each local CAD-graph comprise one or more nodes, one or more internal edges, and one or more external edges. Each of the nodes represents a canonical surface of the CAD model. Each internal edge represents an internal connection between the canonical surfaces represented by the nodes connected by the edge. By the mention of "internal connection", it is meant that the canonical surfaces represented by the nodes connected by the edge are portion of a same part of the mechanical assembly of parts. That is, the internal connection is within a single mechanical part. Each external edge represents a contact between the canonical surfaces represented by the nodes connected by the edge. By the mention "contact", it is meant that the canonical surfaces represented by the nodes connected by the edge are portion of different parts of the mechanical assembly of parts. That is, the contact is within two different parts. As mentioned above, an internal connection between two canonical surfaces of the CAD model may correspond to the adjacency, the coplanarity, and/or the coaxiality of the two canonical surfaces within a same mechanical part. Additionally or alternatively, an internal connection between two canonical surfaces of the CAD model may correspond to a separation between the two canonical surfaces consisting of a fillet, a chamfer, and/or another non-canonical surface within a same mechanical part. A contact between canonical surfaces of two different mechanical part of the CAD model may correspond to properties of contact between the two canonical surfaces such as contact, stackability, coaxiality, and/or coplanarity.

Notably, in the present disclosure, determining a CAD-graph from a CAD model representing a mechanical assembly of parts may comprise determining each of the canonical surfaces of the CAD model and all of the connections (that is, the internal connections and the contacts) between the determined canonical surfaces. Determining all of the connections may comprise determining the internal connections between couples of canonical surfaces representing portions of a same part of the assembly represented by the CAD model and determining the contacts between couples of canonical surfaces representing portions of different parts of the assembly represented by the CAD model. Determining the CAD-graph may further comprise defining/generating a node for each determined canonical surface, an internal edge for each couple of internally connected (i.e., having an internal connection) canonical surfaces of a same part of the assembly represented by the CAD model, and an external edge for each couple of canonical surfaces of different parts of the assembly that are in contact.

In the present disclosure, determining one or more local CAD-graphs from a CAD model representing a mechanical assembly of parts may comprise the same step performed for determining a CAD-graph, with the exception that determining a local CAD-graph may only require determining the canonical surfaces, internal connections, and contact that are adjacent to a given contact between parts of the assembly represented by the CAD model.

Alternatively, the determining of one or more local CAD-graph from a CAD model representing a mechanical assembly of parts may comprise first determining a CAD-graph of the CAD model and then determining the one or more local CAD-graph from the CAD-graph. The determining of the one or more local CAD-graphs may comprise determining a sub-graph of the CAD-graph comprising a set of nodes, the set of nodes comprising (e.g., consisting of) all the nodes of the CAD-graph that are in the boundary of any of the external edges of the CAD-graph. The sub-graph of the CAD-graph may further comprise a set of internal and external edges, the set of internal and external edges comprising all the internal and/or external edges of the CAD-graph that are bounded by two nodes comprised in the set of nodes. The determining of the one or more local CAD-graphs may further comprise determining each of the connected components of the sub-graph, each of the one or more local CAD-graphs being further determined by one of the connected components. The determining, from a connected component of the sub-graph, of the respective local CAD-graph may comprise enlarging said connected component to all the neighboring vertices.

In implementations, determining, for each CAD model, one or more graphs each representing a respective local contact between parts of the assembly of parts represented by the CAD model (i.e., one or more local CAD-graphs) comprises determining a sub-graph of the CAD-graph representing the CAD model. The determining may, or may not, comprise the determining of the CAD-graph (e.g., the CAD-graph may be predetermined, e.g., already comprised in a dataset). The sub-graph of the CAD-graph may comprise a set of nodes, the set of nodes comprising (e.g., consisting of) all the nodes of the CAD-graph that are in the boundary of any of the external edges of the CAD-graph. The sub-graph of the CAD-graph may further comprise a set of internal and external edges, the set of internal and external edges comprising all the internal and/or external edges of the CAD-graph that are bounded by two nodes comprised in the set of nodes. The determining may further comprise determining one or more connected components of the sub-graph. For example, the determining may comprise determining all the connected components of the sub-graph. Each of the connected components is a graph, comprising edges and nodes, and may comprise each of the boundary nodes of each of the comprised edges. Each of the connected components may correspond to a local contact between parts of the assembly of parts. Indeed, the external edges represent contact between parts of the assembly of parts. The determining may further comprise, for each connected component of the sub-graph, determining a graph representing a local contact between parts of the assembly of parts, that is, a local CAD-graph. The local CAD-graph may comprise one or more nodes, the one or more nodes comprising (e.g., consist of) both all the nodes of the connected component of the sub-graph and all nodes that are at a distance 1 (e.g., at graph distance 1, e.g., only considering internal edges) from the connected component of the sub-graph. The local CAD-graph may comprise all the external edges of the connected component of the sub-graph and all the internal edges of the graph that are adjacent to any node of the connected component of the sub-graph. Thus, the local CAD-graph may be connected and may consist of a 1-neighborhood (e.g., only considering internal edges) of the connected component of the sub-graph with respect to a graph distance.

In the present disclosure, "graph distance" may refer to a standard distance metric in graph theory, wherein the distance between any two nodes is defined as the number of edges in a shortest path connecting them. The shortest path may be composed only of internal edges. Accordingly, nodes that are at a distance of one from a sub-graph (e.g., the connected component of the sub-graph defined above) may be those that are directly adjacent (that is, being separated by an edge, e.g., an internal edge) to nodes within the sub-graph.

Implementations of the method of use may comprise obtaining one or more local CAD-graphs representing a same CAD model. The one or more local CAD-graphs may be obtained and/or determined in any of the possible ways described in the above implementations for determining local CAD-graph to be used as training sample in a training dataset. In specific, the method of use may comprise obtaining a CAD model and determining one or more local CAD-graphs from the CAD model (with any of the above implementations). Alternatively, the method of use may comprise obtaining a CAD model, determining a CAD-graph representing the CAD model, and determining one or more local CAD-graph from the CAD-graph (with any of the above implementations).

In implementations of the method of use, the obtaining of the one or more local CAD-graphs may comprise obtaining a CAD model and determining a CAD-graph of the CAD model. The determining of the CAD-graph may comprise determining the canonical surfaces of the CAD model (e.g., by regrouping faces), and generating a node for each canonical surface. The determining of the CAD-graph may further comprise determining the internal connections between couples of canonical surfaces representing portions of a same part of the assembly represented by the CAD model and generating an internal edge for each couple of connected canonical surfaces. The determining of the CAD-graph may further comprise determining the contacts between couples of canonical surfaces representing portions of different parts of the assembly represented by the CAD model and generating an external edge for each couple of canonical surfaces that are in contact. The method of use may comprise determining one or more local CAD-graphs from the CAD model, e.g., from the CAD-graph (e.g., as explained above). For example, the determining of one or more local CAD-graph may comprise determining a sub-graph of the graph representing the CAD model comprising a set of nodes, the set of nodes comprising (e.g., consisting of) all the nodes of the graph representing the CAD model that are in the boundary of any of the external edges of the graph representing the CAD model. The sub-graph of the CAD-graph may further comprise a set of internal and external edges, the set of internal and external edges comprising all the internal and/or external edges of the graph representing the CAD model that are bounded by two nodes comprised in the set of nodes. The determining of one or more local CAD-graphs may further comprise determining one or more connected components of the sub-graph. The determining of one or more local CAD-graphs may further comprise determining, for each connected component of the sub-graph, a local CAD-graph. The determined local CAD-graph comprising one or more nodes, the one or more nodes comprising all the nodes of the connected component of the sub-graph and all the nodes that are at distance 1 (e.g., at graph distance of 1 as explained above, e.g., only using internal edges) of the connected component of the sub-graph. The determined local CAD-graph comprises all the internal edges of the graph that are adjacent to any node of the connected component of the sub-graph and all the external edges of the connected component of the sub-graph.

Implementations of the method of use may comprise, after the obtaining of a CAD model, the determining of a CAD-graph representing the CAD model, the determining of one or more local CAD-graph from the CAD-graph, and the applying of the machine-learnt classification function to the one or more local CAD-graphs, labelling each node of the CAD-graph with a label of the label list. Thus, in implementations, the method of use may comprise providing as input the one or more local CAD-graphs obtained from a CAD-graph to the machine-learnt classification function, and gathering the output of the classification function to label each node of the CAD-graph with a label of the label list. That is, in implementation, the method of use may comprise gathering the results of the application of the machine-learnt classification function to the one or more local CAD-graphs by labeling the nodes of the CAD-graph with the labels outputted by the machine-learnt classification function for each of the local CAD-graphs. Implementations of the method of use may further comprise labeling each canonical surface of the CAD model with a label of the label list, the label corresponding to the respective label of the node associated with the canonical surface.

As each local CAD-graph may be a sub-graph of the CAD-graph, each of the nodes of each of the local CAD-graph may uniquely correspond to a node of the CAD-graph. Thus, after applying the machine-learnt classification function to each of the local CAD-graphs, the labels obtained for each of the nodes of each of the local graphs may directly be used for labelling the corresponding nodes of the CAD-graph. The labelling of each node of the CAD-graph with a label of the label list may comprise assigning the label "no interface" to any node of the CAD-graph not corresponding to any node in any of the local CAD-graphs comprised in the CAD-graph. This may be important, as one or more of the nodes of the CAD-graph may not be present in any of the local CAD-graphs determined from the CAD-graph. Indeed, each of the local CAD-graphs may consists of nodes that are at a distance at most one from a respective connected component of the sub-graph of the CAD-graph consisting of all the external edges. Thus, any node of the CAD-graph that is at distance at least 2 from any external edges (e.g., from any node adjacent to any external edge) may not be in any local CAD-graph.

Implementations of the method of use may handle double labelling in any way known in the art (e.g., choosing the highest level of interface if contradictory labels are assigned). Indeed, the local CAD-graphs comprised in the CAD-graph may have an intersection and it might happen that the machine-learnt classification function gives a different label to nodes of different local CAD-graphs corresponding to a same node in the CAD-graph. However, these intersections are usually small, and the nodes concerned are usually very few (e.g., less than 10% or 5%) compared to the size of the CAD-graph.

In the learning method, each CAD-graph and/or local CAD-graph comprised in a dataset (e.g., the training dataset of the machine-learning method and/or a dataset obtained from a CAD-dataset) further comprises a label for each node, the label is one within the label list: primary face of a mechanical interface, secondary face of a mechanical interface, tertiary face of a mechanical interface, maintain face of a mechanical interface, and no interface. Each label of each node corresponds to the respective classification of the canonical surface of the CAD model representing the mechanical assembly of parts associated with the node. That is, a node is labeled, e.g., primary face if and only if the canonical surface associated with the node, is a primary face. The labels may be the ground truth used for the training of the classification function.

In implementations of the learning method, determining a CAD-graph and/or a local CAD-graph from a CAD model representing a mechanical assembly of parts comprised in a CAD-dataset may comprise labelling (with a label withing the label list) each node with the classification label of the canonical surface represented by the node. Determining each of the local CAD-graphs from a CAD-graph may also comprise labelling each node of each of the local CAD-graphs with the classification label of the respective node of the CAD-graph. That is, as a local CAD-graph may be a sub-graph of a CAD-graph, the labelling of the local CAD-graph may be induced (e.g., by restriction) from the labelling of the respective CAD-graph.

FIGs. 5-10 show different examples of CAD models representing mechanical assemblies of parts and the associated CAD-graphs. Specifically, the FIGs. 5A-10A show the CAD models and the FIGs. 5B-10B show the associated CAD-graphs. The CAD-graphs comprise a label for each node (corresponding to a different hatching) corresponding to the label list. Moreover, the external edges (corresponding to "real contact" and "stackable") are marked differently from the internal edges.

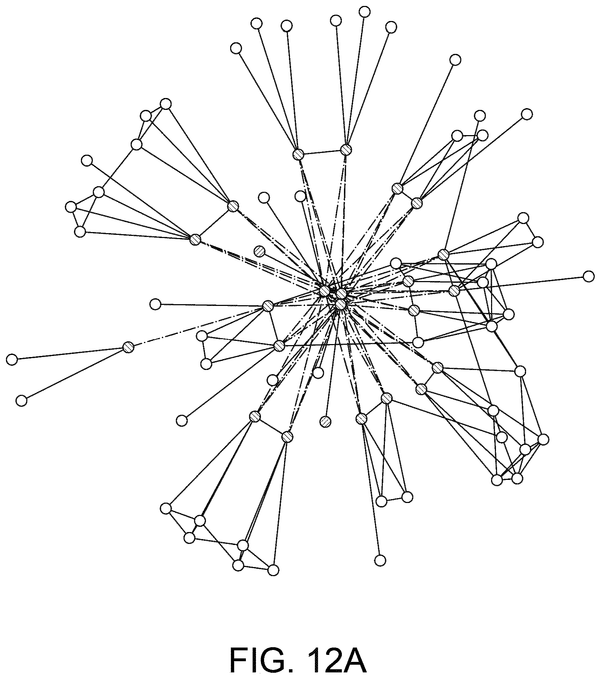

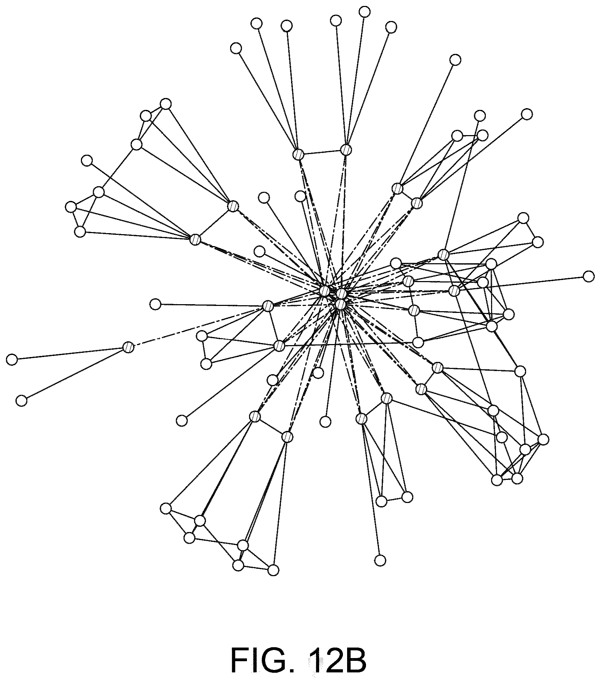

FIGs. 11-12 show examples of local CAD-graphs. Specifically, FIGs. 11A and 12A show examples of local CAD-graphs comprising labels for each node (corresponding to a different hatching) corresponding to the label list. Moreover, the external edges (corresponding to "real contact" and "stackable") are marked differently from the internal edges. FIGs. 11B and 12B highlight the external edges and the internal edges between couple of nodes both adjacent to a respective external edge.

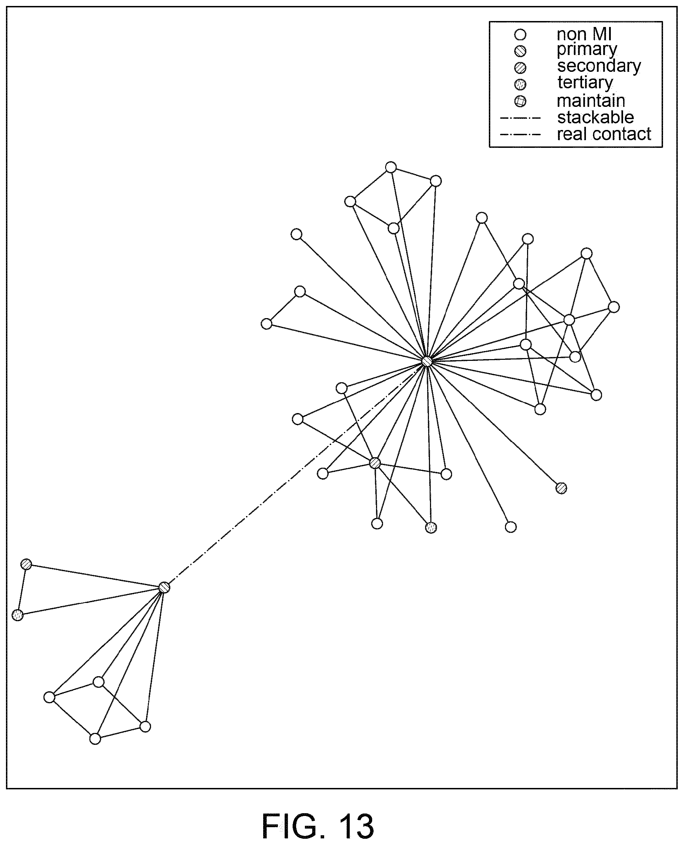

FIGs. 13-18 show examples of local CAD-graphs comprising labels for each node (corresponding to a different hatching) corresponding to the label list. Moreover, the external edges (corresponding to "real contact" and "stackable") are marked differently from the internal edges.

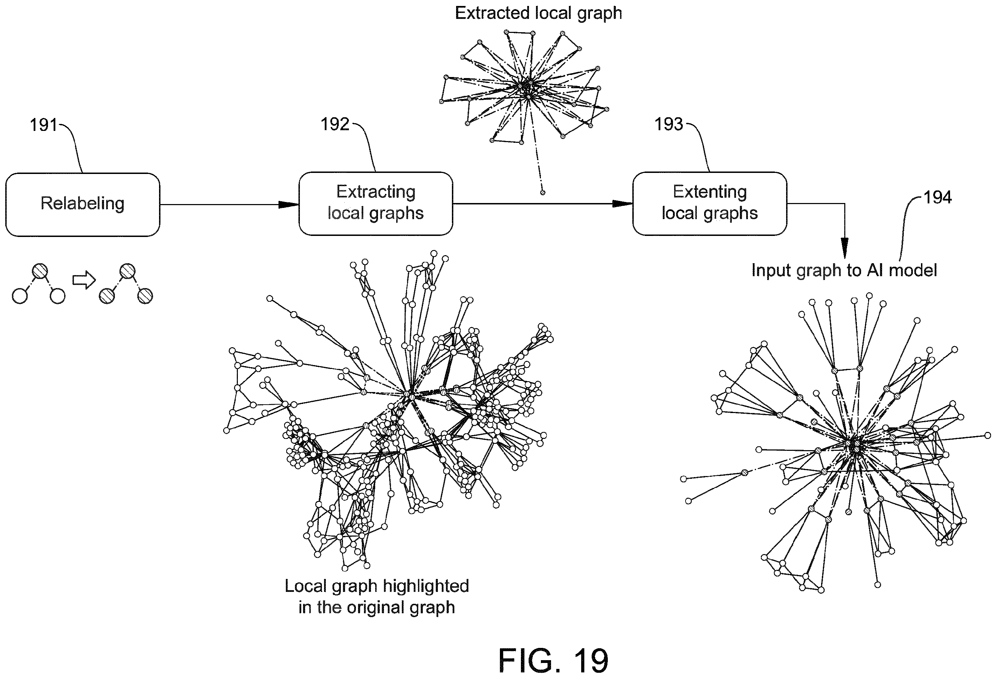

FIG. 19 illustrates a flowchart of the determining of one or more local CAD-graph from a CAD-graph that may be comprised in the learning method. Specifically, implementations of the learning method may comprise, after the obtaining of a CAD-dataset, the determining of a CAD-graph for every model of the CAD-dataset, and the labeling of each node of each of the CAD-graph with a label within the label list, relabeling 191 the nodes of the CAD-graph. Indeed, some nodes may have been incorrectly labeled by experts. In such implementations, the determining may further comprise extracting 192 from the CAD-graph the connected components of the sub-graph obtained by considering all the internal and external edges that are bounded by two nodes, each node bounding an external edge. In such implementations, the determining may further comprise extending 193 the extracted connected components to the 1-neighborhood (e.g., with respect to a graph distance). In such implementations, the determining may further comprise forming 194 a dataset of local CAD-graphs with the local CAD-graphs so-obtained.

In the present disclosure, CAD models may be B-reps comprising a plurality of faces. In implementations of either the learning method or the method of use, determining each of the canonical surfaces of a CAD model (e.g., a B-rep) may comprise determining whether each of the faces of the CAD model (e.g., each of the faces of the B-rep) is a portion of a canonical surface, that is a portion of a plane, a sphere, a cone, a torus, or a cylinder. In implementations, determining each of the canonical surfaces may further comprise joining one or more different faces that are in contact and are portion of a same canonical surface. For example, joining two faces that are portions of cylinder, to obtain a joint face that is a portion of a cylinder. Therefore, in implementations, each of the detected canonical surfaces may consist of one or more faces of the B-rep defining the CAD model.

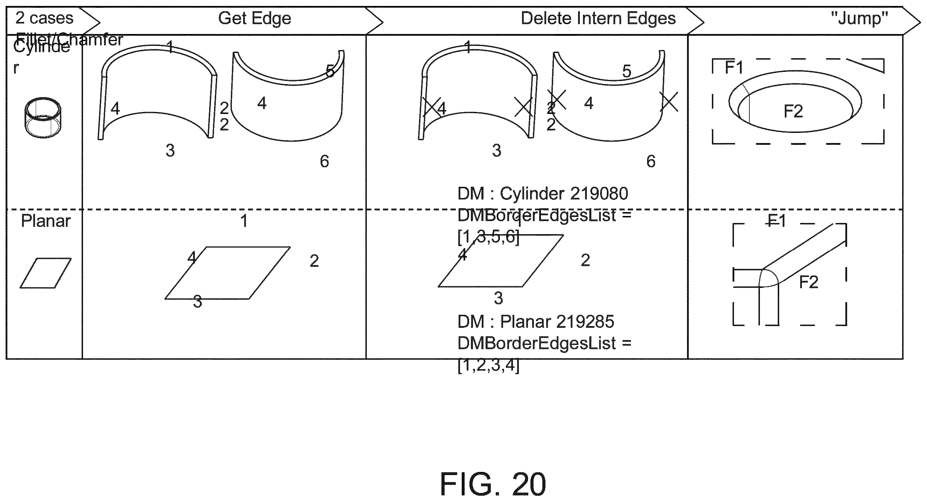

FIG. 20 illustrates an example of the above-described implementations. In the figure, a hollow cylinder is composed of two faces. The two faces are joined together to form a unique canonical surface that is a portion of a cylinder.

In implementations of the learning method, the obtaining of a dataset (e.g., the training dataset of the learning method and/or a dataset obtained from a CAD-dataset) may comprise obtaining and/or determining, for each CAD-graph and/or local CAD-graph comprised in the training dataset, a node-vector for each node of the (local) CAD-graph, an internal-edge-vector for each internal edge of the (local) CAD-graph, and/or an external-edge-vector for each external edge of the (local) CAD-graph. Implementations of the learning method node-vectors, internal-edge-vectors, and external-edge-vectors of a local CAD-graph may be directly determined (e.g., be the same) from their counterpart associated with a respective CAD-graph.

Specifically, the obtaining of a training dataset may comprise retrieving (e.g., from local or remote memory) or receiving (e.g., from a remote system) a node-vector for each node of each respective (local) CAD-graph, an internal-edge-vector for each internal edge of each respective (local) CAD-graph, and/or an external-edge-vector for each external edge of each respective (local) CAD-graph.

Additionally or alternatively, at least part of the dataset may be obtained/determined from a CAD-dataset and the obtaining of the dataset may further comprise determining, for each CAD model representing a mechanical assembly of parts comprised in the CAD-dataset, a node-vector for each canonical surface of the CAD model (corresponding to a node), an internal-edge-vector for each internal connection between canonical surfaces of a same part of the assembly represented by of the CAD model (corresponding to an internal edge), and/or an external-edge-vector for each contact between canonical surfaces of different parts of the assembly represented by of the CAD model (corresponding to an external edge).

Each of the node-vectors, internal-edge-vectors, and/or external-edge-vectors included in each of the (local) CAD-graphs may be advantageous for training the classification function (and, after the training, for the inference step of the method of use). Indeed, during training, the node-vectors, internal-edge-vectors, and/or external-edge-vectors may be used to better understand and predict the training samples.

In implementations of the method of use, the obtaining of one or more local CAD-graphs may comprise obtaining and/or determining a node-vector for each node of the local CAD-graph, an internal-edge-vector for each internal edge of the local CAD-graph, and/or an external-edge-vector for each external edge of the local CAD-graph. The obtaining and/or determining may be implemented in any of the possible ways described above in relation to the equivalent steps for the learning method. For example, the method of use may comprise obtaining a CAD model, determining a node-vector for each canonical surface (corresponding to a node) of the CAD model, an internal-edge-vector for each internal connection between canonical surfaces of a same part of the assembly represented by the CAD model (corresponding to an internal edge), and/or an external-edge-vector for each contact between canonical surfaces of different parts of the assembly represented by of the CAD model (corresponding to an external edge).

A node-vector associated to a node (that may be obtained and/or determined in the learning method and/or in the method of use) may be a feature vector representing properties of a canonical surface represented by the node. In specific, a node-vector may be a vector comprising several entries, each entry corresponding to a respective property of the canonical surface represented by the node. For example, each node-vector may comprise an entry for a surface type (e.g., one within the list of the canonical surfaces, that is, plane, sphere, cone, torus, or cylinder), an area, parameters defining the surface type (e.g., radius if the surface type is a sphere), orientation, material, or a combination thereof.

An internal-edge-vector associated to an internal edge (that may be obtained and/or determined in the learning method and/or in the method of use) may be a feature vector representing properties of the internal connection represented by the edge. The feature vector may be a vector comprising several entries, each entry corresponding to a respective property of the internal connection between the canonical surfaces represented by the edge. For example, each property of the internal connection represented by each internal-edge-vector representing the properties of a connection between two canonical surfaces comprise one or more of the following:
- convexity, that is, whether the local portion of the CAD model comprising the two canonical surfaces is convex;
- concavity, that is, whether the local portion of the CAD model comprising the two canonical surfaces is concave;
- coplanarity, that is, whether the two canonical surfaces are on a same plane;
- coaxiality, that is, whether the two canonical surfaces are portion of cylinders sharing the same axis;
- neighbor smooth, that is, the two canonical surfaces share a common edge in a same plane;
- presence of a fillet, that is, the two canonical surfaces are separated by a fillet;
- presence of a chamfer, that is, the two canonical surfaces are separated by a chamfer; and/or
- presence of a datum, that is, the two canonical surfaces are separated by a non-canonical set of surfaces (e.g., that may not support a mechanical interface) such as chamfrain, fillet, or curved surfaces.

An external-edge-vector associated to an external edge (that may be obtained and/or determined in the learning method and/or in the method of use) may be a feature vector representing properties of the contact represented by the edge. The feature vector may be a vector comprising several entries, each entry corresponding to a respective property of the contact between the canonical surfaces represented by the edge. For example, each property of the contact represented by each external-edge-vector representing the properties of a connection between two canonical surfaces comprise one or more of the following:
- contact, that is, whether the two canonical surfaces are in direct contact with each other, sharing a common surface area without any gaps or overlaps;
- stackablity, that is, whether the two canonical surfaces are portion of cylinders that are fitted together;
- coaxiality, that is, whether the two canonical surfaces are (on different parts and) portion of cylinders sharing the same axis; and/or
- coplanarity, that is, whether the two canonical surfaces are (on different parts and) on a same plane.

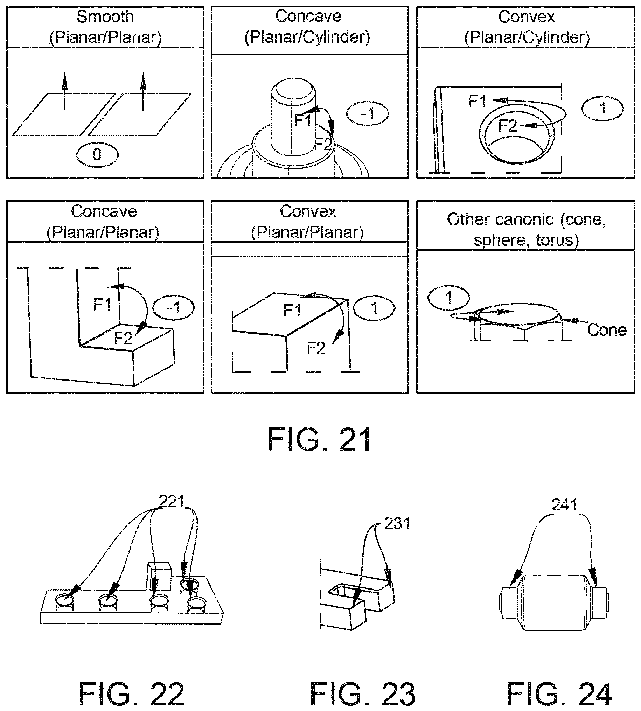

FIGs. 21-32 show examples of connections between canonical surfaces.

FIG. 21 shows examples of internal connections, comprising smooth, concave, convex, and other canonic.

FIG. 22 illustrates a mechanical part of a mechanical assembly of parts comprising five canonical surfaces that are portions of hollow cylinders 221. The five portions of hollow cylinders 221 are aligned on the same plane, that is, are coplanar. Therefore, the five portions of hollow cylinders 221 have pairwise internal connections. The internal-edge-vectors associated to the internal edges representing the internal connections may comprise the information that the internal connection is a coplanar internal connection between cylinders.

FIG. 23 illustrates a mechanical part of a mechanical assembly of parts with two canonical surfaces that are portion of planes 231. The two portions of planes 231 are coplanar. Therefore, the two portions of planes 82 have an internal connection. The internal-edge-vector associated to the internal edge representing the internal connection may comprise the information that the internal connection is a coplanar internal connection between planes.

FIG. 24 illustrates a mechanical part of a mechanical assembly of parts with two canonical surfaces that are portion of cylinders 241. The two portions of cylinders 241 are coaxial. Therefore, the two portions of cylinders 241 have an internal connection. The internal-edge-vector associated to the internal edge representing the internal connection may comprise the information that the internal connection is a coaxial internal connection between cylinders.

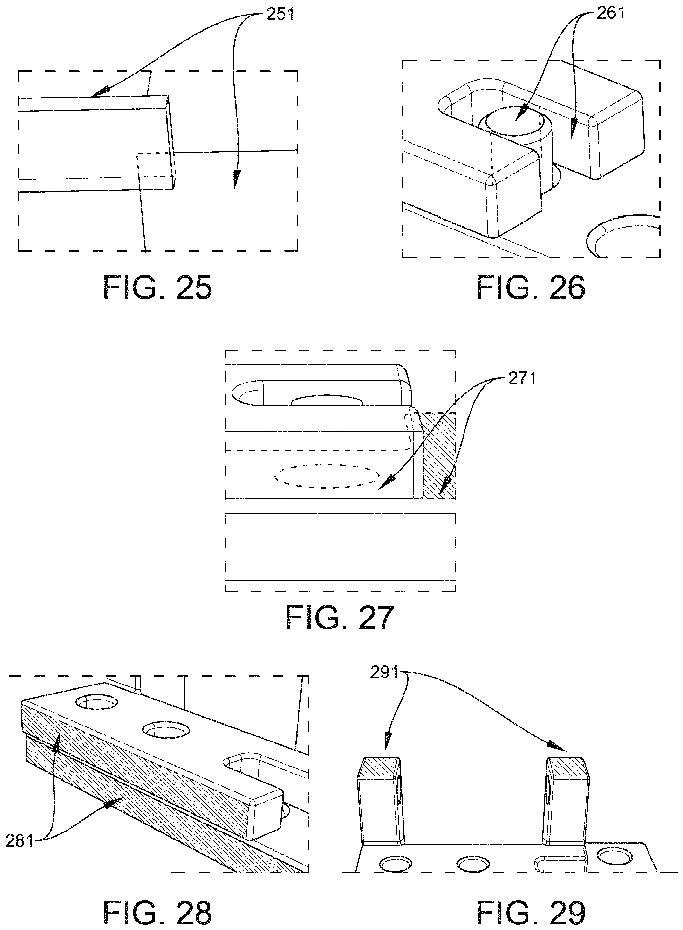

FIG. 25 illustrates two mechanical parts of a mechanical assembly of parts with two canonical surfaces that are portion of planes 251. The two portions of planes 251 are in contact. Therefore, the two portions of planes 251 have a contact. The external-edge-vector associated to the external edge representing the contact may comprise the information that the contact is a (direct) contact between planes.

FIG. 26 illustrates mechanical parts of a mechanical assembly of parts with canonical surfaces that are portions of planes and cylinders 261. The portions of planes and cylinders 261 are in contact. Therefore, the portions of planes and cylinders 261 have a contact. The external-edge-vector associated to the external edges representing the contacts may comprise the information that the contacts are (direct) contact between canonical surfaces.

FIG. 27 illustrates two mechanical parts of a mechanical assembly of parts with two canonical surfaces that are portion of planes 271. The two portions of planes 271 are in contact. Therefore, the two portions of planes 271 have a contact. The external-edge-vector associated to the external edge representing the contact may comprise the information that the contact is a (direct) contact between planes.

FIG. 28 illustrates two mechanical parts of a mechanical assembly of parts with two canonical surfaces that are portion of planes 281. The two portions of planes 281 are coplanar. Therefore, the two portions of planes 281 have a contact. The external-edge-vector associated to the external edge representing the contact may comprise the information that the contact is a coplanar contact between planes (of different parts).

FIG. 29 illustrates two mechanical parts of a mechanical assembly of parts with two canonical surfaces that are portion of planes 291. The two portions of planes 291 are coplanar. Therefore, the two portions of planes 291 have a contact. The external-edge-vector associated to the external edge representing the contact may comprise the information that the contact is a coplanar contact between planes (of different parts).

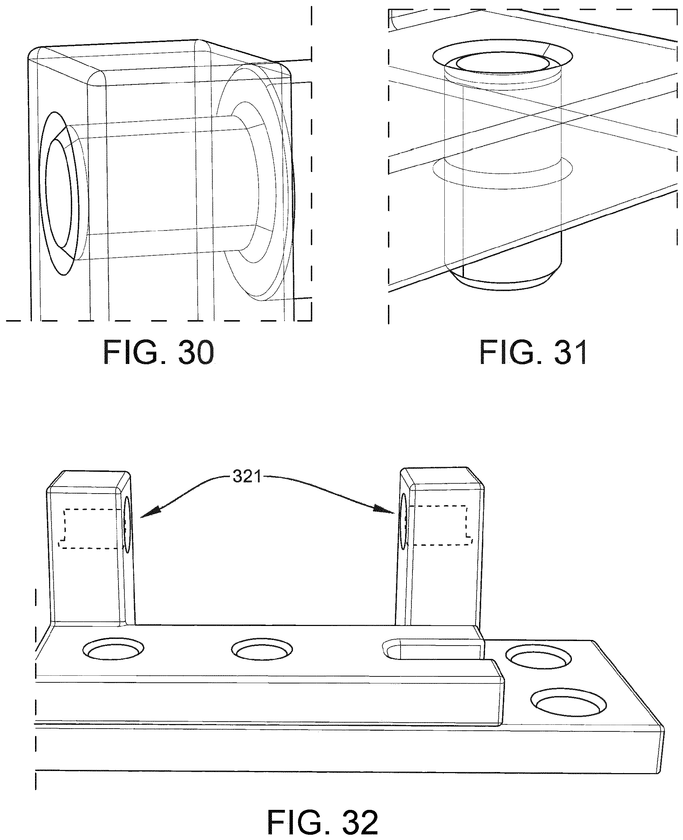

FIG. 30 and 31 illustrate mechanical parts of a mechanical assembly of parts with canonical surfaces that are portions of cylinders. The portions of cylinders are stackable. Therefore, the two portions of cylinders have a contact. The external-edge-vector associated to the external edge representing the contact may comprise the information that the contact is a stackable contact between portion of cylinders.

FIG. 32 illustrates two mechanical parts of a mechanical assembly of parts with two canonical surfaces that are portion of cylinders 321. The two portions of cylinders 321 are coaxial. Therefore, the two portions of planes 321 have a contact. The external-edge-vector associated to the external edge representing the contact may comprise the information that the contact is a coaxial contact between cylinders (of different parts).

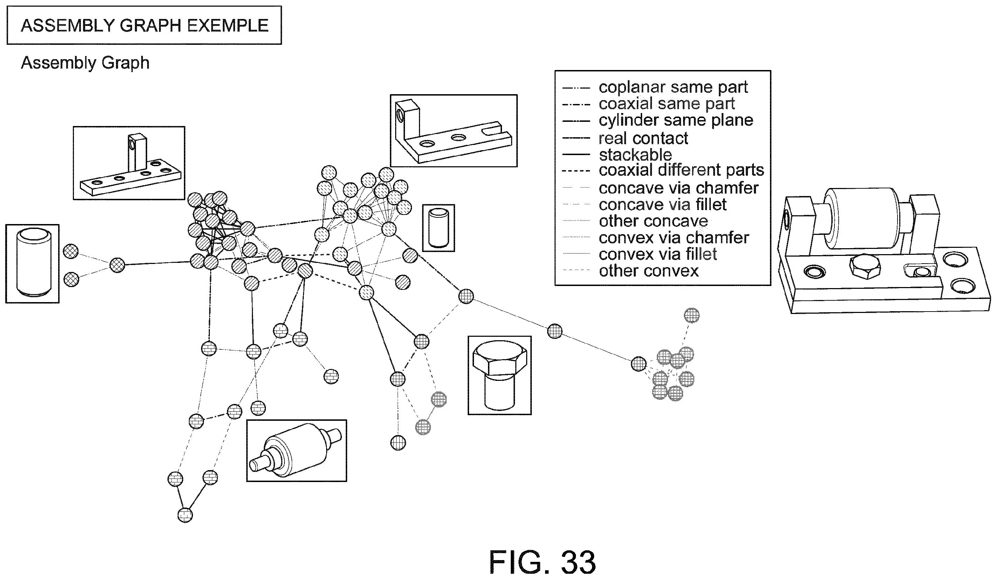

FIG. 33 illustrates a CAD-graph of a mechanical assembly of parts. The nodes of the CAD-graph are illustrated with a hatching each corresponding to a part of the assembly. The edges comprise the information about the type of internal connection or contact between the associated canonical surfaces.

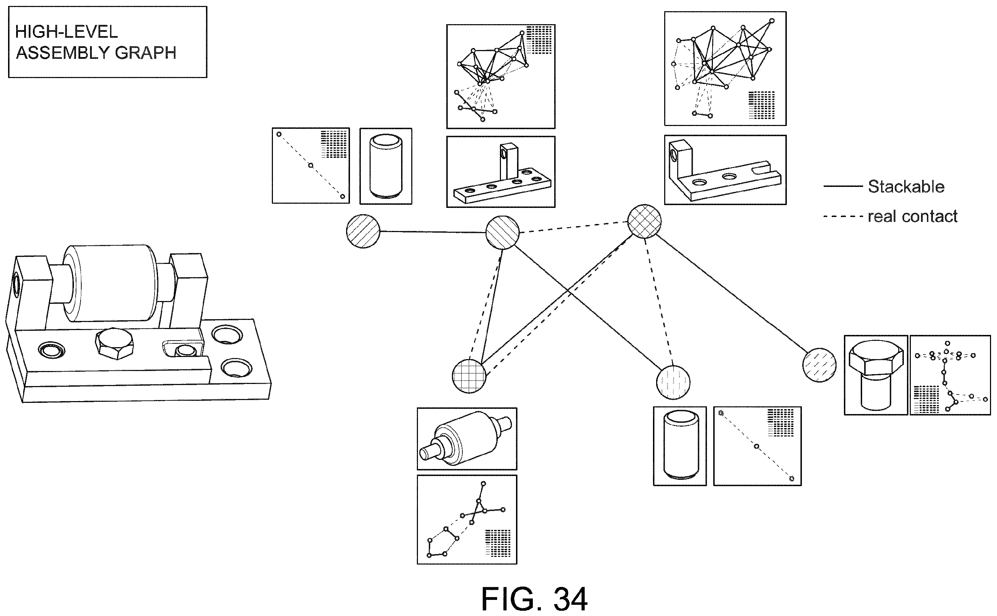

FIG. 34 illustrates an assembly level graph of the CAD-graph of FIG. 33 (i.e., only showing the external connections and contacts between the mechanical parts) and for each part a respective CAD-graph.

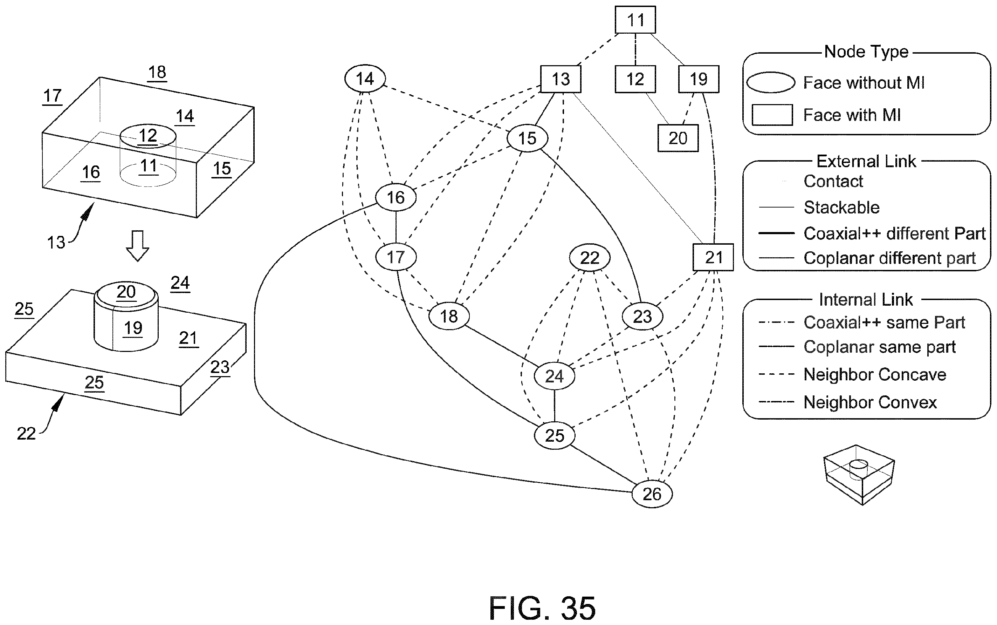

FIG. 35 illustrates a CAD model representing a mechanical assembly of parts consisting of two mechanical parts. Each node of the graph is labeled as being part of a mechanical interface (without further specifying whether the node is associated with a primary, secondary, tertiary, or a maintain face). In particular, the canonical surfaces 11, 12,13, 19, 20, and 21 are part of mechanical interfaces. In FIG. 35 each (internal or external) edge is associated with a respective internal connection or contact. In FIG. 35, each node may further comprise a node-vector. The node-vector of each of the nodes besides nodes 11 and 19 may comprise the information that the surface type of the associated canonical surface is "plane", and the node-vector of the nodes 11 and 19 may comprise the information that the surface type of the associated canonical surface is "cylinder". Similarly, in FIG. 35, each edge may further comprise an edge-vector.

In implementations of the learning method and/or the method of use, determining a (local) CAD-graph from a CAD model representing a mechanical assembly of parts, determining each of the node-vectors for each of the canonical surfaces (and the corresponding nodes), determining each of the internal-edge-vectors for each of the internal connections, and/or determining each of the external-edge-vectors for each of the contacts may comprise several different steps. For example, each of the determining may comprise several methods, each of which specialized in obtaining a single feature (e.g., an entry of a node/internal-edge-vector/external-edge-vector). In implementations, determining a (local) CAD-graph/each of the node-vectors/each of the internal-edge-vectors/each of the external-edge-vectors from a CAD model representing a mechanical assembly of parts may comprise one or more steps of extraction.

In implementations of the learning method and/or the method of use, generating each of the node-vectors from a CAD model may comprise extracting information related to mechanical interfaces (e.g., ID, type). In implementations, generating each of the node-vectors from a CAD model may comprise extracting the topology of the CAD model (e.g., ID, area, axis, material orientation, type of canonical surface). In implementations, generating each of the internal-edge-vectors from a CAD model may comprise determining the type of internal connection (e.g., coaxial, coplanar). In implementations, determining the internal connections between canonical surfaces of a CAD model may comprise detecting fillets and chamfers to study the neighborhoods between the canonical surfaces (e.g., portions of planes, cylinders, spheres, cones, tori). In implementations, generating each of the external-edge-vectors from a CAD model may comprise determining contacts (e.g., direct contact, stackable, coaxial).

In implementations of the learning method and/or of the method of use, a step of extraction (comprised in the one or more steps of extraction) may comprise extraction of material meaning. Extraction of material meaning is a process that allows to determine certain characteristics of 3D objects, especially for cylinders. The extraction of material meaning enables the method to discern whether a cylinder is representing a hollow or solid part of the mechanical part. This may indicate whether the cylinder may be a screw, a gear, or another type of object. In implementations, extraction may comprise determining on which side of a canonical surface (e.g., a portion of a plane) the material is located.

In implementations of the learning method and/or of the method of use, a step of extraction (comprised in the one or more steps of extraction) may comprise determining the normal and center of each face of the CAD model (e.g., of each canonical surface). The normal and center may determine an orientation relative to the object. The step of extraction may further comprise determining the orientation of each face in its "shell", the shell representing the outer envelope of the object. Herein, a "shell" may be a surface (e.g., a set of faces connected by edges) bounding a volume in the 3D space. A shell may be an inner shell or an outer shell.

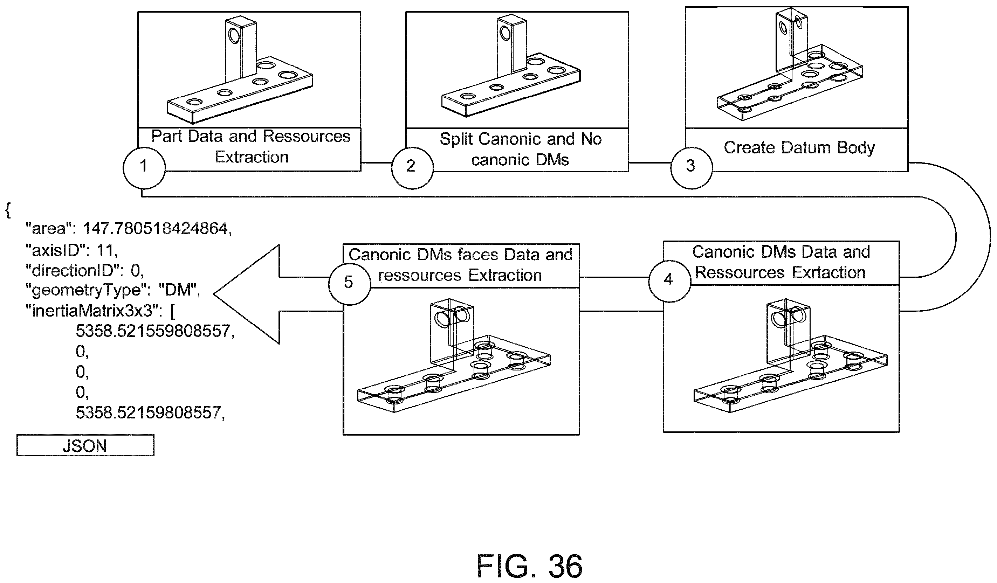

FIG. 36 illustrates an implementation of a step of extraction, comprising extracting data and resources, separating canonical surfaces and non-canonical surfaces, creating the datum body (e.g., the set of non-canonical surfaces), and extracting resources form the canonical surfaces.

In implementations of the learning method and/or of the method of use, after extracting various information such as axes and material orientation, the information may be processed to obtain the different types of connections (internal connections and/or contacts) between two surfaces. The table below illustrates an example of the conditions to be checked for each type of connection.

| **Type Edge** | **Exemple** | **Axis** | **Material Orientation** | **Part** | **Check intersection** | **Check ratio size radius** |
|---|---|---|---|---|---|---|
| Contact | Plan/Plan | Same | Different | Different | Yes | X |
| | Plan/Cylinder | X | = 1 (Cylinder Full) | Different | X | X |
| Coplanar same part | Plan/Plan | Same | Same | Same | X | X |
| Coplanar different part | Plan/Plan | Same | Same | Different | X | X |
| Stackable | Cylinder/ Cylinder | Same | Different | Different | X | Yes |
| Cylinder same plan | Cylinder/ Cylinder | Differ ent | Same = -1 (Cylinders empty) | Different | X | Yes |
| Coaxial Same Part | Cylinder/ Cylinder | Same | Same | Same | X | Yes |
| Coaxial Different Part | Cylinder/ Cylinder | Same | Same | Different | X | Yes |

In implementations, the above conditions may have to be extended to all combinations of canonical surfaces (e.g., plane, cylinder, sphere, cone, and/or torus). Moreover, the implementations may comprise filtering the faces that are likely to be compatible before running the intersection operator. This may ensure that it is indeed a real contact or stackable.

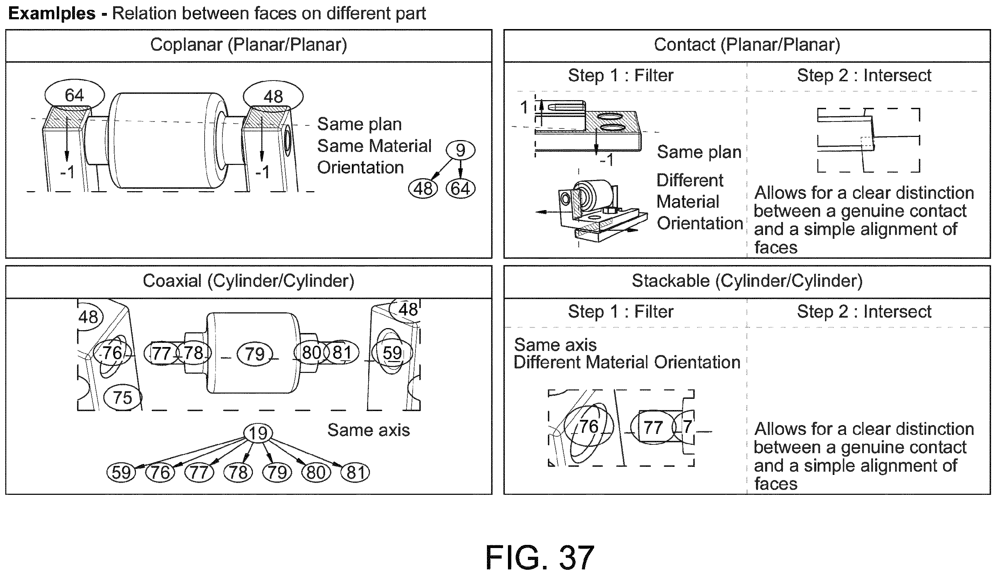

FIG. 37 illustrates an example of such an extraction step.

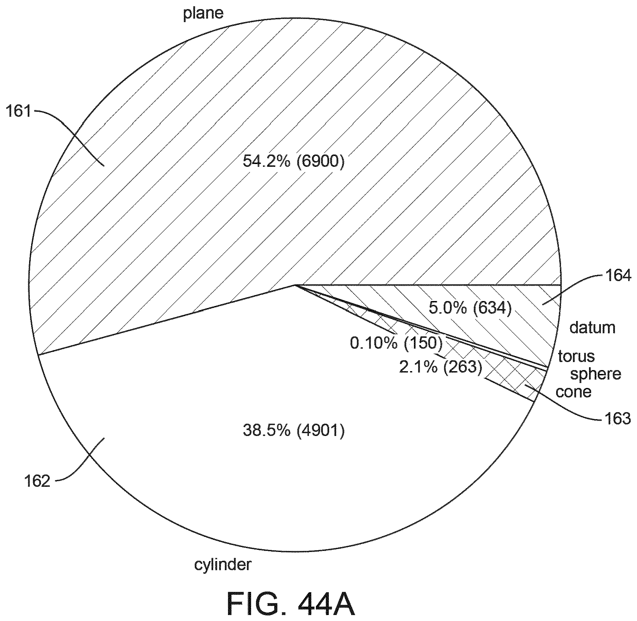

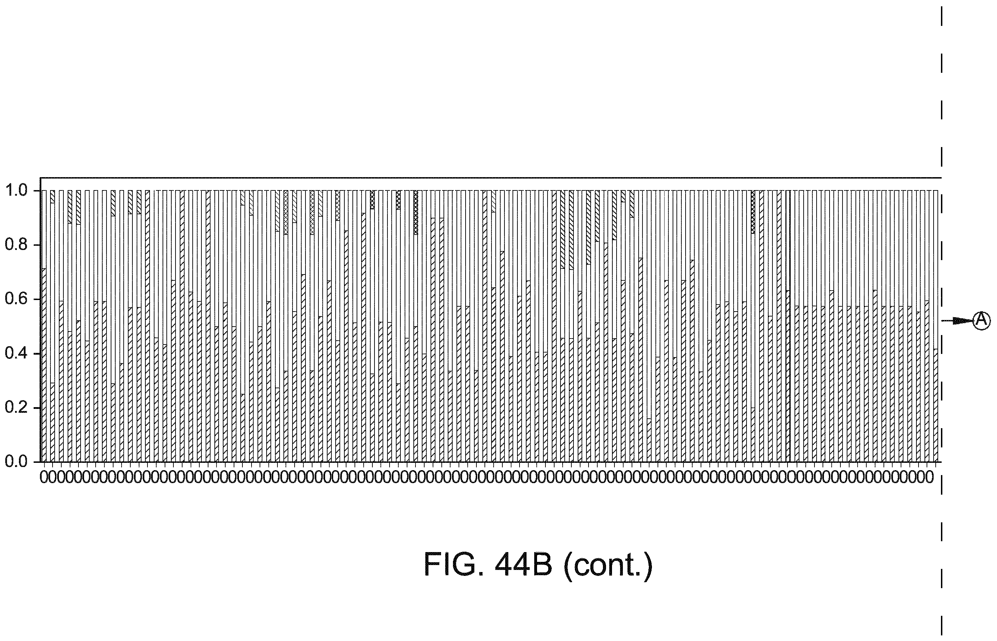

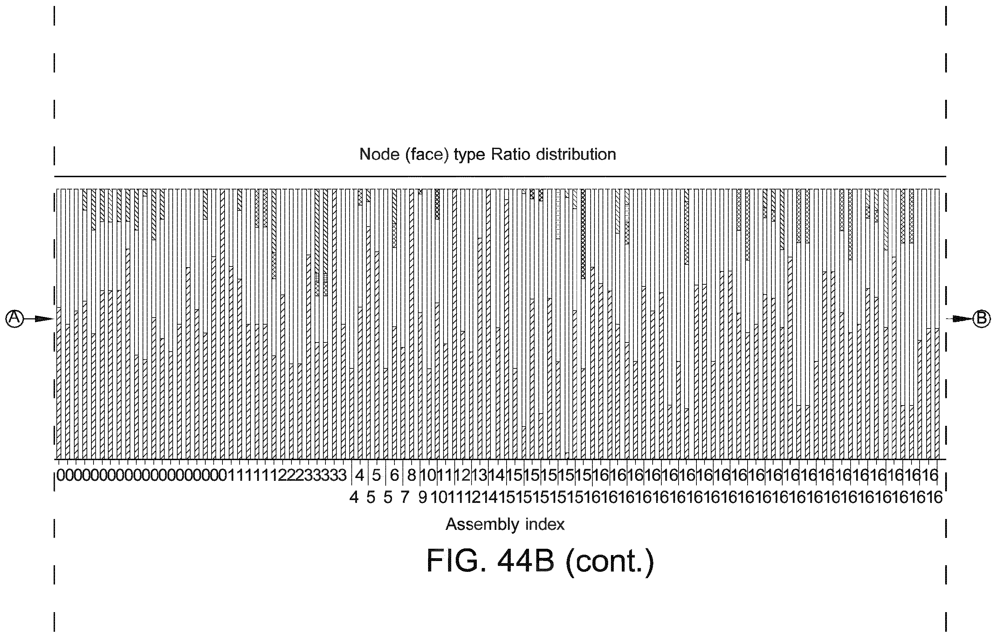

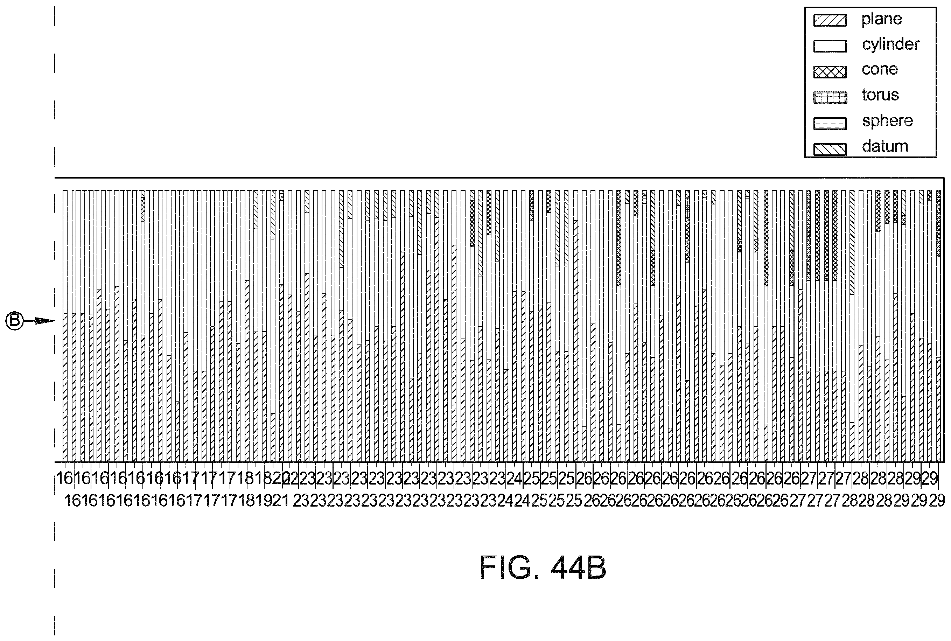

In implementations, the distribution of node types, edge types, and labels of the label list in a training dataset may not be homogenous. In implementations, it may be beneficial to have a diversified dataset (e.g., a dataset comprising many examples of different kinds) to increase the usability of the method. FIGs. 44-46 discussed below, show the distribution of surface types, edge types, and labels in a dataset used for implementing the method.

In implementations, the learning method may comprise separating (e.g., partitioning) the training dataset into two (e.g., disjoint) parts, a first part that may be used to learn the classification function and a second part that may be used to test the classification function. The separating of the training dataset may comprise respecting the different proportions of the different features in the separating of the training dataset.

Notably, the method of use comprises obtaining one or more local CAD-graphs representing a CAD model representing a mechanical assembly of parts. The obtaining may comprise obtaining a CAD model, determining a CAD-graph representing the CAD-model, and determining the one or more local CAD-graphs from the CAD-graph representing the CAD model. The obtaining of the one or more local CAD-graphs and/or the determining of the CAD-graph may be implemented with the above-described steps (e.g., described in reference to the determining of (local) CAD-graph to be included in a training dataset). Specifically, the determining of the (one or more local) CAD-graph may comprise determining each of the canonical surfaces of the CAD model and all of the connections (internal connections and/or contacts) between the determined canonical surfaces. It is understood that whenever the training dataset includes some additional information attached to each of the CAD-graphs (such as node-vectors, internal-edge-vectors, and/or external-edge-vectors), the method of use may comprise obtaining and/or determining at least part of the additional information, said additional information to be given as input to the classification function (e.g., node-vectors, internal-edge-vectors, and/or external-edge-vectors). The determining may be implemented as described above, e.g., with an extraction step.

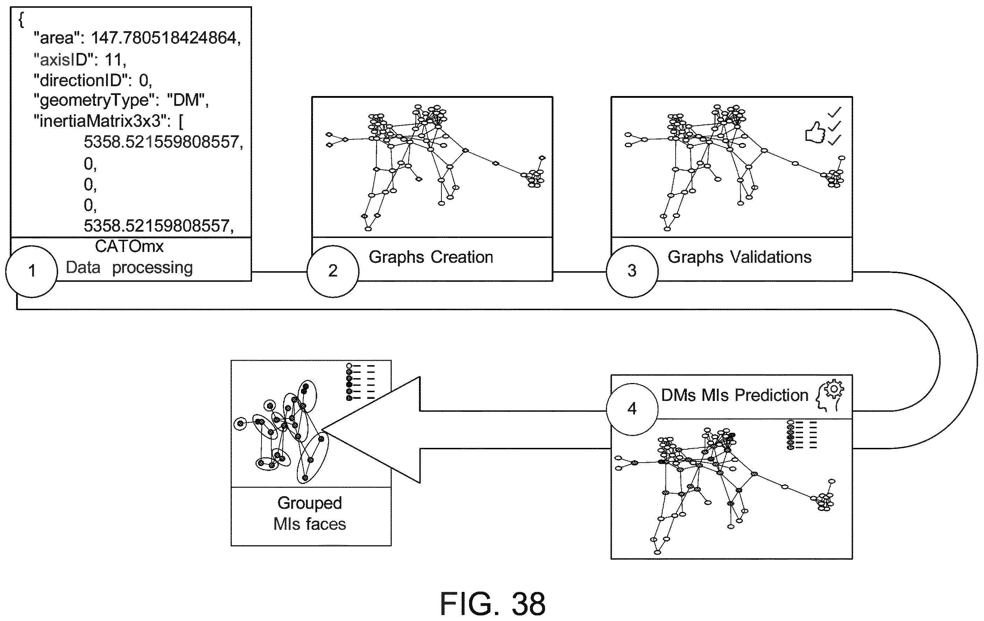

FIG. 38 illustrates a flowchart of the method of use, including creating and validating a CAD-graph from a CAD model representing a mechanical assembly of parts, using the classifying function to predict the labels of each of the node, and determining the mechanical interfaces from the labeled nodes.

The classification function may be based on (e.g., include) a graph neural network (GNN). A GNN is a type of neural network specifically designed to work with data structured as graphs. GNNs are powerful tools for analyzing data with complex interconnections, such as the types of connection (e.g., internal connections and/or contacts) between the canonical surfaces of a CAD model representing a mechanical assembly of parts. GNNs perform neighborhood aggregation, updating node features by aggregating information from direct neighbors at each graph layer. This allows for information sharing as well as the capture of local context.

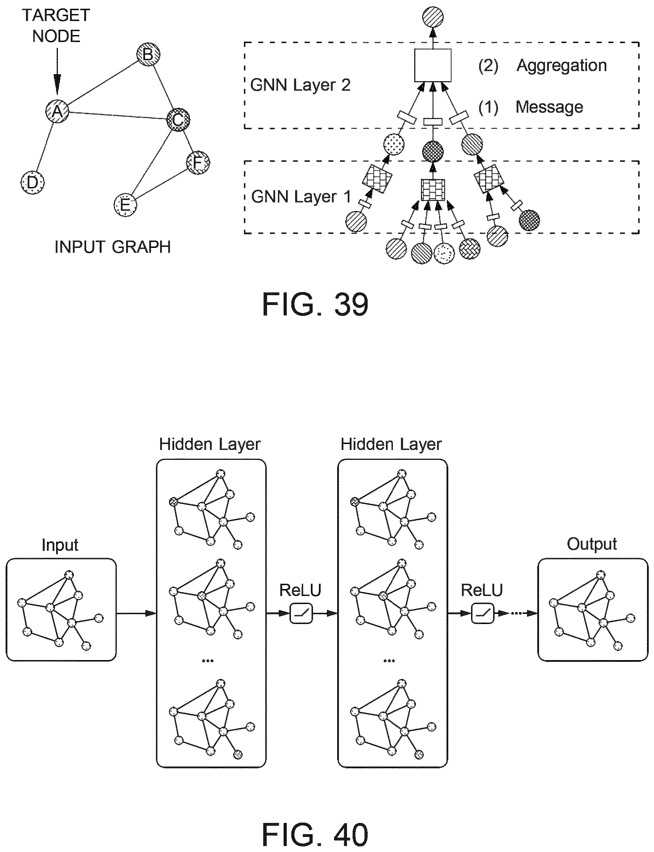

FIG. 39 illustrates the key mechanism of "message passing" of a GNN.

FIG. 40 illustrates an example of a model of a GNN that may be used in a classification function, comprising ReLU activation functions.

In implementations, the classification function may further include multi-layer perceptron (MLP) neural networks (e.g., a MLP before a GNN and a MLP after a GNN). The MLP may be used to augment the node features. Augmenting the node feature may enable the model to tackle more complicated situations by increasing the expressivity of the model.

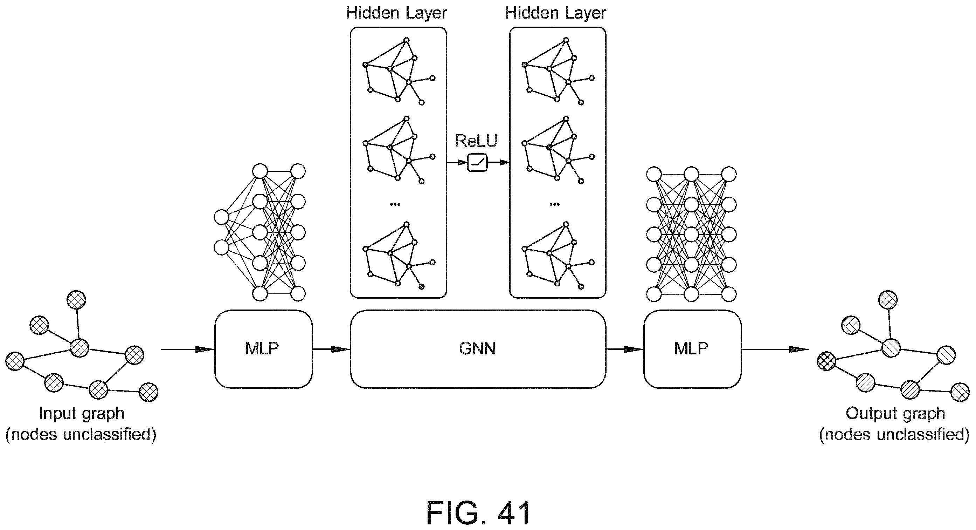

FIG. 41 illustrates an implementation of a classification function, consisting of a feed-forward architecture consisting of three main blocks: a MLP for feature augmentation, a GNN for node representation learning, and another MLP for classification.

The training of the classification function may include using a loss function. The loss function may be, e.g., the cross-entropy loss function. In implementations, the cross-entropy loss may be weighted based on different classes so as to compensate for the imbalance of class distribution. Specifically, the samples from the minority class may be associated with a larger weight, while the samples from the majority class may receive smaller weights. In implementations, the loss function may be defined by the formula: ${l}_{n} = - {w}_{{y}_{n}} log \frac{exp \left({x}_{n , {y}_{n}}\right)}{{\sum }_{c = 1}^{C} exp \left({x}_{n , c}\right)}$ where *n* is the sample, *xₙ* is the output vector of the classification function for the sample *n, yₙ* is the ground truth label of the sample *n, C* is the number of all classes, *x_{n,yₙ}* is the output of the classification function for the class *yₙ*, *x_{n,c}* is the output of the classification function for the class c, and *w_{yₙ}* is the weight associated with the class *yₙ*.

In implementations, the learning method and/or the method of use may comprise displaying a graphical representation, e.g., on a display. The graphical representation may comprise illustrations of one or more of the above-described steps. The graphical representation may illustrate a 3D assembly. For example, a CAD model representing a mechanical assembly of parts may be shown in the graphical representation including some of its features (e.g., contained in a node-vector and/or edge vector). Some of the features may comprise radius and/or material orientation. The user may interact with the graphical representation to execute the method (e.g., determining the classification of each of the canonical surfaces and/or determining the mechanical interfaces). The graphical representation may comprise a CAD-graph of the CAD model or one or more local CAD-graphs.

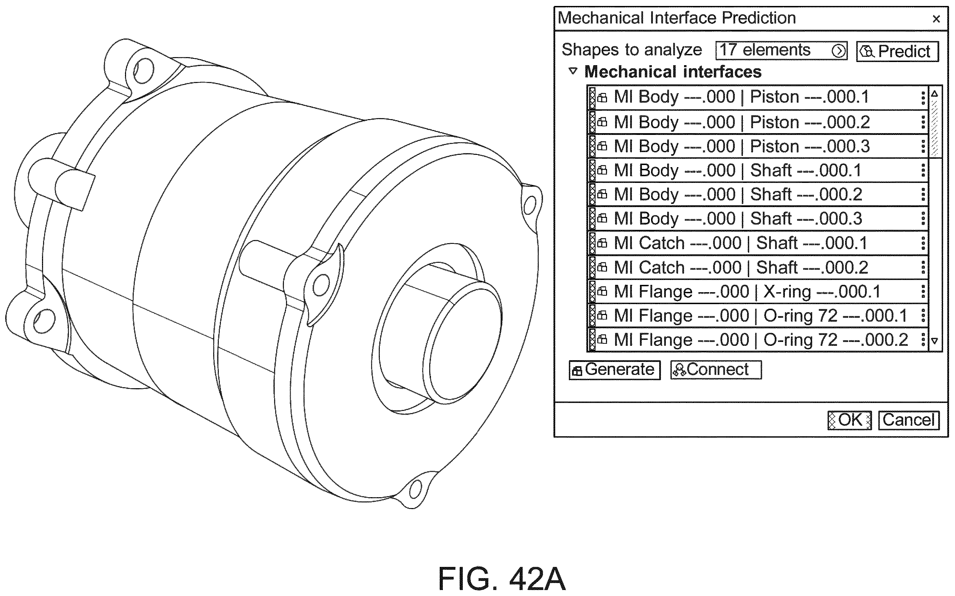

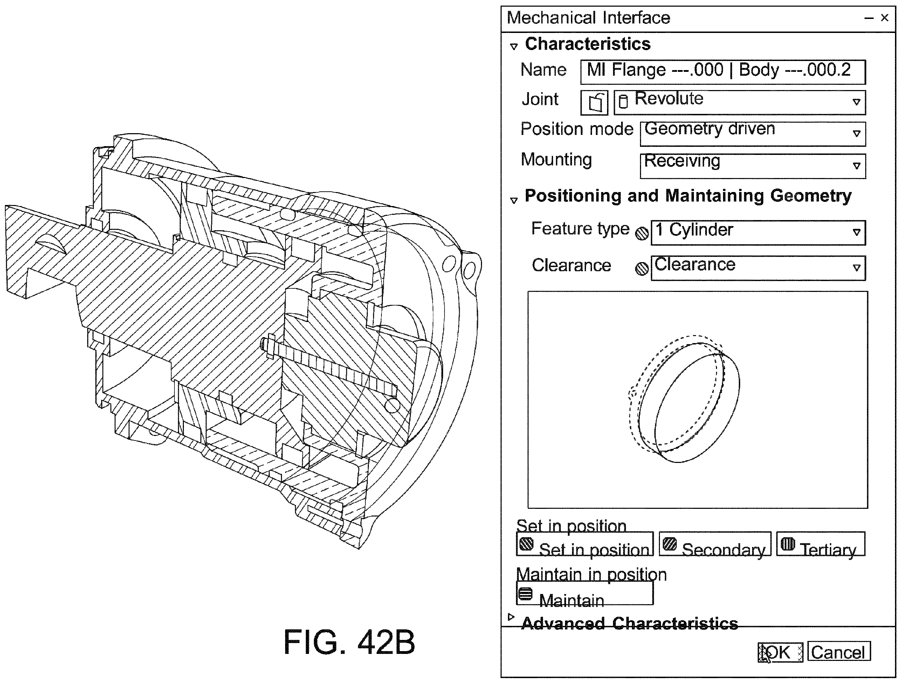

FIGs. 42A and 42B illustrate an implementation of the method, wherein a CAD model is shown in a graphical interface.

The learning method was implemented, and the classification function was tested on a dataset. The training dataset in the implementation was obtained from a CAD-dataset. The CAD-dataset consisted in 30 assemblies of mechanical parts, such as the assemblies shown in FIG. 4, for a total of over 5800 mechanical interfaces.

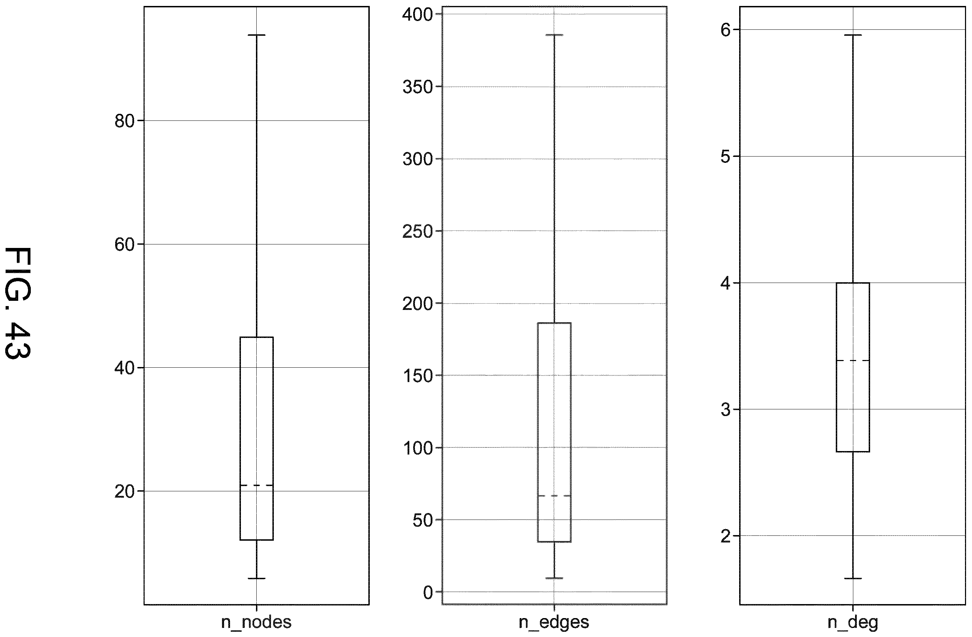

FIG. 43 illustrate boxplots detailing statistics for the number of nodes, edges, and degrees of the local graphs in the implemented training dataset. The median value of the number of nodes of each local graph in the implemented training dataset is 21. The median value of the number of edges of each local graph in the implemented training dataset is 66. The median value of the node degree of each local graph in the implemented training dataset is 4. Therefore, the local graphs are relatively small in size with a moderate level of connectivity. This may imply a better performance of the methods.

FIGs. 44A and 44B show a distribution chart of the types of canonical surfaces included in the CAD models in the implemented CAD-dataset. The distribution chart of FIG. 44A indicates that 54.2% of the canonical surfaces are planes 441, 38.5% of the canonical surfaces are cylinders 442, 2.1% of the canonical surfaces are cones 443, and 5.0% of the canonical surfaces are datum 444.

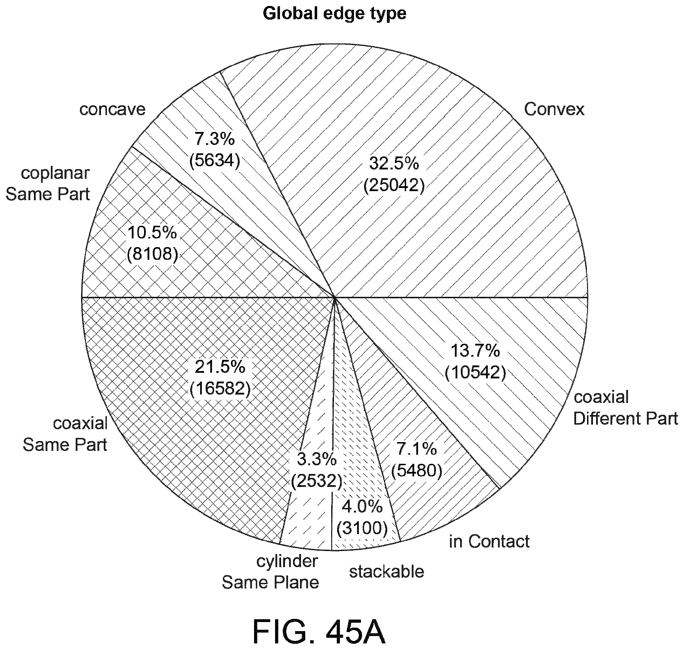

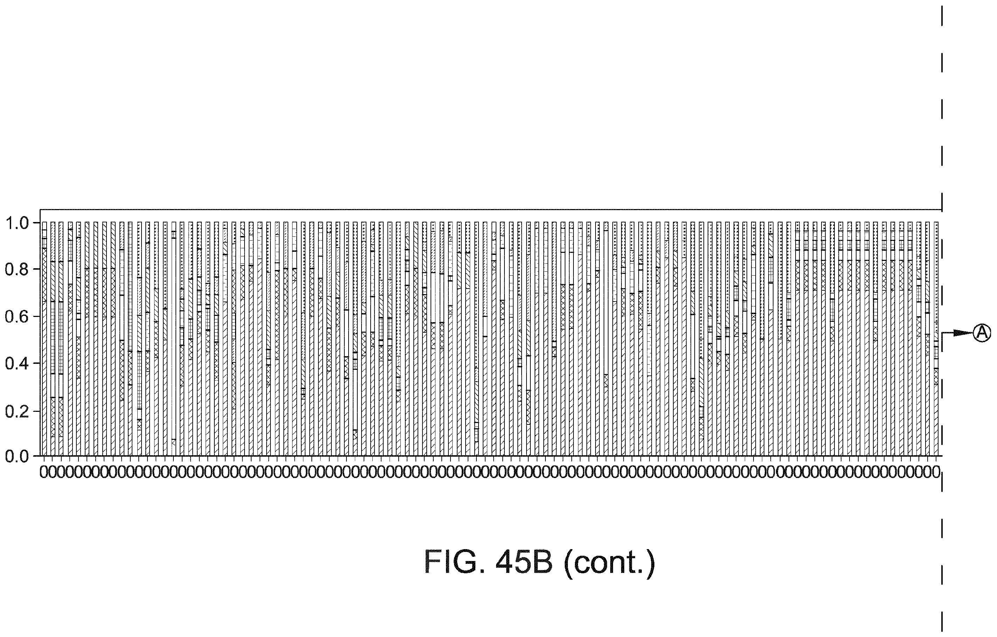

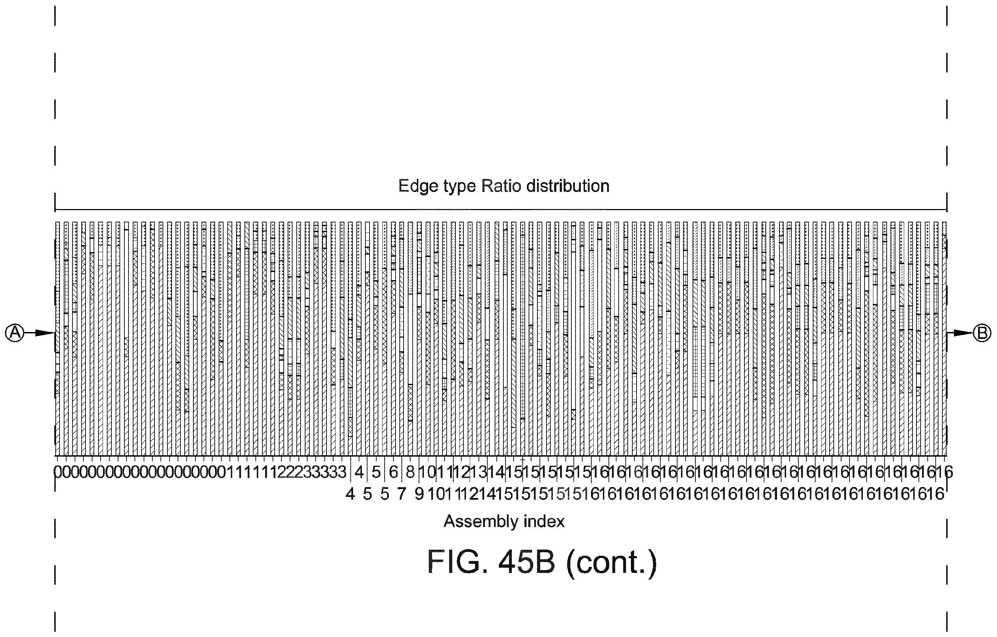

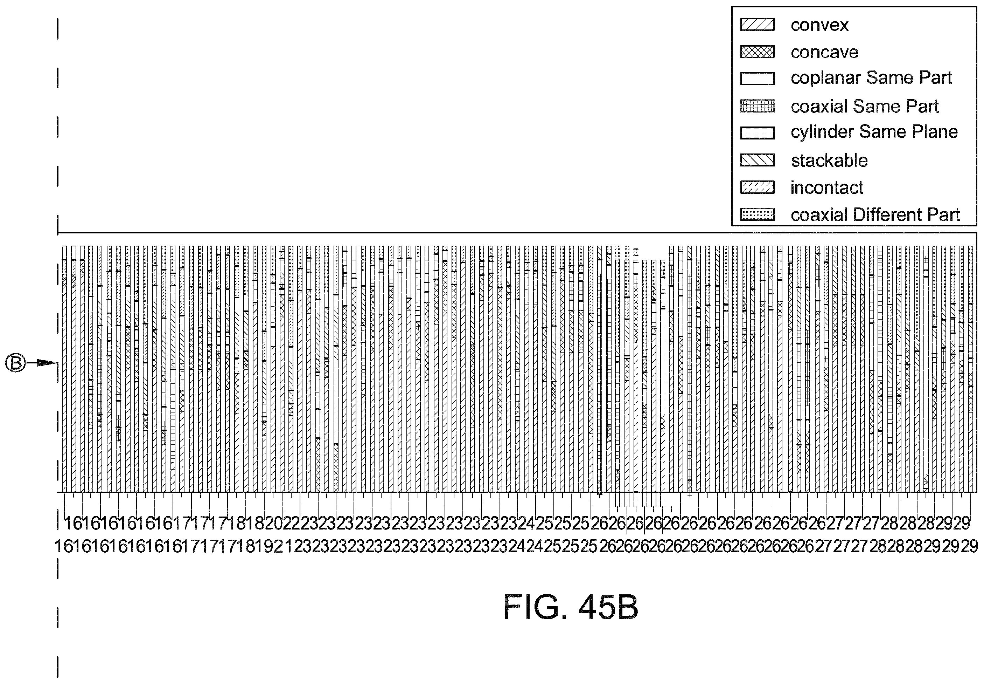

FIGs. 45A and 45B show a distribution chart of the edge type (i.e., internal connection and contact) of the CAD models in the implemented CAD-dataset. The distribution chart of FIG. 45A indicates that 32.5% of the edge types are convex, 21.5% of the edge type are coaxial and internal, and the other edge types are between 7% and 13%.

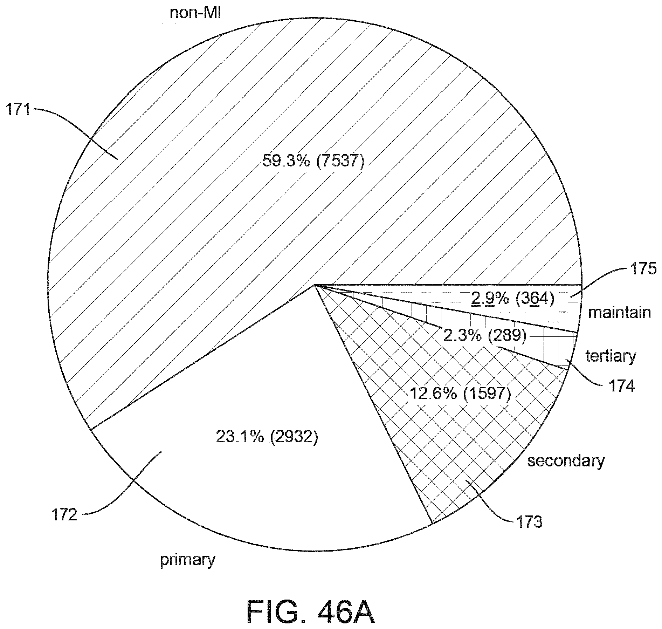

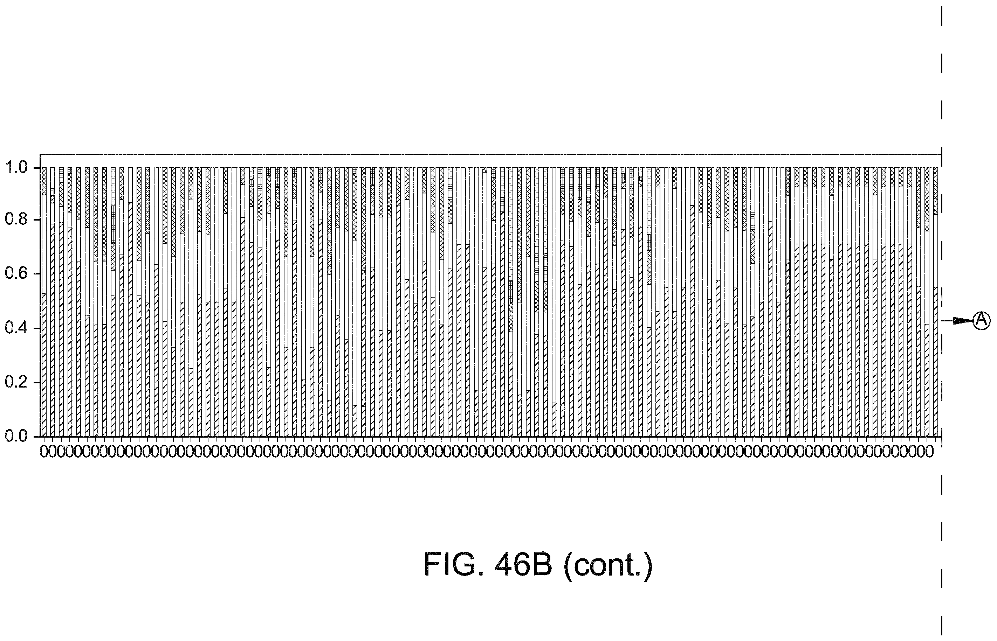

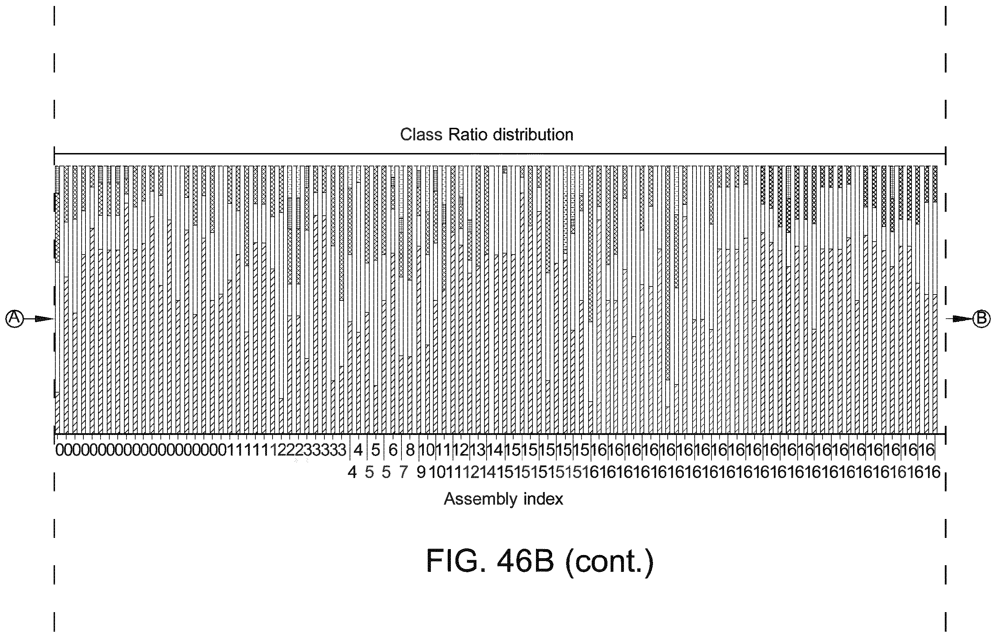

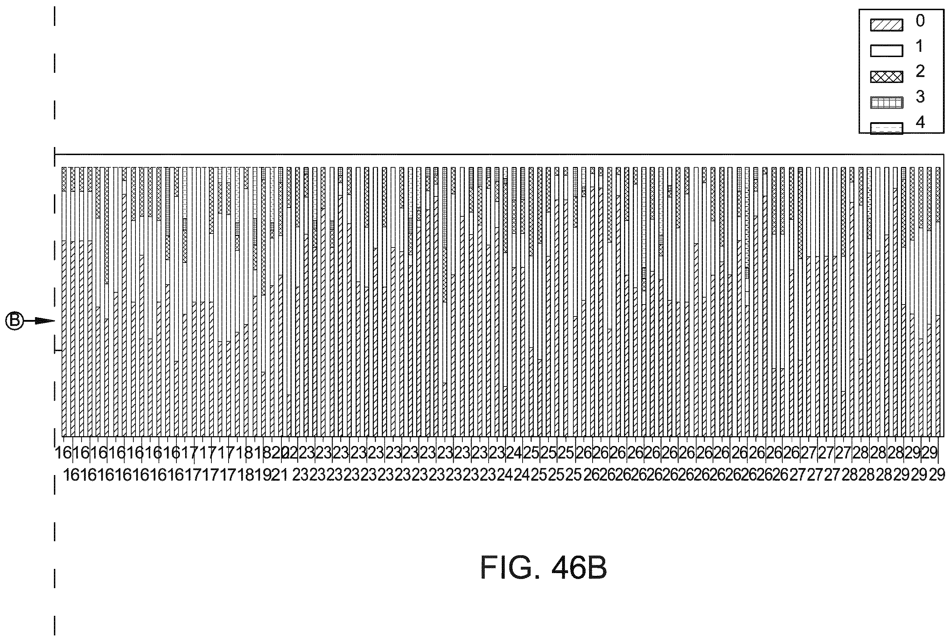

FIGs. 46A and 46B show a distribution chart of the label of the canonical surfaces included in the CAD models in the implemented CAD-dataset. The distribution chart of FIG. 46A indicates that 59.3% of the canonical surfaces are no interface 461, 23.1% of the canonical surfaces are primary faces 462, 12.6% of the canonical surfaces are secondary faces 463, 2.3% of the canonical surfaces are tertiary faces 464, and 2.9% of the canonical surfaces are maintain faces 465. The proportion of no interface faces was greatly reduced in the training dataset comprising the local graphs. The training dataset is therefore more balanced with respect to the proportion of interface faces and no interface faces, ensuring a better training of the classification function.

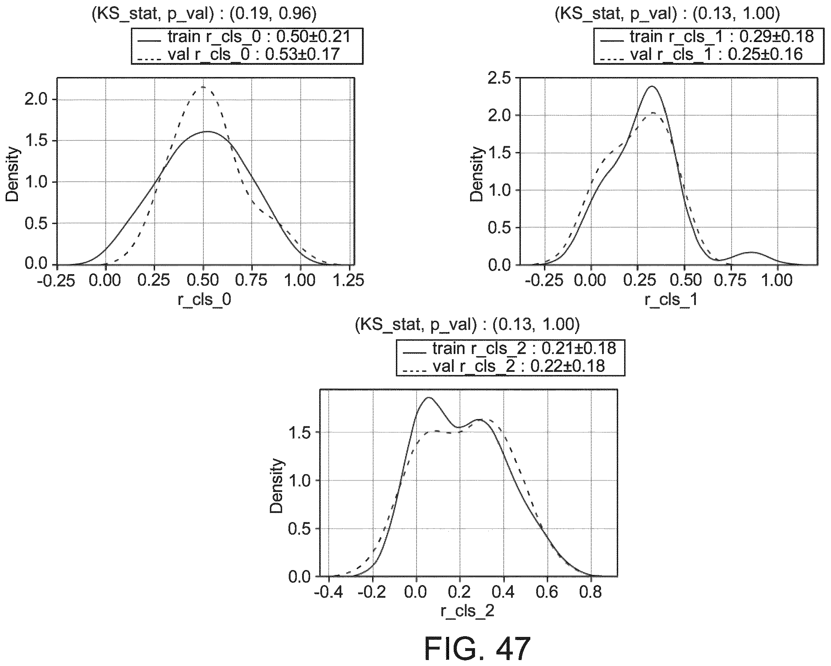

FIG. 47 shows a distribution of three classes in the training and testing dataset used in the implementation, showing that the proportion of the features are the same during training and testing.

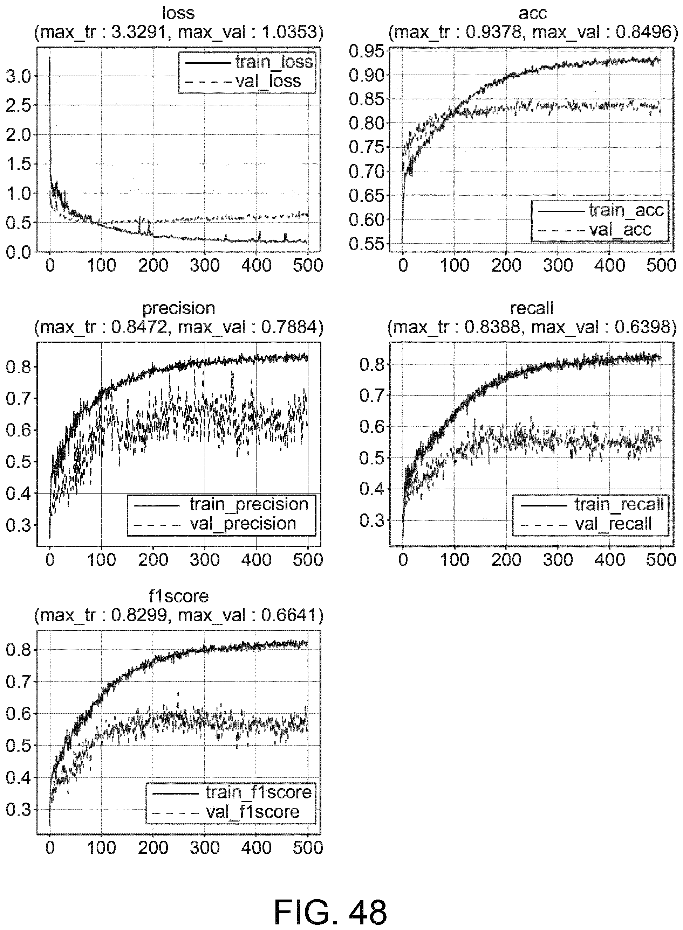

FIG. 48 shows the evolution of loss and metrics during the training of the classification function. In the implementation, the learning rate was 5e-4, the optimizer used was ADAM, and the batch size was 32.

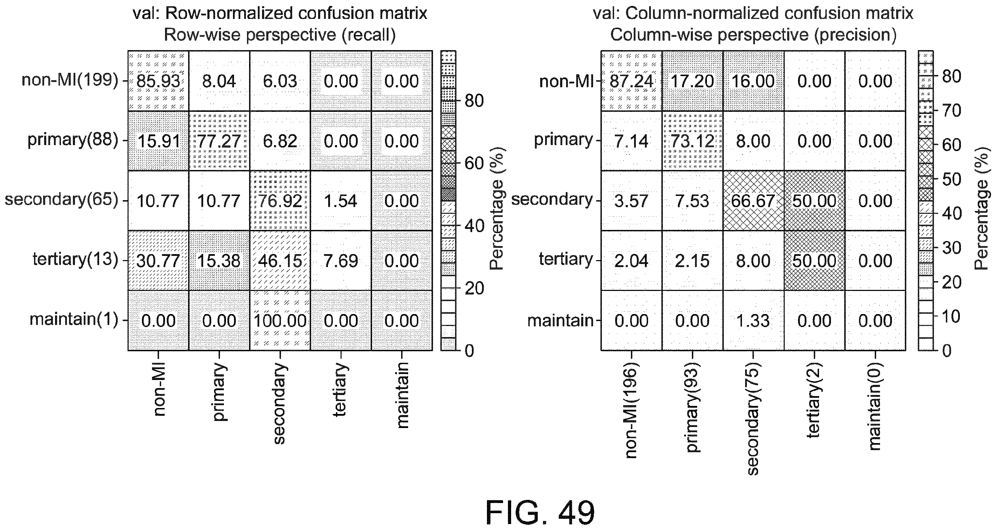

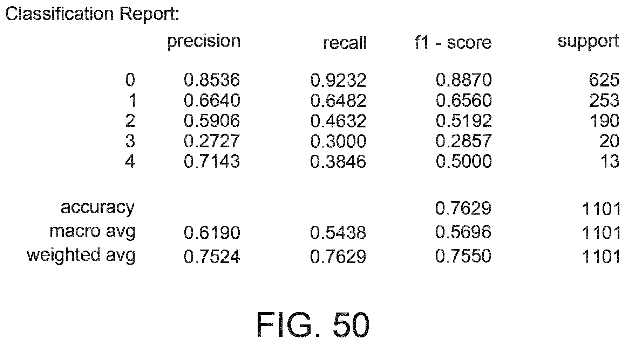

FIGs. 49-50 show the confusion matrix and the classification report of the result of the training of the classification function in the implementation. The confusion matrix of FIG. 49 shows that non interface, primary, and secondary faces are well predicted with an accuracy of over 76%.

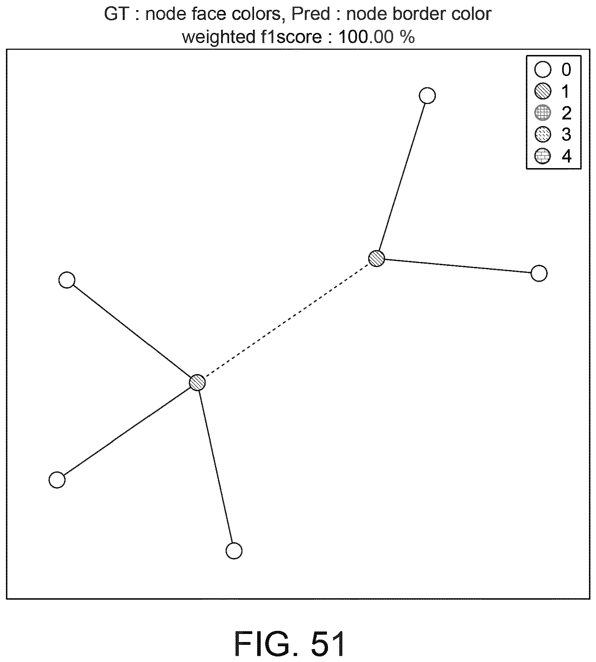

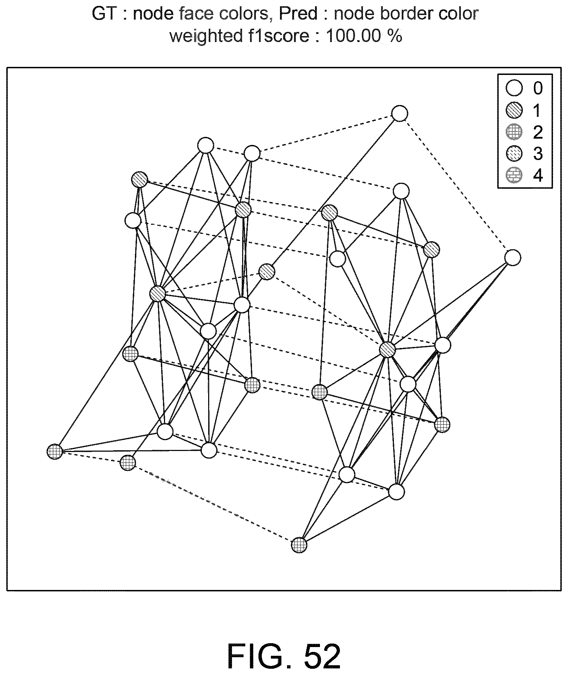

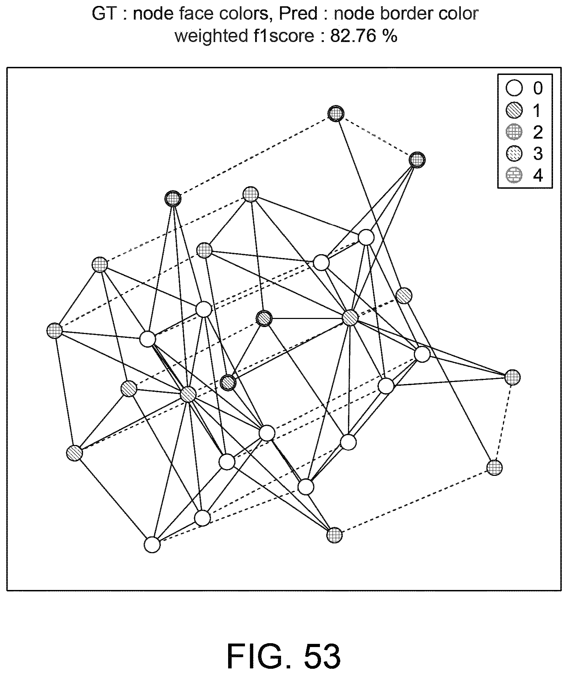

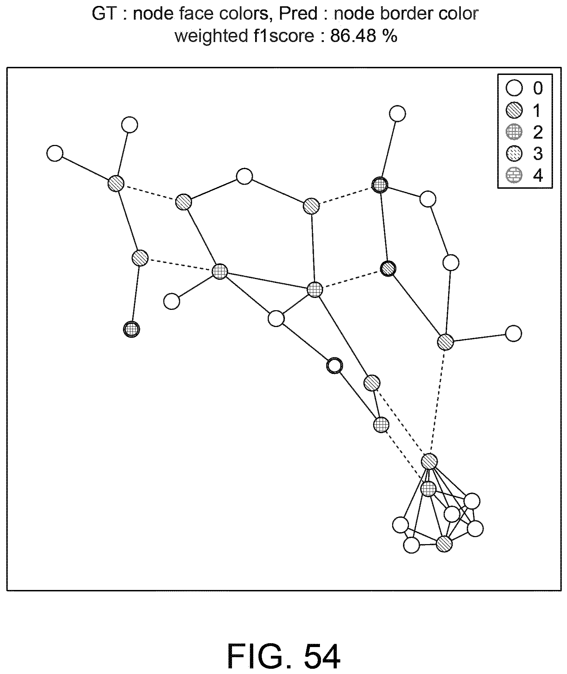

FIGs. 51-54 show the results of the implemented classification function applied to different local CAD-graphs. As in FIGs. 1, 2A, 2B, and 2C, the hatching associated with the label "0" corresponds to canonical surfaces that are no interface. The hatching associated with the label "1" corresponds to canonical surfaces that are primary faces. The hatching associated with the label "2" corresponds to canonical surfaces that are secondary faces. The hatching associated with the label "3" corresponds to canonical surfaces that are tertiary faces. The hatching associated with the label "4" corresponds to canonical surfaces that are maintain faces. The nodes that have only one kind of hatching are the nodes correctly assessed by the implemented classification function (that is, the predicted classification corresponds to the ground truth, e.g., given by an expert). The nodes that have a border hatching different from the central hatching are the nodes that are wrongly classified by the classification function, with the central hatching being the ground truth (e.g., the labels given by experts) classification and the border hatching the inferred classification. The dashed edges correspond to the external edges.

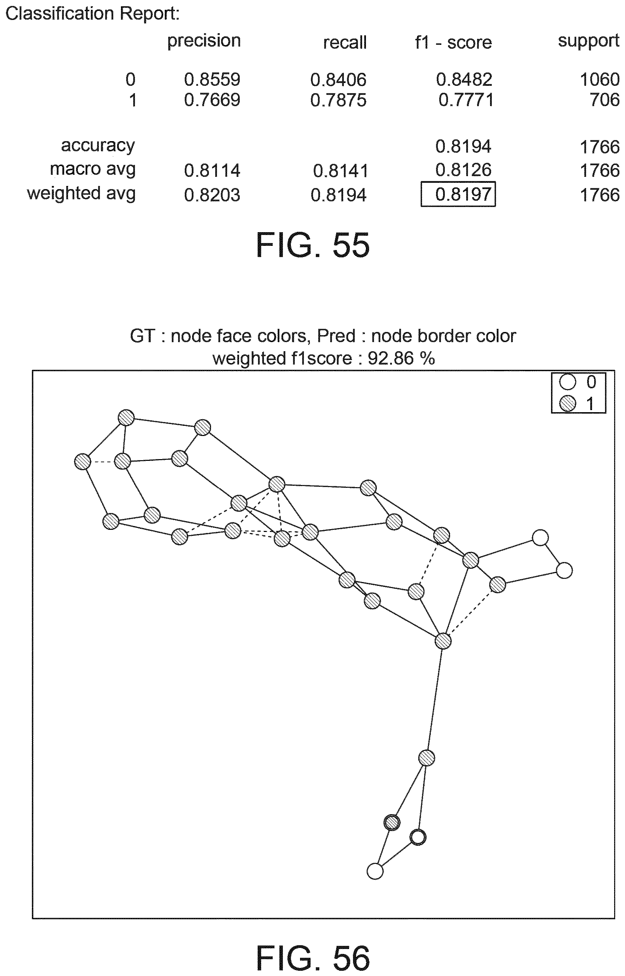

FIG. 55 shows the classification report of the result of the training of the classification function only taking into account whether each node is an interface or a no interface node.

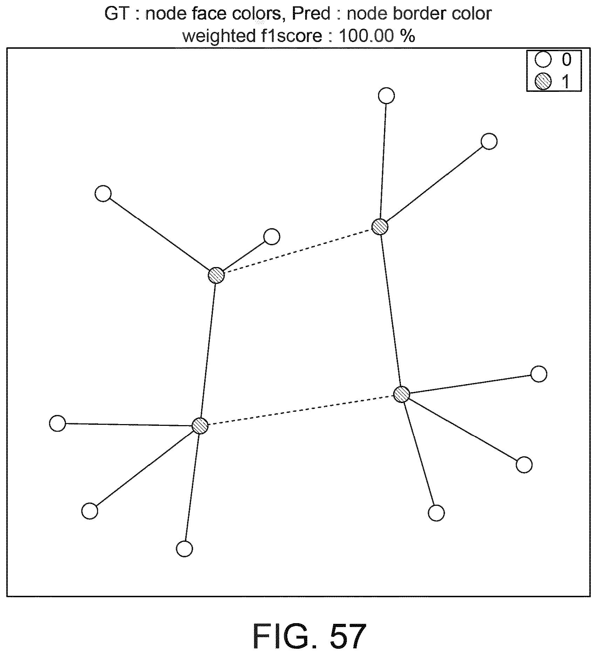

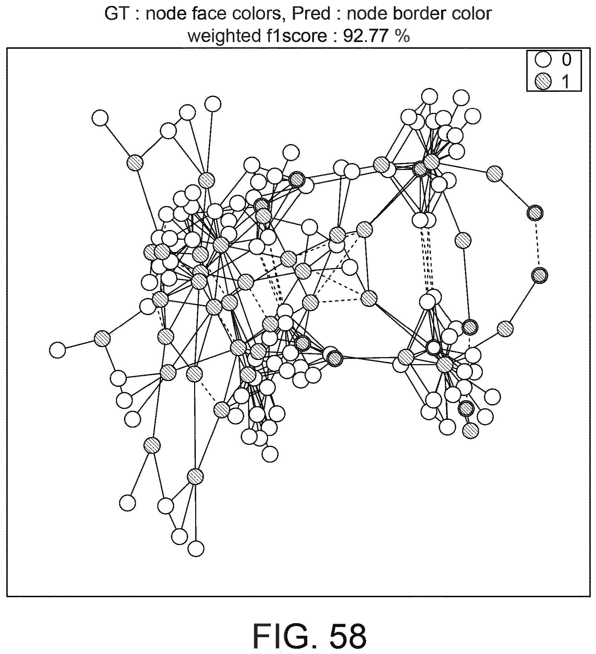

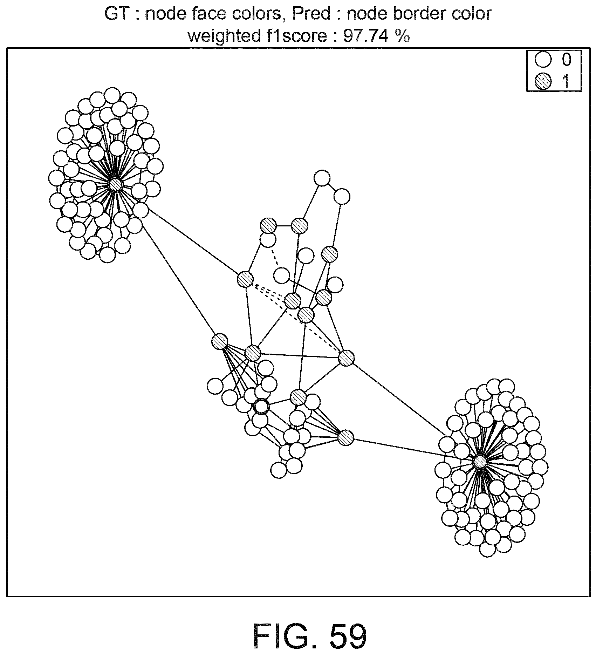

FIGs. 56-59 show the results of the implemented classification function applied to different local CAD-graphs, only taking into account whether each node is an interface or a no interface node. In these figures, the hatching associated with the label "0" corresponds to canonical surfaces that are no interface. The hatching associated with the label "1" corresponds to canonical surfaces that are interface faces. As in FIGs. 51-54, the nodes that have only one kind of hatching are the nodes correctly assessed by the implemented classification function, whereas the nodes that have a border hatching different from the central hatching are the nodes that are wrongly classified by the classification function. The dashed edges correspond to the external edges.

The methods and implementations presented in the present disclosure may be combined in any possible ways unless explicitly stated otherwise. In particular, any of the methods described herein may comprise any of the steps described in relation to any of the described methods and/or implementations of the present disclosure.

"Designing a manufacturing product/mechanical part/mechanical product" designates any action or series of actions which is at least a part of a process of elaborating a modeled object (3D or 2D) of the manufacturing product/mechanical part/mechanical product. The method may form such a process or may form at least a part of the process as described above.

The method thus generally manipulates modeled objects, such as CAD model outputted by the method. A modeled object is any object defined by data stored e.g. in the database. By extension, the expression "modeled object" designates the data itself. According to the type of the system, the modeled objects may be defined by different kinds of data. The system may indeed be any combination of a CAD system and a CAM system. In those different systems, modeled objects are defined by corresponding data. One may accordingly speak of CAD object, CAM object, CAD data, and CAM data. However, these systems are not exclusive one of the other, as a modeled object may be defined by data corresponding to any combination of these systems. A system may thus well be both a CAD and/or CAM system, as will be apparent from the definitions of such systems provided below.

By CAD solution (*e*.*g*. a CAD system or a CAD software), it is additionally meant any system, software or hardware, adapted at least for designing a modeled object on the basis of a graphical representation of the modeled object and/or on a structured representation thereof (*e*.*g*. a feature tree), such as CATIA. In this case, the data defining a modeled object comprise data allowing the representation of the modeled object. A CAD system may for example provide a representation of CAD modeled objects using edges or lines, in certain cases with faces or surfaces. Lines, edges, or surfaces may be represented in various manners, e.g. non-uniform rational B-splines (NURBS). Specifically, a CAD file contains specifications, from which geometry may be generated, which in turn allows for a representation to be generated. Specifications of a modeled object may be stored in a single CAD file or multiple ones. The typical size of a file representing a modeled object in a CAD system is in the range of one Megabyte per part. And a modeled object may typically be an assembly of thousands of parts. The specifications (also referred to as "CAD specifications") of a CAD model may be stored in a CAD file as explained above, but may also be stored as distributed CAD data on one or more storage, i.e. on a cloud environment.

In the context of CAD, a modeled object may typically be a 2D or 3D modeled object, e.g. representing a product such as a part or an assembly of parts, or possibly an assembly of products. The 2D or 3D modeled object may be a manufacturing product, *i*.*e*. a product to be manufactured. By "3D modeled object", it is meant any object which is modeled by data allowing its 3D representation. A 3D representation allows the viewing of the part from all angles. For example, a 3D modeled object, when 3D represented, may be handled and turned around any of its axes, or around any axis in the screen on which the representation is displayed. This notably excludes 2D icons, which are not 3D modeled. The display of a 3D representation facilitates design (i.e. increases the speed at which designers statistically accomplish their task). This speeds up the manufacturing process in the industry, as the design of the products is part of the manufacturing process.

The 3D modeled object may represent the geometry of a product to be manufactured in the real world subsequent to the completion of its virtual design with for instance a CAD/CAE software solution or CAD/CAE system, such as a (e.g. mechanical) part or assembly of parts (or equivalently an assembly of parts, as the assembly of parts may be seen as a part itself from the point of view of the method, or the method may be applied independently to each part of the assembly), or more generally any rigid body assembly (e.g. a mobile mechanism). A CAD/CAE software solution allows the design of products in various and unlimited industrial fields, including: aerospace, architecture, construction, consumer goods, high-tech devices, industrial equipment, transportation, marine, and/or offshore oil/gas production or transportation. The 3D modeled object designed by the method may thus represent an industrial product which may be any mechanical part, such as a part of a terrestrial vehicle (including e.g. car and light truck equipment, racing cars, motorcycles, truck and motor equipment, trucks and buses, trains), a part of an aerial vehicle (including e.g. airframe equipment, aerospace equipment, propulsion equipment, defense products, airline equipment, space equipment), a part of a naval vehicle (including e.g. navy equipment, commercial ships, offshore equipment, yachts and workboats, marine equipment), a general mechanical part (including e.g. industrial manufacturing machinery, heavy mobile machinery or equipment, installed equipment, industrial equipment product, fabricated metal product, tire manufacturing product), an electro-mechanical or electronic part (including e.g. consumer electronics, security and/or control and/or instrumentation products, computing and communication equipment, semiconductors, medical devices and equipment), a consumer good (including e.g. furniture, home and garden products, leisure goods, fashion products, hard goods retailers' products, soft goods retailers' products), a packaging (including e.g. food and beverage and tobacco, beauty and personal care, household product packaging).

A CAD system may be history-based. In this case, a modeled object is further defined by data comprising a history of geometrical features. A modeled object may indeed be designed by a physical person (i.e. the designer/user) using standard modeling features (e.g. extrude, revolute, cut, and/or round) and/or standard surfacing features (e.g. sweep, blend, loft, fill, deform, and/or smoothing). Many CAD systems supporting such modeling functions are history-based system. This means that the creation history of design features is typically saved through an acyclic data flow linking the said geometrical features together through input and output links. The history based modeling paradigm is well known since the beginning of the 80's. A modeled object is described by two persistent data representations: history and B-rep (i.e. boundary representation). The B-rep is the result of the computations defined in the history. The shape of the part displayed on the screen of the computer when the modeled object is represented is (e.g. a tessellation of) the B-rep. The history of the part is the design intent. Basically, the history gathers the information on the operations which the modeled object has undergone. The B-rep may be saved together with the history, to make it easier to display complex parts. The history may be saved together with the B-rep in order to allow design changes of the part according to the design intent.

By CAM solution, it is meant any solution, software of hardware, adapted for managing the manufacturing data of a product. The manufacturing data generally include data related to the product to manufacture, the manufacturing process and the required resources. A CAM solution is used to plan and optimize the whole manufacturing process of a product. For instance, it may provide the CAM users with information on the feasibility, the duration of a manufacturing process or the number of resources, such as specific robots, that may be used at a specific step of the manufacturing process; and thus allowing decision on management or required investment. CAM is a subsequent process after a CAD process and potential CAE process. For example, a CAM solution may provide the information regarding machining parameters, or molding parameters coherent with a provided extrusion feature in a CAD model. Such CAM solutions are provided by Dassault Systèmes under the trademarks CATIA, Solidworks or trademark DELMIA^{®}.

CAD and CAM solutions are therefore tightly related. Indeed, a CAD solution focuses on the design of a product or part and CAM solution focuses on how to make it. Designing a CAD model is a first step towards a computer-aided manufacturing. Indeed, CAD solutions provide key functionalities, such as feature based modeling and boundary representation (B-Rep), to reduce the risk of errors and the loss of precision during the manufacturing process handled with a CAM solution. Indeed, a CAD model is intended to be manufactured. Therefore, it is a virtual twin, also called digital twin, of an object to be manufactured with two objectives:
- checking the correct behavior of the object to be manufactured in a specific environment; and
- ensuring the manufacturability of the object to be manufactured.

The modeled object outputted/designed/taken as input by the method may be a 2D/3D discrete geometrical representation of a manufacturing product/mechanical product/mechanical part The discrete geometrical representation is a data structure which comprises a discrete set of pieces of data. Each piece of data may specify an element of the product/mechanical part, and be referred to as a discrete element. The discrete geometrical representation may be 3D or alternatively 2D. Yet alternatively, the discrete geometrical representation may be both 3D and 2D, *i.e.* may comprise a 3D portion which is a 3D discrete geometrical representation and a 2D portion which is a discrete geometrical representation, such as a hybrid 3D-2D meshing (*e.g.* for modeling a product comprising both thin parts, modeled with the 2D portions, and thick parts, modeled with the 3D portions). The discrete geometrical representation may in examples comprise a number of such pieces of data higher than 100, 1000, or 10000.

The modeled object outputted/designed/processed/taken as input by the method may be a CAD model, for example comprising or consisting in a feature tree and/or a B-rep. Such a model may stem from a CAE model and may results from a CAE to CAD conversion process, that the method may for example comprise at an initial stage.

The CAD model may be feature-based (*e.g.* it may comprise a feature tree, and optionally a corresponding B-rep obtained by executing the feature tree). A feature-based 3D model allows (*e.g.* during the determination of a manufacturing file or CAM file or CAM specifications stored as distributed data as discussed hereinafter) the detection and an automatic resolution of a geometry error in a CAD model such as a clash that will affect the manufacturing process. A clash is an interpenetration between two parts of a 3D model for example due to their relative motion. Furthermore, this clash may sometimes only be detected via a finite element analysis based on the CAD feature-based model. Therefore, a resolution of a clash can be performed with or automatically by the CAD solution by iteratively modifying the parameters of the features and doing a finite element analysis.

As another example, a feature-based 3D model allows (*e.g.* during the determination of a manufacturing file or CAM file or CAM specification stored as distributed data as discussed hereinafter) an automatic creation of a tool path for a machine via a computer numerical control (CNC). With CNC, each object to be manufactured gets a custom computer program, stored in and executed by the machine control unit, a microcomputer attached to the machine. The program contains the instructions and parameters the machine tool will follow. Mills, lathes, routers, grinders and lasers are examples of common machine tools whose operations can be automated with CNC.

A key characteristic of a CAD model is that it may be designed exactly and unambiguously by chaining a small number of high-level parameterized design operations (including for example, but not limited to, sketch, extrusion, chamfer) and edited by modifying its high-level parameters. That this is a key distinction with the polyhedral representations such as a triangular surface mesh which may represent any 3D shape but do not provide modification or parameterization capabilities required in an industrial design context.

As CAD model is a parameterized model of a part/product, it is lighter in terms of memory footprint than other models such as a CAE model. Indeed, instead of storing a collection of discrete geometrical elements such as finite elements, a CAD model allows the storing of a list of features and parameters, which is lighter in terms of storage and memory footprint. Working on CAD models thus reduced memory requirements for the underlying systems, as compared for example to CAE models, in addition to facilitate editability of the model. This amounts to say that a CAE to CAD conversion process in fact compresses the CAE model into a CAD model which is lighter in terms of memory requirementsi (*e.g.* footprint), in addition to transforming the CAE model into a more easily editable CAD model.

The generation of a custom computer program from CAD files or distributed CAD specifications may be automated. Such generation may therefore be errorproof and may ensure a perfect reproduction of the CAD model to a manufactured product. CNC is considered to provide more precision, complexity and repeatability than is possible with manual machining. Other benefits include greater accuracy, speed and flexibility, as well as capabilities such as contour machining, which allows milling of contoured shapes, including those produced in 3D designs.

The B-rep (i.e. boundary representation) is a 3D representation of a mechanical part. Specifically, the B-rep is a persistent data representation describing the 3D modeled object representing the mechanical part. The B-rep may be the result of computations and/or a series of operations carried out during a designing phase of the 3D modeled object representing the mechanical part. The shape of the mechanical part displayed on the screen of the computer when the modeled object is represented is (e.g. a tessellation of) the B-rep. In examples, the B-rep represents a part of the model object.

A B-Rep includes topological entities and geometrical entities. Topological entities are: face, edge, and vertex. Geometrical entities are 3D objects: surface, plane, curve, line, point. By definition, a face is a bounded portion of a surface, named the supporting surface. An edge is a bounded portion of a curve, named the supporting curve. A vertex is a point in 3D space. They are related to each other as follows. The bounded portion of a curve is defined by two points (the vertices) lying on the curve. The bounded portion of a surface is defined by its boundary, this boundary being a set of edges lying on the surface. The boundary of the edges of the face are connected by sharing vertices. Faces are connected by sharing edges. Two faces are adjacent if they share an edge. Similarly, two edges are adjacent if they share a vertex. In the CAD system, the B-Rep gathers in an appropriate data structure the "is bounded by" relationship, the relationship between topological entities and supporting geometries, and mathematical descriptions of supporting geometries. An internal edge of a B-Rep is an edge shared by exactly two faces. By definition, a boundary edge is not shared, it bounds only one face. By definition, a boundary face is bounded by at least one boundary edge. A B-Rep is said to be closed if all its edges are internal edges. A B-Rep is said to be open is it includes at least one boundary edge. A closed B-Rep is used to model a thick 3D volume because it defines the inside portion of space (virtually) enclosing material. An open B-Rep is used to model a 3D skin, which represents a 3D object the thickness of which is sufficiently small to be ignored.

A key advantage of the B-Rep over any other representation types used in CAD modeling is its ability to represent arbitrary shapes exactly. All other representations in use, such as point clouds, distance fields and meshes, perform an approximation of the shape to represent by discretization. The B-Rep, on the other hand, contains surface equations that represent the exact design and therefore constitutes a true "master model" for further manufacturing, whether this be generation of toolpaths for CNC, or discretizing into the correct sample density for a given 3D Printer technology. In other words, by using a B-Rep, the 3D model may be an exact representation of the manufactured object. The B-Rep is also advantageous for simulating the behavior of a 3D model. In terms of stress, thermal, electromagnetic or other analysis, it supports local refinement of the simulation meshes to capture physical phenomena, and for kinematics it supports true contact modeling between curved surfaces. Finally, a B-Rep allows a small memory and/or file footprint. First, because the representation contains surfaces based only on parameters. In other representations such as meshes, the equivalent surface comprises up to thousands of triangles. Second, because a B-Rep doesn't contain any history-based information.

The method may be included in a production process, which may comprise, after performing the method, producing a physical product corresponding to the modeled object designed/processed/outputted by the method. The production process may comprise the following steps:
- (*e.g*. automatically) applying the method, thereby obtaining the CAD model;
- using the obtained CAD model for manufacturing the part/product.

Using a CAD model for manufacturing designates any real-world action or series of action that is/are involved in/participate to the manufacturing of the product/part represented by the CAD model. Using the CAD model for manufacturing may for example comprise one or more of the following steps:
- editing the obtained CAD model;
- performing simulation(s) based on the CAD model or on a corresponding CAE model (*e.g.* the CAE model from which the CAD model stems, after a CAE to CAD conversion process), such as simulations for validation of mechanical, use and/or manufacturing properties and/or constraints *(e.g.* structural simulations, thermodynamics simulation, aerodynamic simulations);
- editing the CAD model based on the results of the simulation(s);
- optionally (*i.e.* depending on the manufacturing process used, the production of the mechanical product may or may not comprise this step), *(e.g.* automatically) determining a manufacturing specifications/CAM specifications (*e.g.* stored as a manufacturing file/CAM file or as distributed CAM data stored on one or more storage (*e.g.* comprising manufacturing instructions for manufacturing the product represented by the CAD model and/or control instructions for the manufacturing process and/or for commanding the manufacturing process or manufacturing tool(s) thereof)) based on the (*e.g.* edited) CAD model (*e.g.* the control instructions stem from the CAD file or distributed CAD data storing the CAD model and/or specifications of the CAD model), for production/manufacturing of the manufacturing product;
- sending the CAD specifications and/or the manufacturing specifications/CAM specifications to a factory in view of manufacturing the product represented by the CAD model; and/or
- *(e.g.* automatically) producing/manufacturing, based on the determined manufacturing specifications/CAM specifications or on the CAD model, the mechanical product originally represented by the model outputted by the method. This may include feeding (*e.g.* automatically) the manufacturing specifications/CAM specifications and/or the CAD specifications to the machine(s) performing the manufacturing process.

This last step of production/manufacturing may be referred to as the manufacturing step or production step. This step manufactures/fabricates the part/product based on the CAD model and/or the CAM specifications, *e.g.* upon the CAD model and/or CAD specifications being fed to one or more manufacturing machine(s) or computer system(s) controlling the machine(s). The manufacturing step may comprise performing any known manufacturing process or series of manufacturing processes, for example one or more additive manufacturing steps, one or more cutting steps (e.g. laser cutting or plasma cutting steps), one or more stamping steps, one or more forging steps, one or more bending steps, one or more deep drawing steps, one or more molding steps, one or more machining steps (e.g. milling steps) and/or one or more punching steps. Because the design method improves the design of a model (CAE or CAD) representing the part/product, the manufacturing and its productivity are also improved.

Editing the CAD model may comprise, by a user (*i.e.* a designer), performing one or more editions of the CAD model, *e.g.* by using a CAD solution. The modifications of the CAD model may include one or more modifications each of a geometry and/or of a parameter of the CAD model. The modifications may include any modification or series of modifications performed on a feature tree of the model (*e.g.* modification of feature parameters and/or specifications) and/or modifications performed on a displayed representation of the CAD model (*e.g.* a B-rep). The modifications are modifications which maintain the technical functionalities of the part/product, *i.e*. the user performs modifications which may affect the geometry and/or parameters of the model but only with the purpose of making the CAD model technically more compliant with the downstream use and/or manufacturing of the part/product. Such modifications may include any modification or series of modification that make the CAD model technically compliant with specifications of the machine(s) used in the downstream manufacturing process. Such modifications may additionally or alternatively include any modification or series of modification that make the CAD model technically compliant with a further use of the product/part once manufactured, such modification or series of modifications being for example based on results of the simulation(s).

The CAM specifications may comprise a manufacturing set up model obtained from the CAD model. The manufacturing set up may comprise all data required for manufacturing the mechanical product (*e.g.* control instructions for controlling the manufacturing process) so that it has a geometry and/or a distribution of material that corresponds to what is captured by the CAD model, possibly up to manufacturing tolerance errors. Determining the production specifications may comprise applying any CAM (Computer-Aided Manufacturing) or CAD-to-CAM solution for (*e.g.* automatically) determining the production specifications from the CAD model (*e.g.* any automated CAD-to-CAM conversion algorithm). Such CAM or CAD-to-CAM solutions may include one or more of the following software solutions, which enable automatic generation of manufacturing instructions and tool paths for a given manufacturing process based on a CAD model of the product to manufacture:
- Fusion 360,
- FreeCAD,
- CATIA,
- SOLIDWORKS,
- The NC Shop Floor programmer of Dassault Systèmes illustrated on https://my.3dexperience.3ds.com/welcome/fr/compass-world/rootroles/nc-shop-floor-programmer,
- The NC Mill-Turn Machine Programmer of Dassault Systèmes illustrated on https://my.3dexperience.3ds.com/welcome/fr/compass-world/rootroles/nc-mill-turn-machine-programmer, and/or
- The Powder Bed Machine Programmer of Dassault Systèmes illustrated on https://my.3dexperience.3ds.com/welcome/fr/compass-world/rootroles/powder-bed-machine-programmer.

The product/part may be an additive manufacturable part, *i.e.* a part to be manufactured by additive manufacturing (*i.e.* 3D printing). In this case, the production process does not comprise the step of determining the CAM specifications and directly proceeds to the producing/manufacturing step, by directly (*e.g.* and automatically) feeding a 3D printer with the CAD model. 3D printers are configured for, upon being fed with a CAD model representing a mechanical product (*e.g.* and upon launching, by a 3D printer operator, the 3D printing), directly and automatically 3D print the mechanical product in accordance with the CAD model. In other words, the 3D printer receive the CAD model, which is (e.g. automatically) fed to it, reads *(e.g.* automatically) the CAD model, and prints *(e.g.* automatically) the part by adding together material, *e.g.* layer by layer, to reproduce the geometry and/or distribution of material captured by the CAD model. The 3D printer adds the material to thereby reproduce exactly in reality the geometry and/or distribution of material captured by the CAD model, up to the resolution of the 3D printer, and optionally with or without tolerance errors and/or manufacturing corrections. The manufacturing may comprise, *e.g.* by a user *(e.g.* an operator of the 3D printer) or automatically (by the 3D printer or a computer system controlling it), determining such manufacturing corrections and/or tolerance errors, for example by modifying the CAD specifications to match specifications of the 3D printer. The production process may additionally or alternatively comprise determining (*e.g.* automatically by the 3D printer or a computer system controlling it) from the CAD model, a printing direction, for example to minimize overhang volume (as described in European patent No. 3327593, which is incorporated herein by reference), a layer-slicing (i.e., determining thickness of each layer, and layer-wise paths/trajectories and other characteristics for the 3D printer head (e.g., for a laser beam, for example the path, speed, intensity/temperature, and other parameters).

The product/part may alternatively be a machined part (*i.e.* a part manufactured by machining), such as a milled part (*i.e.* a part manufactured by milling). In such a case, the production process may comprise a step of determining the CAM specifications. This step may be carried out automatically, by any suitable CAM solution to automatically obtain a CAM specifications from a CAD model of a machined part. The determination of the CAM specifications may comprise (*e.g.* automatically) checking if the CAD model has any geometric particularity (*e.g.* error or artefact) that may affect the production process and (*e.g.* automatically) correcting such particularities. For example, machining or milling based on the CAD model may not be carried out if the CAD model still comprises sharp edges (because the machining or milling tool cannot create sharp edges), and in such a case the determination of the CAM specifications may comprise (*e.g.* automatically) rounding or filleting such sharp edges *(e.g.* with a round or fillet radius that corresponds, *e.g.* substantially equals up to a tolerance error, the radius of the cutting head of the machining tool), so that machining or milling based on the CAD model can be done. More generally, the determination of the CAM specifications may automatically comprise rounding or filleting geometries within the CAD model that are incompatible with the radius of the machining or milling tool, to enable machining/milling. This check and possible corrections (*e.g.* rounding or filleting of geometries) may be carried out automatically as previously discussed, but also, by a user (*e.g.* a machining engineer), which performs the correction by hand on a CAD and/or CAM solution, *e.g.* the solution constraining the user to perform corrections that make the CAD model compliant with specifications of the tool used in the machining process.

Further to the check, the determination of the CAM specifications may comprise *(e.g.* automatically) determining the machining or milling path, *i.e.* the path to be taken by the machining tool to machine the product. The path may comprise a set of coordinates and/or a parameterized trajectory to be followed by the machining tool for machining, and determining the path may comprise (*e.g.* automatically) computing these coordinates and/or trajectory based on the CAD model. This computation may be based on the computation of a boundary of a Minkowski subtraction of the CAD model by a CAD model representation of the machining tool, as for example discussed in European Patent Application EP21306754.9 filed on 13 December 2021 by Dassault Systèmes, and which is incorporated herein by reference. It is to be understood that the path may be a single path, *e.g.* that the tool continuously follows without breaking contact with the material to be cut. Alternatively, the path may be a concatenation of a sequence sub-paths to be followed in a certain order by the tool, e.g. each being continuously followed by the tool without breaking contact with the material to be cut. Optionally, the determination of the CAM specifications may then comprise (*e.g.* automatically) setting machine parameters, including cutting speed, cut/pierce height, and/or mold opening stroke, for example based on the determined path and on the specification of the machine. Optionally, the determination of the CAM specifications may then comprise (*e.g.* automatically) configuring nesting where the CAM solution decides the best orientation for a part to maximize machining efficiency.

In this case of a machining or milling part, the determining of the CAM specifications thus results in, and outputs, the CAM specifications comprising a machining path, and optionally the set machine parameters and/or specifications of the configured nesting. This outputted CAM specifications may be then (*e.g.* directly and automatically) fed to the machining tool and/or the machining tool may then (*e.g.* directly and automatically) be programmed by reading the specifications, upon which the production process comprises the producing/manufacturing step where the machine performs the machining of the product according to the production specifications, *e.g.* by directly and automatically executing the production specifications. The machining process comprises the machining tool cutting a real-world block of material to reproduce the geometry and/or distribution of material captured by the CAD model, *e.g.* up to a tolerance error *(e.g.* tens of microns for milling).

The product/part may alternatively be a molded part, *i.e.* a part manufactured by molding (*e.g.* injection-molding). In such a case, the production process may comprise the step of determining the CAM specifications. This step may be carried out automatically, by any suitable CAM solution to automatically obtain a CAM specifications from a CAD model of a molded part. The determining of the CAM specifications may comprise (*e.g.* automatically) performing a sequence of molding checks based on the CAD model to check that the geometry and/or distribution of material captured by the CAD model is adapted for molding, and (*e.g.* automatically) performing the appropriate corrections if the CAD model is not adapted for molding. Performing the checks and the appropriate corrections (if any) may be carried out automatically, or, alternatively, by a user (*e.g.* a molding engineer), for example using a CAD and/or CAM solution that allows a user to perform the appropriate corrections on the CAD model but constraints him/her corrections that make the CAD model compliant with specifications of the molding tool(s). The checks may include: verifying that the virtual product as represented by the CAD model is consistent with the dimensions of the mold and/or verifying that the CAD model comprises all the draft angles required for demolding the product, as known *per se* from molding. The determining of the CAM specifications may then further comprise determining, based on the CAD model, a quantity of liquid material to be used for molding, and/or a time to let the liquid material harden/set inside the mold, and outputting CAM specifications comprising these parameters. The production process then comprises (*e.g.* automatically) performing the molding based on the outputted specifications, where the mold shapes, for the determined hardening time, a liquid material into a shape that corresponds to the geometry and/or distribution of material captured by the CAD model, *e.g.* up to a tolerance error *(e.g.* up to the incorporation of draft angles or to the modification of draft angles, for demolding).

The product/part may alternatively be a stamped part, also possibly referred to as "stamping part", *i.e.* a part to be manufactured in a stamping process. The production process may in this case comprise (e.g. automatically) determining CAM specifications based on the CAD model. The CAD model represents the stamping part, e.g. possible with one or more flanges if the part is to comprise some, and possibly in this latter case with extra material to be removed so as to form an unfolded state of one or more flanges of the part, as known *per se* from stamping. The CAD model thus comprises a portion that represents the part without the flanges (which is the whole part in some cases) and possibly an outer extra patch portion that represents the flanges (if any), with possibly the extra material (if any). This extra patch portion may present a g2-continuity over a certain length and then a g1-continuity over a certain length.

The determination of the CAM specifications may in this stamping case comprise (*e.g.* automatically) determining parameters of the stamping machine, for example a size of a stamping die or punch and/or a stamping force, based on the geometry and/or distribution of material of the virtual product as captured by the CAD model. If the CAD model also comprises the representation of the extra material to be removed so as to form an unfolded state of one or more flanges of the part, the extra material to be removed may for example be cut by machining, and determining the CAM specifications may also comprise determining a corresponding machining CAM specifications, *e.g.* as discussed previously. If there are one or more flanges, determining the CAM specifications may comprise determining geometrical specifications of the g2-continuity and g1-continuity portions that allow, after the stamping itself and the removal of the extra material, to fold in a folding process the flanges towards an inner surface of the stamped part and along the g2-continuity length. The CAM specifications thereby determined may thus comprise: parameters of the stamping tool, optionally said specifications for folding the flanges (if any), and optionally a machining production specifications for removing the extra material (if any).

The stamping production process may then output, *e.g.* directly and automatically, the CAM specifications, and perform the stamping process (*e.g.* automatically) based on the specifications. The stamping process may comprise stamping (*e.g.* punching) a portion of material to form the product as represented by the CAD specifications, that is possibly with the unfolded flanges and the extra material (if any). Where appropriate, the stamping process may then comprise cutting the extra material based on the machining production specifications and folding the flanges based on said specifications for folding the flanges, thereby folding the flanges on their g2-continuity length and giving a smooth aspect to the outer boundary of the part. In this latter case, the shape of the part once manufactured differ from its virtual counterpart as represented by the CAD model in that the extra material is removed and the flanges are folded, whereas the CAD model represents the part with the extra material and the flanges in an unfolded state.

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

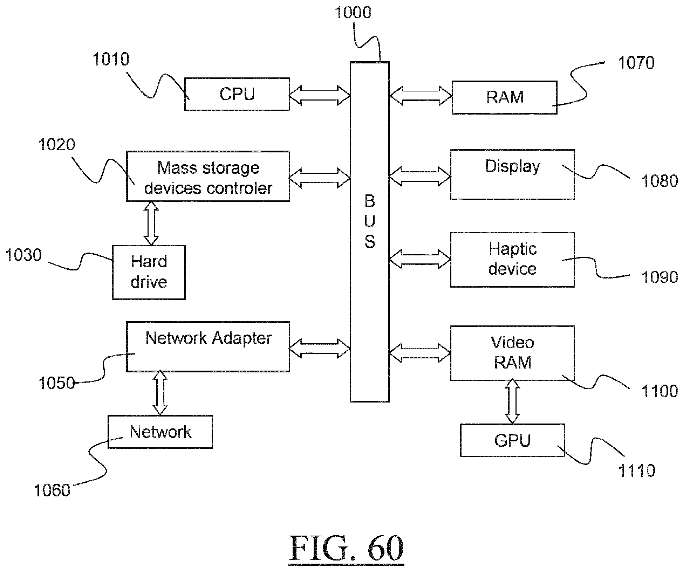

FIG. 60 shows an example of the system, wherein the system is a client computer system, *e.g.* a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

## Claims

1. A computer-implemented method for machine-learning a classification function configured for detection of mechanical interfaces of a CAD model, the CAD model representing a mechanical assembly of parts, the method comprising:
- obtaining a training dataset comprising training samples, each training sample comprising a graph representing a local contact between parts of a CAD model representing a mechanical assembly of parts, the graph comprising:
• one or more nodes, each node representing a canonical surface of the CAD model; each node comprising a label which is one within the label list:
∘ primary face of a mechanical interface;
∘ secondary face of a mechanical interface;
∘ tertiary face of a mechanical interface;
∘ maintain face of a mechanical interface; and
∘ no interface;
• one or more internal edges, each internal edge representing an internal connection between the canonical surfaces represented by the nodes connected by the edge, the canonical surfaces representing portions of a same part of the mechanical assembly; and
• one or more external edges, each external edge representing a contact between the canonical surfaces represent by the nodes connected by the edge, the canonical surfaces representing portions of different parts of the mechanical assembly; and
- training the classification function based on the training dataset to classify, with a label of the label list, each node of a graph representing a local contact between parts of a CAD model representing a mechanical assembly of parts.

2. The method of claim 1, wherein each of the graphs comprised in the training dataset comprises:
- a node-vector for each node, the node-vector being a feature vector representing properties of a canonical surface represented by the node;
- an internal-edge-vector for each internal edge, the internal-edge-vector being a feature vector representing properties of an internal connection represented by the edge; and/or
- an external-edge-vector for each external edge, the external-edge-vector being a feature vector representing properties of a contact represented by the edge.

3. The method of claim 2, wherein:
- the properties of the canonical surface represented by each node-vector comprise: surface type, area, radius, orientation, material, or a combination thereof;
- the properties of the internal connection represented by each internal-edge-vector comprise: convexity, concavity, coplanarity, coaxiality, neighbor smooth, presence of a fillet, presence of a chamfer, presence of a connection other than a fillet or a chamfer, or a combination thereof; and/or
- the properties of the contact represented by each external-edge-vector comprise: contact, stackablity, coaxiality, coplanarity, or a combination thereof.

4. The method of any one of claims 1 to 3, wherein obtaining the training dataset comprises:
- obtaining an initial dataset comprising CAD models representing mechanical assembly of parts; and
- for each CAD model representing a mechanical assembly of parts in the initial dataset, determining one or more graphs each representing a respective local contact between parts of the assembly of parts.

5. The method of claim 4, wherein the obtaining of the training dataset further comprises, before the determining, for each CAD model, of the one or more graphs each representing a respective local contact between parts of the assembly of parts, determining, for each CAD model of the initial dataset, a graph representing the CAD model, including:
- determining the canonical surfaces of the CAD model, and generating a node for each canonical surface;
- determining the internal connections between couples of canonical surfaces representing portions of a same part of the assembly represented by the CAD model, and generating an internal edge for each couple of canonical surfaces having an internal connection; and
- determining the contacts between couples of canonical surfaces representing portions of different parts of the assembly represented by the CAD model, and generating an external edge for each couple of canonical surfaces that are in contact,
wherein, for each CAD model of the initial dataset, the determining of one or more graphs each representing a respective local contact between parts of the assembly of parts is based on the determined graph representing the CAD model.

6. The method of claim 5, wherein the determining, for each CAD model, of one or more graphs each representing a respective local contact between parts of the assembly of parts represented by the CAD model based on the determined graph representing the CAD model comprises:
- determining a sub-graph of the determined graph representing the CAD model, the sub-graph comprising:
• a set of nodes, comprising all the nodes of the determined graph that are in a boundary of any of the external edges of the determined graph; and
• a set of internal and external edges, comprising all the internal and/or external edges of the determined graph that are bounded by two nodes comprised in the set of nodes;
- determining one or more connected components of the sub-graph; and
- determining, for each connected component of the sub-graph, a graph representing a local contact between parts of the assembly of parts, the graph comprising:
• one or more nodes, the one or more nodes comprising all the nodes of the connected component of the sub-graph and all the nodes that are at distance 1 of the connected component of the sub-graph;
• all the internal edges of the graph that are adjacent to any node of the connected component of the sub-graph; and
• all the external edges of the connected component of the sub-graph.

7. The method of any one of claims 1 to 6, wherein each canonical surface is a portion of a plane, of a sphere, of cone, of a torus, or of a cylinder.

8. The method of any one of claims 1 to 7, wherein the classification function comprises a graph neural network.

9. The method of any one of claims 1 to 8, the classification function being further configured to form mechanical interfaces based on the outputted labels by regrouping neighboring canonical surfaces corresponding to primary, secondary, tertiary, and maintain faces, the canonical surfaces representing portions of a same mechanical part.

10. A machine-learnt classification function obtainable according to any one of claims 1 to 9.

11. A computer-implemented method of use of the machine-learnt classification function of claim 10, the method of use comprising:
- obtaining one or more graphs each representing a respective local contact between parts of a same CAD model representing the mechanical assembly of parts, each graph comprising:
• one or more nodes, each node representing a canonical surface of the CAD model;
• one or more internal edges, each internal edge representing an internal connection between the canonical surfaces represented by the nodes connected by the edge, the canonical surfaces representing portions of a same part of the mechanical assembly; and
• one or more external edges, each external edge representing a contact between the canonical surfaces represent by the nodes connected by the edge, the canonical surfaces representing portions of different parts of the mechanical assembly; and
- applying the machine-learnt classification function to the one or more graphs.

12. The method of claim 11, wherein obtaining the one or more graphs comprises:
- obtaining the CAD model;
- determining a graph representing the CAD model, including:
• determining the canonical surfaces of the CAD model, and generating a node for each canonical surface;
• determining the internal connections between couples of canonical surfaces representing portions of a same part of the assembly represented by the CAD model, and generating an internal edge for each couple of canonical surfaces having an internal connection; and
• determining the contacts between couples of canonical surfaces representing portions of different parts of the assembly represented by the CAD model, and generating an external edge for each couple of canonical surfaces that are in contact,
- determining one or more graphs each representing a respective local contact between parts of the assembly of parts represented by the CAD model including:
• determining a sub-graph of the graph representing the CAD model, the sub-graph comprising:
∘ a set of nodes, comprising all the nodes of the graph representing the CAD model that are in a boundary of any of the external edges of the graph representing the CAD model; and
∘ a set of internal and external edges, comprising all the internal and/or external edges of the graph representing the CAD model that are bounded by two nodes comprised in the set of nodes;
• determining one or more connected components of the sub-graph; and
• determining, for each connected component of the sub-graph, a graph representing a local contact between parts of the assembly of parts, the graph comprising:
∘ one or more nodes, the one or more nodes comprising all the nodes of the connected component of the sub-graph and all the nodes that are at distance 1 of the connected component of the sub-graph;
∘ all the internal edge of the graph that are adjacent to any node of the connected component of the sub-graph; and
∘ all the external edges of the connected component of the sub-graph;
and wherein the method further comprises gathering the results of the application of the function to the one or more graphs by labeling the nodes of the graph representing the CAD model with the labels outputted by the function for each of the one or more graphs.

13. A computer-program comprising instructions which, when the program is executed on a computer, cause the computer to carry out the method of any one of claims 1 to 9, and/or the method of any one of claims 11 to 12.

14. A computer-readable storage medium having recorded thereon the computer-program of claim 13 and/or the machine-learnt classification function of claim 10.

15. A system comprising a processor coupled to a memory, the memory having recorded thereon the computer-program of claim 13 and/or the machine-learnt classification function of claim 10.

## Amended claims

### Amended claims in accordance with Rule 137(2) EPC.

**1.** A computer-implemented method for machine-learning and of use of a classification function configured for detection of mechanical interfaces of a CAD model, the CAD model representing a mechanical assembly of parts, the method comprising:
- obtaining a training dataset comprising training samples, each training sample comprising a graph representing a local contact between parts of a CAD model representing a mechanical assembly of parts, the graph comprising:
• one or more nodes, each node representing a canonical surface of the CAD model; each node comprising a label which is one within the label list:
o primary face of a mechanical interface, the primary face being a canonical surface of the mechanical interface that reduces the most degrees of freedom in the mechanical assembly of parts;
o secondary face of a mechanical interface, the secondary face being a canonical surface of the mechanical interface that is not a primary face and that reduces the most degrees of freedom in the mechanical assembly of parts, aside from the primary faces;
o tertiary face of a mechanical interface, the tertiary face being a canonical surface of the mechanical interface that is neither a primary face nor a secondary face and that reduces at least a degree of freedom in the mechanical assembly of parts;
o maintain face of a mechanical interface, the maintain being a canonical surface of the mechanical interface that maintains the mechanical parts in the position set by the primary, secondary and tertiary surfaces within the mechanical assembly of parts; and
o no interface;
• one or more internal edges, each internal edge representing an internal connection between the canonical surfaces represented by the nodes connected by the edge, the canonical surfaces representing portions of a same part of the mechanical assembly; and
• one or more external edges, each external edge representing a contact between the canonical surfaces represent by the nodes connected by the edge, the canonical surfaces representing portions of different parts of the mechanical assembly; and
- training the classification function based on the training dataset to classify, with a label of the label list, each node of a graph representing a local contact between parts of a CAD model representing a mechanical assembly of parts
- obtaining one or more graphs each representing a respective local contact between parts of a CAD model representing the mechanical assembly of parts, each graph comprising:
• one or more nodes, each node representing a canonical surface of the CAD model;
• one or more internal edges, each internal edge representing an internal connection between the canonical surfaces represented by the nodes connected by the edge, the canonical surfaces representing portions of a same part of the mechanical assembly; and
• one or more external edges, each external edge representing a contact between the canonical surfaces represent by the nodes connected by the edge, the canonical surfaces representing portions of different parts of the mechanical assembly;
- applying the machine-learnt classification function to the one or more graphs, thereby detecting mechanical interfaces of the CAD model; and
- using the detected mechanical interfaces to manufacture the mechanical assembly of parts;
the classification function being further configured to form mechanical interfaces based on the outputted labels by regrouping neighboring canonical surfaces corresponding to primary, secondary, tertiary, and maintain faces, the canonical surfaces representing portions of a same mechanical part.

**2.** The method of claim 1, wherein each of the graphs comprised in the training dataset comprises:
- a node-vector for each node, the node-vector being a feature vector representing properties of a canonical surface represented by the node;
- an internal-edge-vector for each internal edge, the internal-edge-vector being a feature vector representing properties of an internal connection represented by the edge; and/or
- an external-edge-vector for each external edge, the external-edge-vector being a feature vector representing properties of a contact represented by the edge.

**3.** The method of claim 2, wherein:
- the properties of the canonical surface represented by each node-vector comprise: surface type, area, radius, orientation, material, or a combination thereof;
- the properties of the internal connection represented by each internal-edge-vector comprise: convexity, concavity, coplanarity, coaxiality, neighbor smooth, presence of a fillet, presence of a chamfer, presence of a connection other than a fillet or a chamfer, or a combination thereof; and/or
- the properties of the contact represented by each external-edge-vector comprise: contact, stackablity, coaxiality, coplanarity, or a combination thereof.

**4.** The method of any one of claims 1 to 3, wherein obtaining the training dataset comprises:
- obtaining an initial dataset comprising CAD models representing mechanical assembly of parts; and
- for each CAD model representing a mechanical assembly of parts in the initial dataset, determining one or more graphs each representing a respective local contact between parts of the assembly of parts.

**5.** The method of claim 4, wherein the obtaining of the training dataset further comprises, before the determining, for each CAD model, of the one or more graphs each representing a respective local contact between parts of the assembly of parts, determining, for each CAD model of the initial dataset, a graph representing the CAD model, including:
- determining the canonical surfaces of the CAD model, and generating a node for each canonical surface;
- determining the internal connections between couples of canonical surfaces representing portions of a same part of the assembly represented by the CAD model, and generating an internal edge for each couple of canonical surfaces having an internal connection; and
- determining the contacts between couples of canonical surfaces representing portions of different parts of the assembly represented by the CAD model, and generating an external edge for each couple of canonical surfaces that are in contact,
wherein, for each CAD model of the initial dataset, the determining of one or more graphs each representing a respective local contact between parts of the assembly of parts is based on the determined graph representing the CAD model.

**6.** The method of claim 5, wherein the determining, for each CAD model, of one or more graphs each representing a respective local contact between parts of the assembly of parts represented by the CAD model based on the determined graph representing the CAD model comprises:
- determining a sub-graph of the determined graph representing the CAD model, the sub-graph comprising:
• a set of nodes, comprising all the nodes of the determined graph that are in a boundary of any of the external edges of the determined graph; and
• a set of internal and external edges, comprising all the internal and/or external edges of the determined graph that are bounded by two nodes comprised in the set of nodes;
- determining one or more connected components of the sub-graph; and
- determining, for each connected component of the sub-graph, a graph representing a local contact between parts of the assembly of parts, the graph comprising:
• one or more nodes, the one or more nodes comprising all the nodes of the connected component of the sub-graph and all the nodes that are at distance 1 of the connected component of the sub-graph;
• all the internal edges of the graph that are adjacent to any node of the connected component of the sub-graph; and
• all the external edges of the connected component of the sub-graph.

**7.** The method of any one of claims 1 to 6, wherein each canonical surface is a portion of a plane, of a sphere, of cone, of a torus, or of a cylinder.

**8.** The method of any one of claims 1 to 7, wherein the classification function comprises a graph neural network.

**9.** The method of claim 1, wherein obtaining the one or more graphs comprises:
- obtaining the CAD model;
- determining a graph representing the CAD model, including:
• determining the canonical surfaces of the CAD model, and generating a node for each canonical surface;
• determining the internal connections between couples of canonical surfaces representing portions of a same part of the assembly represented by the CAD model, and generating an internal edge for each couple of canonical surfaces having an internal connection; and
• determining the contacts between couples of canonical surfaces representing portions of different parts of the assembly represented by the CAD model, and generating an external edge for each couple of canonical surfaces that are in contact,
- determining one or more graphs each representing a respective local contact between parts of the assembly of parts represented by the CAD model including:
• determining a sub-graph of the graph representing the CAD model, the sub-graph comprising:
o a set of nodes, comprising all the nodes of the graph representing the CAD model that are in a boundary of any of the external edges of the graph representing the CAD model; and
o a set of internal and external edges, comprising all the internal and/or external edges of the graph representing the CAD model that are bounded by two nodes comprised in the set of nodes;
• determining one or more connected components of the sub-graph; and
• determining, for each connected component of the sub-graph, a graph representing a local contact between parts of the assembly of parts, the graph comprising:
o one or more nodes, the one or more nodes comprising all the nodes of the connected component of the sub-graph and all the nodes that are at distance 1 of the connected component of the sub-graph;
o all the internal edge of the graph that are adjacent to any node of the connected component of the sub-graph; and
o all the external edges of the connected component of the sub-graph;
and wherein the method further comprises gathering the results of the application of the function to the one or more graphs by labeling the nodes of the graph representing the CAD model with the labels outputted by the function for each of the one or more graphs.

**10.** A computer-program comprising instructions which, when the program is executed on a computer, cause the computer to carry out the method of any one of claims 1 to 9.

**11.** A computer-readable storage medium having recorded thereon the computer-program of claim 10.

**12.** A system comprising a processor coupled to a memory, the memory having recorded thereon the computer-program of claim 10.

**1.** A computer-implemented method for machine-learning and of use of a classification function configured for detection of mechanical interfaces of a CAD model, the CAD model representing a mechanical assembly of parts, the method comprising:
- obtaining a training dataset comprising training samples, each training sample comprising a graph representing a local contact between parts of a CAD model representing a mechanical assembly of parts, the graph comprising:
• one or more nodes, each node representing a canonical surface of the CAD model; each node comprising a label which is one within the label list:
o primary face of a mechanical interface, the primary face being a canonical surface of the mechanical interface that reduces the most degrees of freedom in the mechanical assembly of parts;
o secondary face of a mechanical interface, the secondary face being a canonical surface of the mechanical interface that is not a primary face and that reduces the most degrees of freedom in the mechanical assembly of parts, aside from the primary faces;
o tertiary face of a mechanical interface, the tertiary face being a canonical surface of the mechanical interface that is neither a primary face nor a secondary face and that reduces at least a degree of freedom in the mechanical assembly of parts;
o maintain face of a mechanical interface, the maintain being a canonical surface of the mechanical interface that maintains the mechanical parts in the position set by the primary, secondary and tertiary surfaces within the mechanical assembly of parts; and
o no interface;
• one or more internal edges, each internal edge representing an internal connection between the canonical surfaces represented by the nodes connected by the edge, the canonical surfaces representing portions of a same part of the mechanical assembly; and
• one or more external edges, each external edge representing a contact between the canonical surfaces represent by the nodes connected by the edge, the canonical surfaces representing portions of different parts of the mechanical assembly; and
- training the classification function based on the training dataset to classify, with a label of the label list, each node of a graph representing a local contact between parts of a CAD model representing a mechanical assembly of parts
- obtaining one or more graphs each representing a respective local contact between parts of a CAD model representing the mechanical assembly of parts, each graph comprising:
• one or more nodes, each node representing a canonical surface of the CAD model;
• one or more internal edges, each internal edge representing an internal connection between the canonical surfaces represented by the nodes connected by the edge, the canonical surfaces representing portions of a same part of the mechanical assembly; and
• one or more external edges, each external edge representing a contact between the canonical surfaces represent by the nodes connected by the edge, the canonical surfaces representing portions of different parts of the mechanical assembly;
- applying the machine-learnt classification function to the one or more graphs, thereby detecting mechanical interfaces of the CAD model; and
- using the detected mechanical interfaces to manufacture the mechanical assembly of parts, zones of interaction represented by the mechanical interfaces being manufactured with a higher precision and more detailed tolerances than other zones of the mechanical parts comprising the mechanical assembly of parts that are not supposed to have functional roles or be in contact with other mechanical parts;
the classification function being further configured to form mechanical interfaces based on the outputted labels by regrouping neighboring canonical surfaces corresponding to primary, secondary, tertiary, and maintain faces, the canonical surfaces representing portions of a same mechanical part.

**2.** The method of claim 1, wherein each of the graphs comprised in the training dataset comprises:
- a node-vector for each node, the node-vector being a feature vector representing properties of a canonical surface represented by the node;
- an internal-edge-vector for each internal edge, the internal-edge-vector being a feature vector representing properties of an internal connection represented by the edge; and/or
- an external-edge-vector for each external edge, the external-edge-vector being a feature vector representing properties of a contact represented by the edge.

**3.** The method of claim 2, wherein:
- the properties of the canonical surface represented by each node-vector comprise: surface type, area, radius, orientation, material, or a combination thereof;
- the properties of the internal connection represented by each internal-edge-vector comprise: convexity, concavity, coplanarity, coaxiality, neighbor smooth, presence of a fillet, presence of a chamfer, presence of a connection other than a fillet or a chamfer, or a combination thereof; and/or
- the properties of the contact represented by each external-edge-vector comprise: contact, stackablity, coaxiality, coplanarity, or a combination thereof.

**4.** The method of any one of claims 1 to 3, wherein obtaining the training dataset comprises:
- obtaining an initial dataset comprising CAD models representing mechanical assembly of parts; and
- for each CAD model representing a mechanical assembly of parts in the initial dataset, determining one or more graphs each representing a respective local contact between parts of the assembly of parts.

**5.** The method of claim 4, wherein the obtaining of the training dataset further comprises, before the determining, for each CAD model, of the one or more graphs each representing a respective local contact between parts of the assembly of parts, determining, for each CAD model of the initial dataset, a graph representing the CAD model, including:
- determining the canonical surfaces of the CAD model, and generating a node for each canonical surface;
- determining the internal connections between couples of canonical surfaces representing portions of a same part of the assembly represented by the CAD model, and generating an internal edge for each couple of canonical surfaces having an internal connection; and
- determining the contacts between couples of canonical surfaces representing portions of different parts of the assembly represented by the CAD model, and generating an external edge for each couple of canonical surfaces that are in contact,
wherein, for each CAD model of the initial dataset, the determining of one or more graphs each representing a respective local contact between parts of the assembly of parts is based on the determined graph representing the CAD model.

**6.** The method of claim 5, wherein the determining, for each CAD model, of one or more graphs each representing a respective local contact between parts of the assembly of parts represented by the CAD model based on the determined graph representing the CAD model comprises:
- determining a sub-graph of the determined graph representing the CAD model, the sub-graph comprising:
• a set of nodes, comprising all the nodes of the determined graph that are in a boundary of any of the external edges of the determined graph; and
• a set of internal and external edges, comprising all the internal and/or external edges of the determined graph that are bounded by two nodes comprised in the set of nodes;
- determining one or more connected components of the sub-graph; and
- determining, for each connected component of the sub-graph, a graph representing a local contact between parts of the assembly of parts, the graph comprising:
• one or more nodes, the one or more nodes comprising all the nodes of the connected component of the sub-graph and all the nodes that are at distance 1 of the connected component of the sub-graph;
• all the internal edges of the graph that are adjacent to any node of the connected component of the sub-graph; and
• all the external edges of the connected component of the sub-graph.

**7.** The method of any one of claims 1 to 6, wherein each canonical surface is a portion of a plane, of a sphere, of cone, of a torus, or of a cylinder.

**8.** The method of any one of claims 1 to 7, wherein the classification function comprises a graph neural network.

**9.** The method of claim 1, wherein obtaining the one or more graphs comprises:
- obtaining the CAD model;
- determining a graph representing the CAD model, including:
• determining the canonical surfaces of the CAD model, and generating a node for each canonical surface;
• determining the internal connections between couples of canonical surfaces representing portions of a same part of the assembly represented by the CAD model, and generating an internal edge for each couple of canonical surfaces having an internal connection; and
• determining the contacts between couples of canonical surfaces representing portions of different parts of the assembly represented by the CAD model, and generating an external edge for each couple of canonical surfaces that are in contact,
- determining one or more graphs each representing a respective local contact between parts of the assembly of parts represented by the CAD model including:
• determining a sub-graph of the graph representing the CAD model, the sub-graph comprising:
o a set of nodes, comprising all the nodes of the graph representing the CAD model that are in a boundary of any of the external edges of the graph representing the CAD model; and
o a set of internal and external edges, comprising all the internal and/or external edges of the graph representing the CAD model that are bounded by two nodes comprised in the set of nodes;
• determining one or more connected components of the sub-graph; and
• determining, for each connected component of the sub-graph, a graph representing a local contact between parts of the assembly of parts, the graph comprising:
o one or more nodes, the one or more nodes comprising all the nodes of the connected component of the sub-graph and all the nodes that are at distance 1 of the connected component of the sub-graph;
o all the internal edge of the graph that are adjacent to any node of the connected component of the sub-graph; and
o all the external edges of the connected component of the sub-graph;
and wherein the method further comprises gathering the results of the application of the function to the one or more graphs by labeling the nodes of the graph representing the CAD model with the labels outputted by the function for each of the one or more graphs.

**10.** A computer-program comprising instructions which, when the program is executed on a computer, cause the computer to carry out the method of any one of claims 1 to 9.

**11.** A computer-readable storage medium having recorded thereon the computer-program of claim 10.

**12.** A system comprising a processor coupled to a memory, the memory having recorded thereon the computer-program of claim 10.
